# EUROPÄISCHE PATENTSCHRIFT

(11) **EP 3 724 202 B1**
(45) Veröffentlichungstag und Bekanntmachung des Hinweises auf die Patenterteilung: **17.08.2022**
(21) Anmeldenummer: 18811859.0
(22) Anmeldetag: 10.12.2018
(51) Int. Cl.: C07F 15/00, H01L 51/50, H01L 51/00

(54) **METALLKOMPLEXE**
METAL COMPLEXES
COMPLEXES MÉTALLIQUES

(30) Priorität: 13.12.2017 EP 17206950
(43) Veröffentlichungstag der Anmeldung: 21.10.2020
(73) Patentinhaber: Merck Patent GmbH, 64293 Darmstadt (DE)
(72) Erfinder: STOESSEL, Philipp, 60389 Frankfurt am Main (DE); AUCH, Armin, 71083 Herrenberg (DE)
(86) Internationale Anmeldenummer: PCT/EP2018/084094
(87) Internationale Veröffentlichungsnummer: WO 2019/115423

(56) Entgegenhaltungen:
- WO-A1-2014/033044
- WO-A1-2016/124304

## Beschreibung

Die vorliegende Erfindung betrifft Iridiumkomplexe, welche sich für den Einsatz in organischen Elektrolumineszenzvorrichtungen, insbesondere als Emitter, eignen.

Gemäß dem Stand der Technik werden in phosphoreszierenden organischen Elektrolumineszenzvorrichtungen (OLEDs) als Triplettemitter vor allem Iridiumkomplexe eingesetzt, insbesondere bis- und tris-orthometallierte Komplexe mit aromatischen Liganden, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)iridium(III) und Derivate davon, sowie eine Vielzahl verwandter Komplexe bekannt, beispielsweise mit 1- oder 3-Phenylisochinolinliganden, mit 2-Phenylchinolinliganden oder mit Phenylcarbenliganden. Auch wenn Komplexe mit polypodalen Liganden Vorteile gegenüber Komplexen zeigen, die ansonsten die gleiche Ligandenstruktur aufweisen, deren einzelne Liganden jedoch nicht polypodal verbrückt sind, gibt es auch hier noch Verbesserungsbedarf. Dieser liegt insbesondere in der Effizienz der Lumineszenz der Verbindungen.

Weiterhin bekannt sind Iridiumkomplexe mit drei bidentaten Liganden, von denen einer ein Pyrazolylborat-Ligand ist. Diese weisen die Schwierigkeit auf, dass der Pyrazolylborat-Ligand bei der Synthese zur hydrolytischen Zersetzung neigt (J. Li et al., Polyhedron 2004, 23, 419-428), so dass hier der Standardsyntheseweg über direkte Umsetzung des Chloro-verbrückten Dimers mit einem Pyrazolylborat-Liganden nicht genutzt werden kann. Auch in Lösung zeigen derartige Komplexe eine Neigung zur Hydrolyse. Hier sind weitere Verbesserungen wünschenswert. Aus WO 2014/033044 A1 ist ein Iridiumkomplex mit einem tetradentaten Liganden und einem Bispyrazolylborat-Liganden für die Verwendung in organischen Elektrolumineszenzvorrichtungen bekannt. Komplexe mit hexadentaten Liganden sind nicht offenbart.

Aus WO 2016/124304 A1 sind Metallkomplexe mit einem hexadentaten Liganden für die Verwendung in organischen Elektrolumineszenzvorrichtungen bekannt, in dem drei miteinander verbrückte Aryl-Heteroaryl-Teilliganden an ein Metall gebunden sind. Komplexe mit Bispyrazolylboratteilliganden sind nicht offenbart.

Aufgabe der vorliegenden Erfindung ist die Bereitstellung neuer und insbesondere verbesserter Metallkomplexe, welche sich als Emitter für die Verwendung in OLEDs eignen.

Überraschend wurde gefunden, dass Metallkomplexe mit einem hexadentaten tripodalen Liganden, der die nachfolgend beschriebene Struktur aufweist und ein oder zwei Pyrazolylborat-Liganden enthält, diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung der Formel (1), 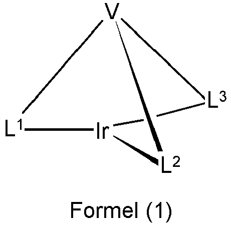 wobei für die verwendeten Symbole gilt:
- L¹: ist ein Teilligand der folgenden Formel (2), der über die beiden mit * gekennzeichneten N-Atome an das Iridium koordiniert und der über die gestrichelte Bindung an V gebunden ist, 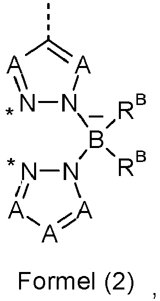 wobei gilt:
A ist bei jedem Auftreten gleich oder verschieden CR oder N, wobei maximal eine Gruppe A pro Ring für N steht;
R^{B} ist bei jedem Auftreten gleich oder verschieden F, OR¹, eine geradkettige Alkylgruppe mit 1 bis 10 C-Atomen oder eine verzweigte oder cyclische Alkylgruppe mit 3 bis 10 C-Atomen, wobei die Alkylgruppe jeweils mit einem oder mehreren Resten R¹ substituiert sein kann, oder ein aromatisches oder heteroaromatisches Ringsystem mit 5 bis 24 aromatischen Ringatomen, das jeweils durch einen oder mehrere Reste R¹ substituiert sein kann; dabei können die beiden Reste R^{B} auch miteinander ein Ringsystem bilden;

- L²: ist ein bidentater, monoanionischer Teilligand, der über ein Kohlenstoffatom und ein Stickstoffatom oder über zwei Kohlenstoffatome an das Iridium koordiniert;
- L³: ist ein bidentater, monoanionischer Teilligand, der über ein Kohlenstoffatom und ein Stickstoffatom oder über zwei Kohlenstoffatome an das Iridium koordiniert, oder ist ein Teilligand der oben aufgeführten Formel (2), der gleich oder verschieden L¹ sein kann;
- V: ist eine Gruppe gemäß einer der Formeln (4b), (5b), (6b) oder (7b), wobei die gestrichelten Bindungen jeweils die Bindungen zu den Teilliganden L¹, L² und L³ darstellen, 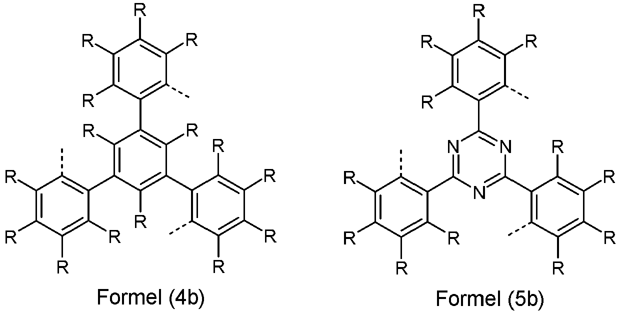 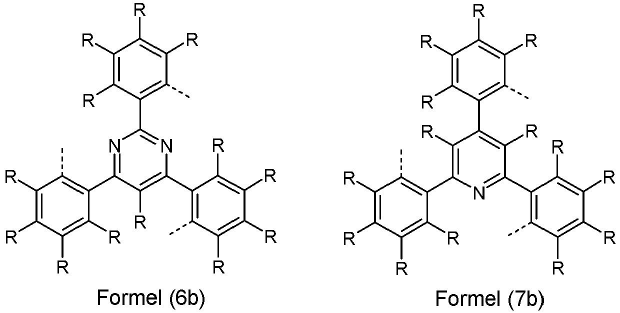
- R: ist bei jedem Auftreten gleich oder verschieden H, D, F, Cl, Br, I, N(R¹)₂, OR¹, SR¹, CN, NO₂, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine gerad-kettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann und wobei eine oder mehrere nicht benach-barte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
- R¹: ist bei jedem Auftreten gleich oder verschieden H, D, F, Cl, Br, I, N(R²)2, OR², SR², CN, NO₂, Si(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können;
dabei können die drei bidentaten Liganden L¹, L² und L³ außer durch die Gruppe V auch noch durch eine weitere Brücke zu einem Kryptat geschlossen sein.

Bei dem Liganden handelt es sich erfindungsgemäß somit um einen hexadentaten, tripodalen Liganden mit drei bidentaten Teilliganden L¹, L² und L³. Dabei bedeutet bidentat, dass der jeweilige Teilligand im Komplex über zwei Koordinationsstellen an das Iridium koordiniert bzw. bindet. Tripodal bedeutet, dass der Ligand drei Teilliganden aufweist, die an die Gruppe V bzw. die Gruppe der Formel (4b), (5b), (6b) bzw. (7b) gebunden sind. Da der Ligand drei bidentate Teilliganden aufweist, ergibt sich insgesamt ein hexadentater Ligand, also ein Ligand, der über sechs Koordinationsstellen an das Iridium koordiniert bzw. bindet. Der Begriff "bidentater Teilligand" bedeutet im Sinne dieser Anmeldung, dass es sich bei L¹, L² bzw. L³ jeweils um einen bidentaten Liganden handeln würde, wenn die Gruppe V bzw. die Gruppe der Formel (3) nicht vorhanden wäre. Durch die formale Abstraktion eines Wasserstoffatoms von diesem bidentaten Liganden und die Anknüpfung an die Gruppe der Formel (3) ist dieser jedoch kein separater Ligand mehr, sondern ein Teil des so entstehenden hexadentaten Liganden, so dass hierfür der Begriff "Teilligand" verwendet wird.

Der Ligand der erfindungsgemäßen Verbindung weist somit die folgende Struktur (LIG) auf: 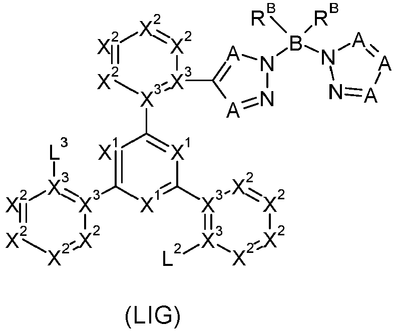 wobei X¹ gleich oder verschieden bei jedem Auftreten für CR oder N steht und X² und X³ für CR stehen.

Die Bindung des Liganden an das Iridium kann sowohl eine Koordinationsbindung als auch eine kovalente Bindung sein bzw. der kovalente Anteil an der Bindung kann je nach Teilligand variieren. Wenn in der vorliegenden Anmeldung die Rede davon ist, dass der Ligand bzw. der Teilligand an das Iridium koordiniert oder bindet, so bezeichnet dies im Sinne der vorliegenden Anmeldung jede Art der Bindung von dem Liganden bzw. Teilliganden an das Iridium, unabhängig vom kovalenten Anteil der Bindung.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können diese Reste, die miteinander ein Ringsystem bilden, benachbart sein, d. h. dass diese Reste an dasselbe Kohlenstoffatom oder an Kohlenstoffatome, die direkt aneinander gebunden sind, gebunden sind, oder sie können weiter voneinander entfernt sein. So ist beispielsweise auch die Ringbildung eines Restes R, der an der Gruppe X² gebunden ist, mit einem Rest R, der an der Gruppe X¹ gebunden ist, möglich.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

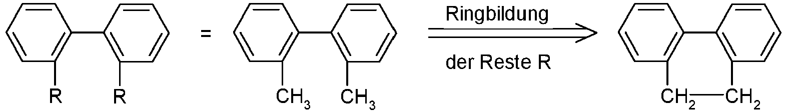

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

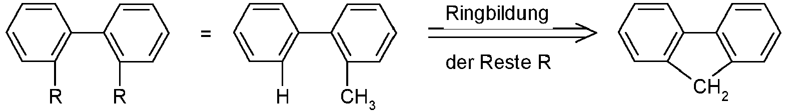

Wie oben beschrieben, kann diese Ringbildung an Resten erfolgen, die an direkt aneinander gebundene Kohlenstoffatome gebunden sind, oder an Resten, die an weiter entfernt liegende Kohlenstoffatome gebunden sind. Bevorzugt ist eine solche Ringbildung bei Resten, die an direkt aneinander gebundene Kohlenstoffatome gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei enthält die Heteroarylgruppe bevorzugt maximal drei Heteroatome. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer Gruppe OR¹ werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Im Folgenden werden bevorzugte Ausführungsformen des Brückenkopfes V, also der Struktur der Formel (3) ausgeführt.

Für bevorzugte Reste R am trivalenten zentralen Benzolring der Formel (4b) bzw. am zentralen Pyrimidinring der Formel (6b) bzw. am zentralen Pyridinring der Formel (7b) gilt:
- R: ist bei jedem Auftreten gleich oder verschieden H, D, F, CN, OR¹, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R¹ substituiert sein kann, bevorzugt aber unsubstituiert ist, oder ein aromatisches oder heteroaromatisches Ringsystem mit 5 bis 24 aromatischen Ringatomen, das jeweils durch einen oder mehrere Reste R¹ substituiert sein kann; dabei kann der Rest R auch mit einem Rest R an X² ein Ringsystem bilden;
- R¹: ist bei jedem Auftreten gleich oder verschieden H, D, F, CN, OR², eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, bevorzugt aber un-substituiert ist, oder ein aromatisches oder heteroaromatisches Ring-system mit 5 bis 24 aromatischen Ringatomen, das jeweils durch einen oder mehrere Reste R² substituiert sein kann; dabei können zwei oder mehrere benachbarte Reste R¹ miteinander ein Ring-system bilden;
- R²: ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können.

Für besonders bevorzugte Reste R am trivalenten zentralen Benzolring der Formel (4b) bzw. am zentralen Pyrimidinring der Formel (6b) bzw. am zentralen Pyridinring der Formel (7b) gilt:
- R: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R¹ substituiert sein kann, bevorzugt aber unsubstituiert ist, oder ein aromatisches oder heteroaromatisches Ringsystem mit 6 bis 12 aromatischen Ringatomen, das jeweils durch einen oder mehrere Reste R¹ substituiert sein kann; dabei kann der Rest R auch mit einem Rest R an X² ein Ringsystem bilden;
- R¹: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R² substituiert sein kann, bevorzugt aber unsubstituiert ist, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.

Bei den Substituenten am Brückenkopf V können, wie oben bei der Beschreibung der Substituenten beschrieben, auch benachbarte Substituenten miteinander ein Ringsystem bilden, so dass kondensierte Strukturen, auch kondensierte Aryl- und Heteroarylgruppen, wie beispielsweise Naphthalin, Chinolin, Benzimidazol, Carbazol, Dibenzofuran oder Dibenzothiophen, entstehen können.

Eine bevorzugte Ausführungsform der Formel (4b) ist die Struktur der folgenden Formel (4b'), 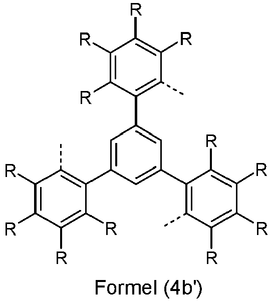 wobei die verwendeten Symbole die oben genannten Bedeutungen aufweisen.

Besonders bevorzugt sind die Gruppen R in den Formeln (3b) bis (7b) bei jedem Auftreten gleich oder verschieden H, D oder eine Alkylgruppe mit 1 bis 4 C-Atomen. Ganz besonders bevorzugt ist R = H. Ganz besonders bevorzugt sind also die Strukturen der folgenden Formeln (4c) bzw. (5c), 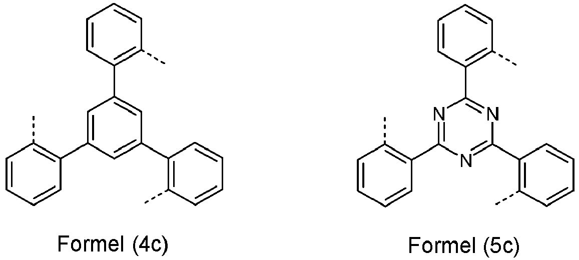 wobei die verwendeten Symbole die oben genannten Bedeutungen aufweisen.

Im Folgenden werden die bidentaten Teilliganden L¹ beschrieben. Bei dem Teilliganden L¹ handelt es sich um eine monoanionische Struktur. Dies ist in Formel (2) durch eine negative Ladung am Boratom gekennzeichnet.

In einer bevorzugten Ausführungsform der Erfindung stehen alle Gruppen A gleich oder verschieden bei jedem Auftreten für CR. Bevorzugt handelt es sich bei dem Teilliganden L¹ somit um eine Struktur der folgenden Formel (2a), 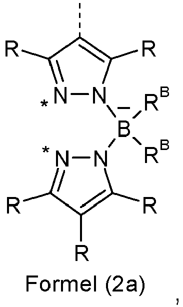 wobei die verwendeten Symbole die oben genannten Bedeutungen aufweisen.

Dabei sind die Substituenten R, der dem koordinierenden N-Atom, welches mit * gekennzeichnet ist, benachbart sind , bevorzugt ausgewählt aus der Gruppe bestehend aus H, D, F, Methyl, Ethyl und Phenyl, besonders bevorzugt H oder D und ganz besonders bevorzugt H.

Besonders bevorzugt weist der Teilligand L¹ also eine Struktur der folgenden Formel (2b) auf, 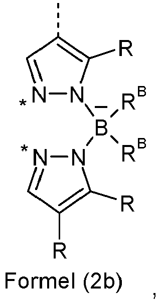 wobei die verwendeten Symbole die oben genannten Bedeutungen aufweisen.

Die weiteren Reste R in den Strukturen der Formeln (2), (2a) bzw. (2b) sind bevorzugt ausgewählt aus der Gruppe bestehend aus H, D, F, Br, OR¹, C(=O)R¹, einer geradkettigen Alkylgruppe mit 1 bis 10 C-Atomen oder einer Alkenylgruppe mit 2 bis 10 C-Atomen oder eine verzweigten oder cyclischen Alkylgruppe mit 3 bis 10 C-Atomen, wobei die Alkyl- bzw. Alkenylgruppe jeweils mit einem oder mehreren Resten R¹ substituiert sein kann, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R auch miteinander ein Ringsystem bilden.

Besonders bevorzugt sind die Reste R in den Strukturen der Formeln (2), (2a) bzw. (2b) ausgewählt aus der Gruppe bestehend aus H, D, F, einer geradkettigen Alkylgruppe mit 1 bis 5 C-Atomen oder einer verzweigten oder cyclischen Alkylgruppe mit 3 bis 6 C-Atomen, wobei die Alkylgruppe mit einem oder mehreren Resten R¹ substituiert sein kann, bevorzugt aber unsubstituiert ist, oder einem aromatischen oder heteroaromatischen Ringsystem mit 6 bis 13 aromatischen Ringatomen, das jeweils durch einen oder mehrere Reste R¹ substituiert sein kann; dabei können zwei benachbarte Reste R auch miteinander ein Ringsystem bilden.

Ganz besonders bevorzugt weist der Teilligand L¹ eine Struktur der folgenden Formel (2c) auf, 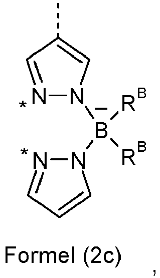 wobei die verwendeten Symbole die oben genannten Bedeutungen aufweisen.

Die Substituenten R^{B} am Boratom in Formel (2), (2a), (2b) bzw. (2c) sind bei jedem Auftreten gleich oder verschieden bevorzugt ausgewählt aus der Gruppe bestehend aus OR¹, wobei R¹ für eine Alkylgruppe mit 1 bis 5 C-Atomen steht, einer geradketttigen Alkylgruppe mit 1 bis 5 C-Atomen, einer verzweigten oder cyclischen Alkylgruppe mit 3 bis 6 C-Atomen, einer Arylgruppe mit 6 bis 10 C-Atomen, die mit einem oder mehreren bevorzugt nicht-aromatischen Resten R¹ substituiert sein kann, oder einer Heteroarylgruppe mit 5 bis 10 aromatischen Ringatomen, die mit einem oder mehreren bevorzugt nicht-aromatischen Resten R¹ substituiert sein kann. Dabei können die beiden Reste R^{B} auch miteinander ein Ringsystem bilden.

Besonders bevorzugt sind die Substituenten R^{B} am Boratom in Formel (2), (2a), (2b) bzw. (2c) bei jedem Auftreten gleich oder verschieden ausgewählt aus der Gruppe bestehend aus OR¹, wobei R¹ für Methyl, Ethyl, n-Propyl oder iso-Propyl steht, einer Alkylgruppe ausgewählt aus Methyl, Ethyl, n-Propyl, iso-Propyl, n-Butyl, iso-Butyl, tert-Butyl und neo-Pentyl, insbesondere Methyl, einer Phenylgruppe, die mit einer oder mehreren Alkylgruppen mit 1 bis 5 C-Atomen substituiert sein kann, bevorzugt aber unsubstituiert ist, oder einer Heteroarylgruppe mit 5 oder 6 aromatischen Ringatomen, die mit einer oder mehreren Alkylgruppen mit 1 bis 5 C-Atomen substituiert sein kann, bevorzugt aber unsubstituiert ist. Dabei können die beiden Reste R^{B} auch miteinander ein Ringsystem bilden.

In einer bevorzugten Ausführungsform der Erfindung sind die beiden Substituenten R^{B} gleich.

Wenn R^{B} für eine Gruppe der Formel OR¹ steht, ist es bevorzugt, wenn beide Substituenten R^{B} für OR¹ stehen, wobei R¹ jeweils für eine Alkylgruppe mit 1 bis 5 C-Atomen steht und die beiden R¹ miteinander ein Ringsystem bilden.

Wenn R^{B} für eine Heteroarylgruppe steht, so handelt es sich dabei bevorzugt um eine Pyrazolylgruppe, welche über ein N-Atom an das Boratom gebunden ist.

Wenn die beiden Substituenten R^{B} zusammen mit dem Boratom, an das sie gebunden sind, ein Ringsystem bilden, sind bevorzugte Ringsysteme die Strukturen der folgenden Formeln (B-1) bis (B-8), 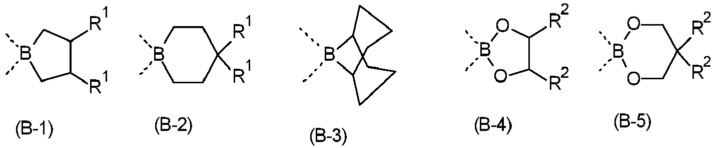 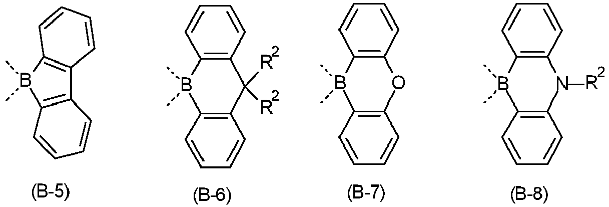 wobei R¹ und R² die oben genannten Bedeutungen aufweisen, die gestrichelten Bindungen am Boratom jeweils die Bindung an den Pyrazolylring bzw. für A = N an den Triazolylring darstellen und die negative Ladung am Boratom nicht eingezeichnet ist.

In einer bevorzugten Ausführungsform der Erfindung stellt L³ einen Teilliganden der Formel (2) dar, wobei die Teilliganden L¹ und L³ gleich oder verschieden sein können. Wenn L³ ein Teilligand der Formel (2) ist, dann sind bevorzugte Ausführungsformen für L³ die oben genannten bevorzugten Ausführungsformen für L¹. Wenn L³ einen Teilliganden der Formel (2) darstellt, dann ist es besonders bevorzugt, wenn L¹ und L³ gleich sind und auch gleich substituiert sind. Die Verbindung der Formel (1) stellt also bevorzugt eine Verbindung der folgenden Formel (1a) dar, 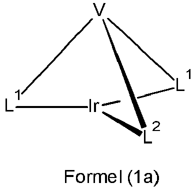 wobei die verwendeten Symbole die oben genannten Bedeutungen aufweisen.

Im Folgenden wird der bidentate Teilligand L² beschrieben, der an das Iridium über ein Kohlenstoffatom und ein Stickstoffatom oder über zwei Kohlenstoffatome koordiniert. Wenn L³ ein bidentater Teilligand ist, der an das Iridium über ein Kohlenstoffatom und ein Stickstoffatom oder über zwei Kohlenstoffatome koordiniert, dann entsprechen bevorzugte Ausführungsformen für diesen Teilliganden L³ den nachfolgend ausgeführten bevorzugten Ausführungsformen für L². In diesem Fall ist es besonders bevorzugt, wenn L² und L³ gleich sind und auch gleich substituiert sind.

Bevorzugt weist L² ein Kohlenstoffatom und ein Stickstoffatom als koordinierende Atome auf.

Es ist weiterhin bevorzugt, wenn es sich bei dem Metallacyclus, der aus dem Iridium und dem Teilliganden L² aufgespannt wird, um einen Fünfring handelt. Dies wird im Folgenden für C und N als koordinierende Atome schematisch dargestellt: 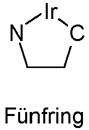 wobei N ein koordinierendes Stickstoffatom und C ein koordinierendes Kohlenstoffatom darstellen und die eingezeichneten Kohlenstoffatome Atome des Teilliganden L² darstellen.

In einer bevorzugten Ausführungsform der Erfindung steht der Teilligand L² für eine Struktur gemäß einer der folgenden Formeln (L-1) oder (L-2), 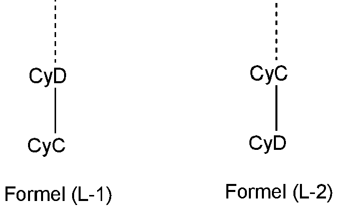 wobei die gestrichelte Bindung die Bindung des Teilliganden an die Gruppe V bzw. die Gruppe der Formel (4b), (5b), (6b) bzw. (7b) darstellt und für die weiteren verwendeten Symbole gilt:
- CyC: ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche über eine kovalente Bindung mit CyD verbunden ist;
- CyD: ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei können mehrere der optionalen Substituenten miteinander ein Ringsystem bilden. Die optionalen Reste sind bevorzugt ausgewählt aus den oben genannten Resten R.

Dabei koordiniert CyD bevorzugt über ein neutrales Stickstoffatom oder über ein Carben-Kohlenstoffatom. Weiterhin koordiniert CyC über ein anionisches Kohlenstoffatom.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD miteinander einen Ring bilden, wodurch CyC und CyD auch zusammen eine einzige kondensierte Heteroarylgruppe als bidentaten Liganden bilden können.

Wenn es sich bei beiden Teilliganden L² und L³ um Teilliganden handelt, die über ein Kohlenstoffatom und ein Stickstoffatom oder über zwei Kohlenstoffatome an das Iridium koordinieren, weisen beide Teilliganden L² und L³ eine Struktur der Formel (L-1) auf, oder beide Teilliganden L² und L³ weisen eine Struktur der Formel (L-2) auf, oder einer der Teilliganden L² und L³ weist eine Struktur der Formel (L-1), und der andere der Teillliganden weist eine Struktur der Formel (L-2) auf. In einer bevorzugten Ausführungsform der Erfindung weisen entweder beide Teilliganden L² und L³ eine Struktur der Formel (L-1) auf, oder beide Teilliganden L² und L³ weisen eine Struktur der Formel (L-2) auf.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-19), wobei die Gruppe CyC jeweils an der durch # gekennzeichneten Position an CyD bindet und an der durch * gekennzeichneten Position an das Iridium koordiniert, 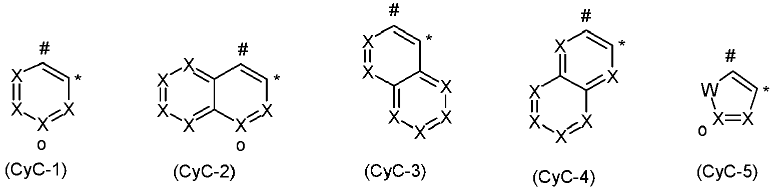 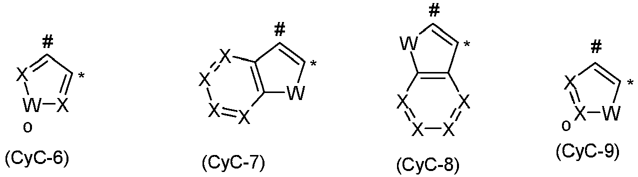 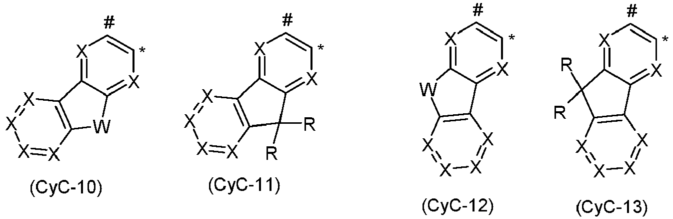 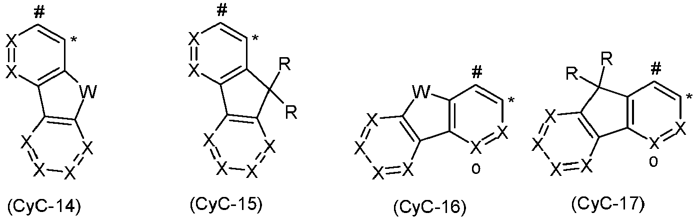 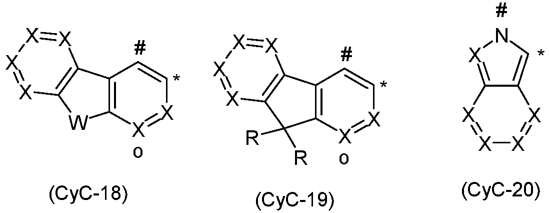 wobei R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist bei jedem Auftreten gleich oder verschieden NR, O oder S;
mit der Maßgabe, dass, wenn die Gruppe der Formel (4b), (5b), (6b) bzw. (7b) an CyC gebunden ist, ein Symbol X für C steht und die Gruppe der Formel (4b), (5b), (6b) bzw. (7b) an dieses Kohlenstoffatom gebunden ist. Wenn die Gruppe CyC an die Gruppe der Formel (4b), (5b), (6b) bzw. (7b) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Gruppe der Formel (4b), (5b), (6b) bzw. (7b) gebunden, da eine solche Bindung an die Brücke aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn die Gruppe der Formel (4b), (5b), (6b) bzw. (7b) an CyC gebunden ist, ein Symbol X für C steht und die Gruppe der Formel (4b), (5b), (6b) bzw. (7b) an dieses Kohlenstoffatom gebunden ist.

Besonders bevorzugte Gruppen CyC sind die Gruppen der folgenden Formeln (CyC-1a) bis (CyC-20a), 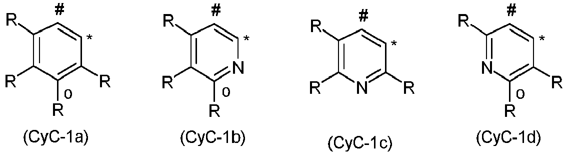 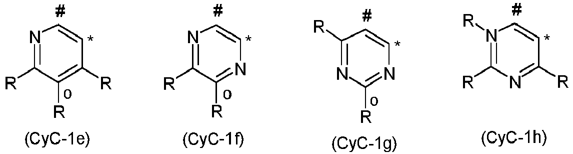 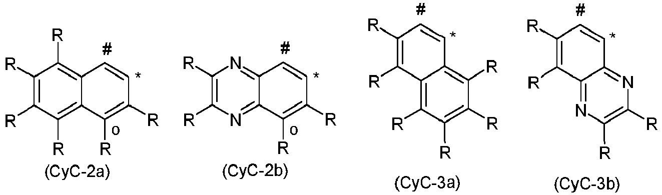 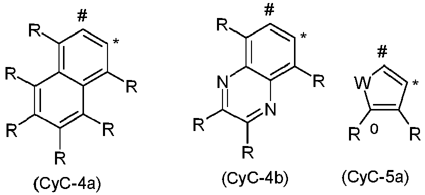 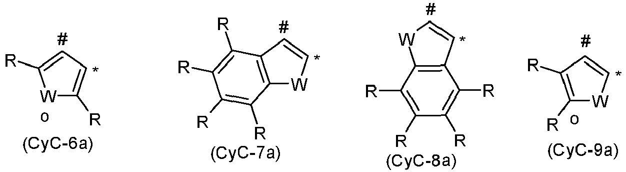 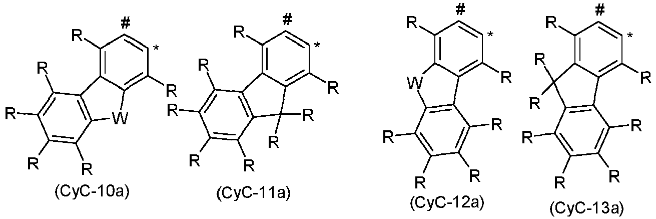 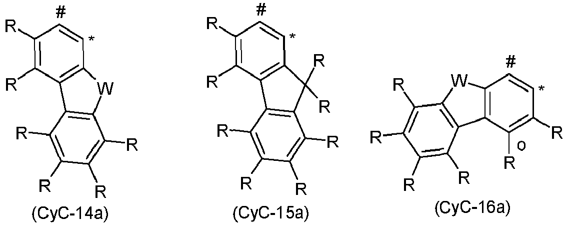 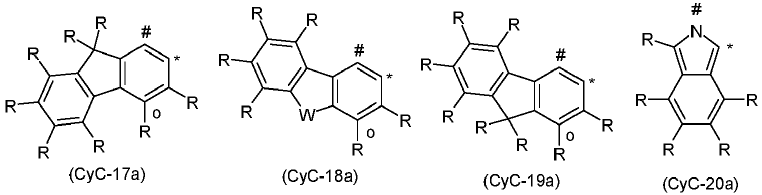 wobei die verwendeten Symbole die oben genannten Bedeutungen aufweisen und, wenn die Gruppe der Formel (4b), (5b), (6b) bzw. (7b) an CyC gebunden ist, ein Rest R nicht vorhanden ist und die Gruppe der Formel (4b), (5b), (6b) bzw. (7b) an das entsprechende Kohlenstoffatom gebunden ist. Wenn die Gruppe CyC an die Gruppe der Formel (4b), (5b), (6b) bzw. (7b) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Gruppe der Formel (4b), (5b), (6b) bzw. (7b) gebunden.

Bevorzugte Gruppen unter den Gruppen (CyC-1) bis (CyC-19) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-12), wobei die Gruppe CyD jeweils an der durch # gekennzeichneten Position an CyC bindet und an der durch * gekennzeichneten Position an das Iridium koordiniert, 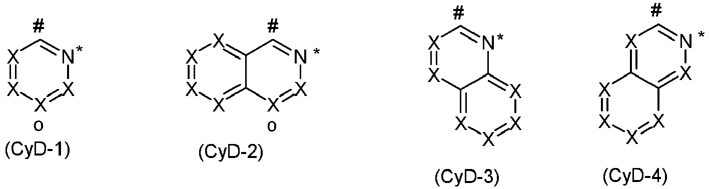 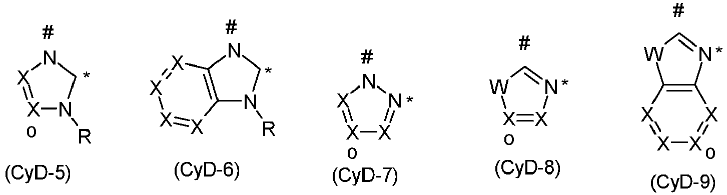 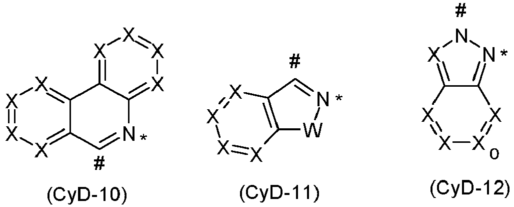 wobei X, W und R die oben genannten Bedeutungen aufweisen, mit der Maßgabe, dass, wenn die Gruppe der Formel (4b), (5b), (6b) bzw. (7b) an CyD gebunden ist, ein Symbol X für C steht und die Gruppe der Formel (4b), (5b), (6b) bzw. (7b) an dieses Kohlenstoffatom gebunden ist. Wenn die Gruppe CyD an die Gruppe der Formel (4b), (5b), (6b) bzw. (7b) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Gruppe der Formel (4b), (5b), (6b) bzw. (7b) gebunden, da eine solche Bindung an die Brücke aus sterischen Gründen nicht vorteilhaft ist.

Dabei koordinieren die Gruppen (CyD-1) bis (CyD-4) und (CyD-7) bis (CyD-12) über ein neutrales Stickstoffatom und (CyD-5) und (CyD-6) über ein Carben-Kohlenstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn die Gruppe der Formel (4b), (5b), (6b) bzw. (7b) an CyD gebunden ist, ein Symbol X für C steht und die Gruppe der Formel (4b), (5b), (6b) bzw. (7b) an dieses Kohlenstoffatom gebunden ist.

Besonders bevorzugte Gruppen CyD sind die Gruppen der folgenden Formeln (CyD-1a) bis (CyD-12b), 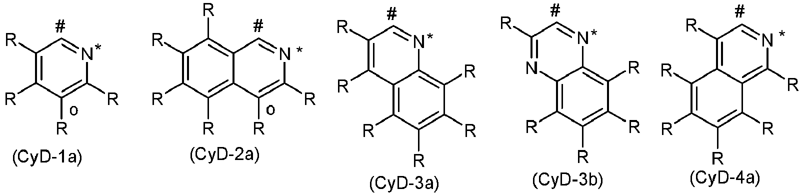 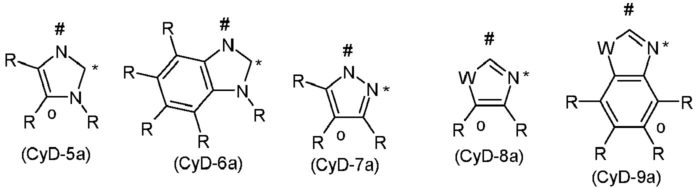 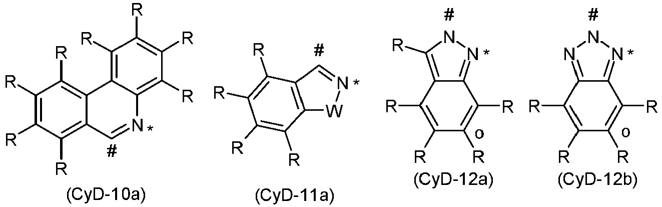 wobei die verwendeten Symbole die oben genannten Bedeutungen aufweisen und, wenn die Gruppe der Formel (4b), (5b), (6b) bzw. (7b) an CyD gebunden ist, ein Rest R nicht vorhanden ist und die Gruppe der Formel (4b), (5b), (6b) bzw. (7b) an das entsprechende Kohlenstoffatom gebunden ist. Wenn die Gruppe CyD an die Gruppe der Formel (4b), (5b), (6b) bzw. (7b) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Gruppe der Formel (4b), (5b), (6b) bzw. (7b) gebunden.

Bevorzugte Gruppen unter den Gruppen (CyD-1) bis (CyD-12) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-12) können beliebig miteinander kombiniert werden, sofern mindestens eine der Gruppen CyC bzw. CyD eine geeignete Anknüpfungsstelle an die Gruppe der Formel (4b), (5b), (6b) bzw. (7b) aufweist, wobei geeignete Anknüpfungsstellen in den oben genannten Formeln mit "o" gekennzeichnet sind.

Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden, sofern mindestens eine der bevorzugten Gruppen CyC bzw. CyD eine geeignete Anknüpfungsstelle an die Gruppe der Formel (4b), (5b), (6b) bzw. (7b) aufweist, wobei geeignete Anknüpfungsstellen in den oben genannten Formeln mit "o" gekennzeichnet sind. Kombinationen, in denen weder CyC noch CyD eine solche geeignete Anknüpfungsstelle für die Gruppe der Formel (4b), (5b), (6b) bzw. (7b) aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L-1) sind die Strukturen der Formeln (L-1-1) und (L-1-2), und bevorzugte Teilliganden (L-2) sind die Strukturen der Formeln (L-2-1) bis (L-2-4), 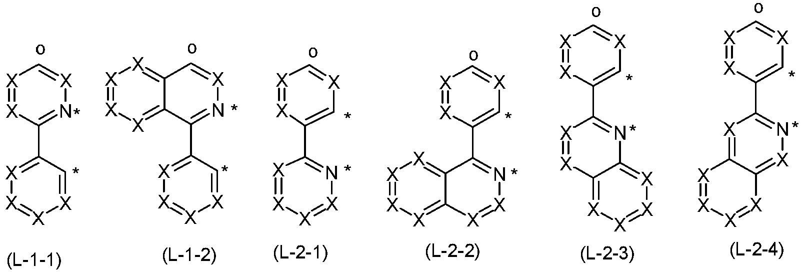 wobei die verwendeten Symbole die oben genannten Bedeutungen aufweisen und "o" die Position der Bindung an die Gruppe der Formel (4b), (5b), (6b) bzw. (7b) darstellt.

Besonders bevorzugte Teilliganden (L-1) sind die Strukturen der Formeln (L-1-1a) und (L-1-2b), und besonders bevorzugte Teilliganden (L-2) sind die Strukturen der Formeln (L-2-1a) bis (L-2-4a), 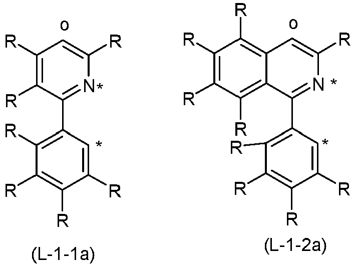 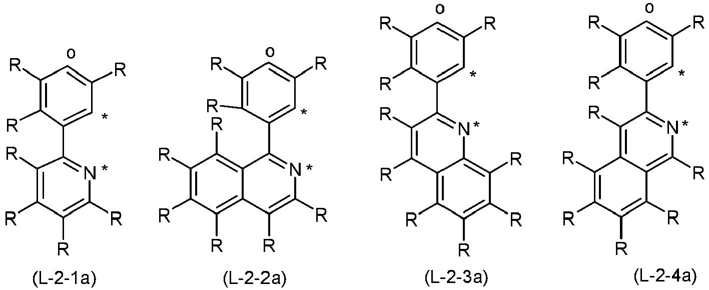 wobei die verwendeten Symbole die oben genannten Bedeutungen aufweisen und "o" die Position der Bindung an die Gruppe der Formel (4b), (5b), (6b) bzw. (7b) darstellt.

Wenn zwei Reste R, von denen einer an CyC und der andere an CyD gebunden sind, miteinander ein aromatisches Ringsystem bilden, können sich überbrückte Teilliganden und beispielsweise auch Teilliganden ergeben, die insgesamt eine einzige größere Heteroarylgruppe darstellen, wie beispielsweise Benzo[h]chinolin, etc.. Die Ringbildung zwischen den Substituenten an CyC und CyD erfolgt dabei bevorzugt durch eine Gruppe gemäß einer der folgenden Formeln (34) bis (43), 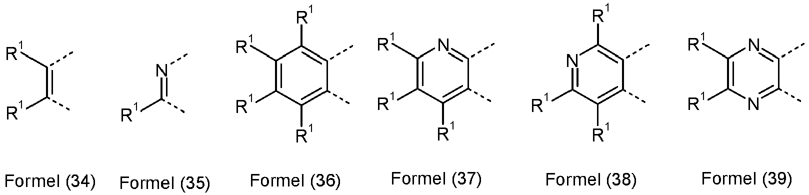 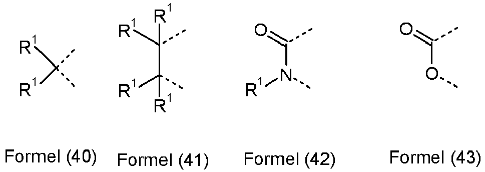 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Möglichkeiten eingebaut werden, beispielsweise kann bei der Gruppe der Formel (43) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Besonders bevorzugt sind die Gruppen der Formeln (34) und (36). Weiterhin ist die Gruppe der Formel (40) insbesondere dann bevorzugt, wenn sich dadurch die Ringbildung zu einem Sechsring ergibt, wie beispielsweise unten durch die Formeln (L-21) und (L-22) dargestellt.

Bevorzugte Liganden, die durch Ringbildung zweier Reste R an den unterschiedlichen Cyclen entstehen, sind die im Folgenden aufgeführten Strukturen der Formeln (L-3) bis (L-30), 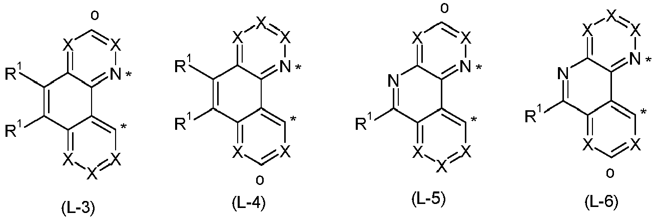 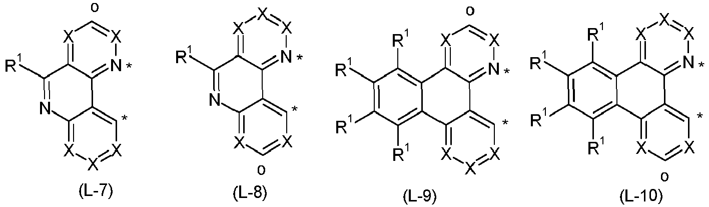 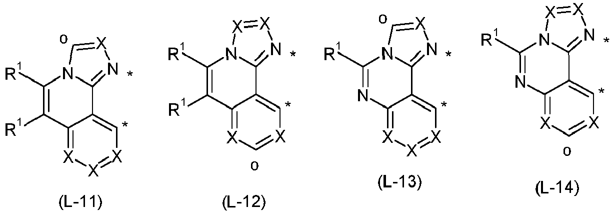 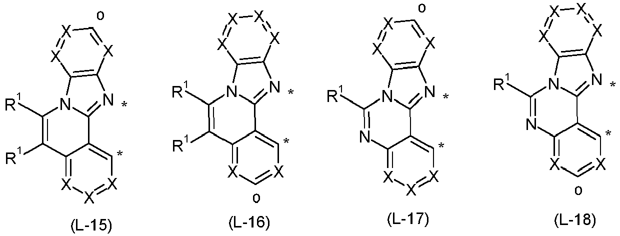 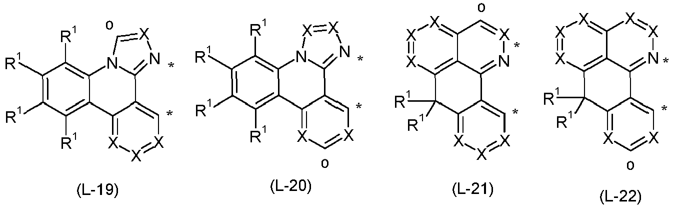 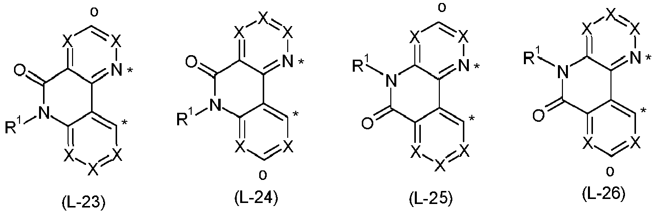 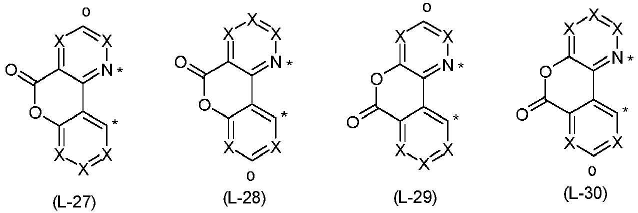 wobei die verwendeten Symbole die oben genannten Bedeutungen aufweisen und "o" die Position angibt, an denen dieser Teilligand mit der Gruppe der Formel (4b), (5b), (6b) bzw. (7b) verknüpft ist.

In einer bevorzugten Ausführungsform der Teilliganden der Formeln (L-3) bis (L-30) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L-5) bis (L-32) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist.

Dabei ist dieser Substituent R bevorzugt eine Gruppe, ausgewählt aus CF₃, OCF₃, Alkylgruppen mit 1 bis 10 C-Atomen, insbesondere verzweigten oder cyclischen Alkylgruppen mit 3 bis 10 C-Atomen, OR¹, wobei R¹ für eine Alkylgruppe mit 1 bis 10 C-Atomen, insbesondere eine verzweigte oder cyclische Alkylgruppe mit 3 bis 10 C-Atomen steht, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Teilligand für Metallkomplexe, in denen das Metall ein Übergangsmetall ist, ist ein Teilligand der folgenden Formel (L-31) oder (L-32), 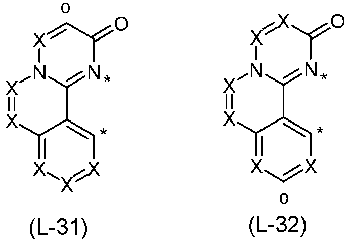 wobei R die oben genannten Bedeutungen aufweist, * die Position der Koordination an das Metall darstellt, "o" die Position der Verknüpfung des Teilliganden mit der Gruppe der Formel (4b), (5b), (6b) bzw. (7b) darstellt und weiterhin gilt:
- X: ist bei jedem Auftreten gleich oder verschieden CR oder N mit der Maßgabe, dass maximal ein Symbol X pro Cyclus für N steht.

Wenn zwei Reste R, die in den Teilliganden (L-31) bzw. (L-32) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der Formel (44), 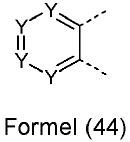 wobei die gestrichelten Bindungen die Verknüpfung dieser Gruppe im Teilliganden symbolisieren und Y gleich oder verschieden bei jedem Auftreten für CR¹ oder N steht und bevorzugt maximal ein Symbol Y für N steht.

In einer bevorzugten Ausführungsform des Teilliganden (L-31) bzw. (L-32) ist maximal eine Gruppe der Formel (44) vorhanden. Es handelt sich also bevorzugt um Teilliganden der folgenden Formeln (L-33) bis (L-38), 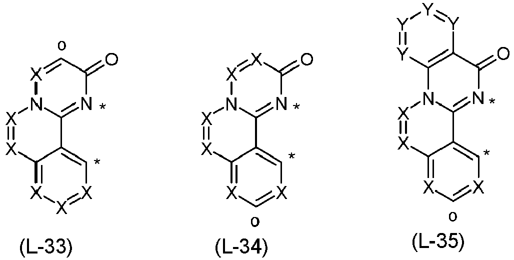 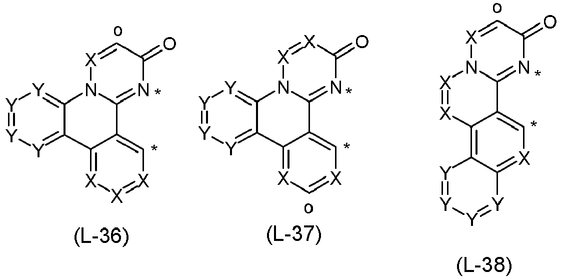 wobei X bei jedem Auftreten gleich oder verschieden für CR oder N steht, jedoch die Reste R nicht miteinander ein aromatisches oder heteroaromatisches Ringsystem bilden und die weiteren Symbole die oben genannten Bedeutungen aufweisen.

In einer bevorzugten Ausführungsform der Erfindung stehen im Teilliganden der Formel (L-31) bis (L-38) insgesamt 0, 1 oder 2 der Symbole X und, falls vorhanden, Y für N. Besonders bevorzugt stehen insgesamt 0 oder 1 der Symbole X und, falls vorhanden, Y für N.

Bevorzugte Ausführungsformen der Formeln (L-33) bis (L-38) sind die Strukturen der folgenden Formeln (L-33a) bis (L-38f), 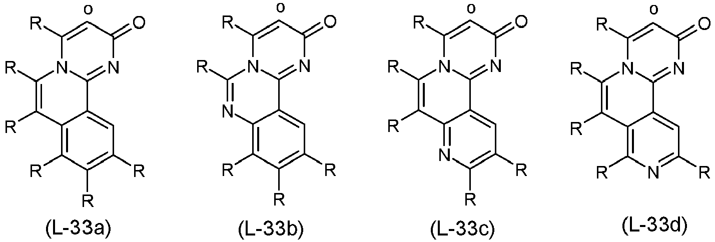 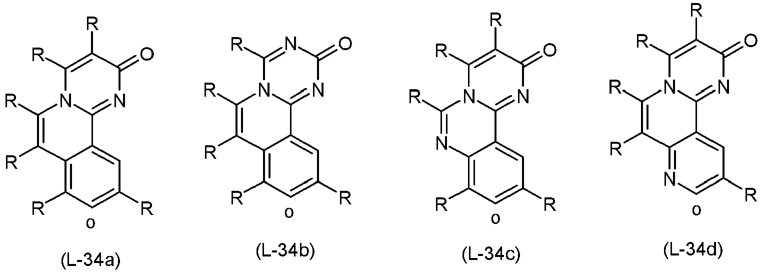 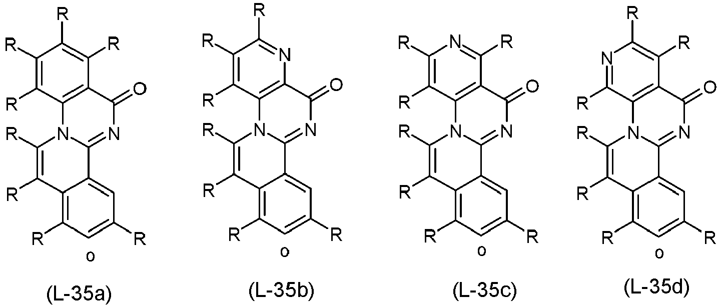 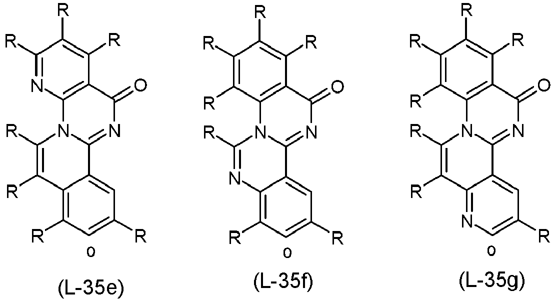 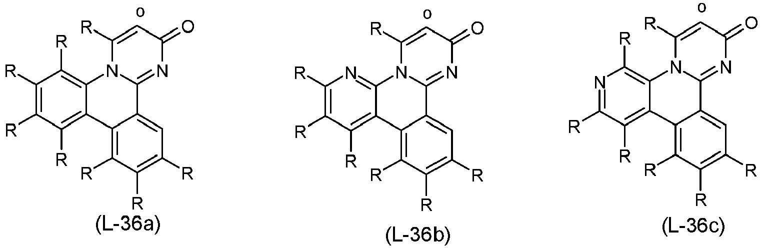 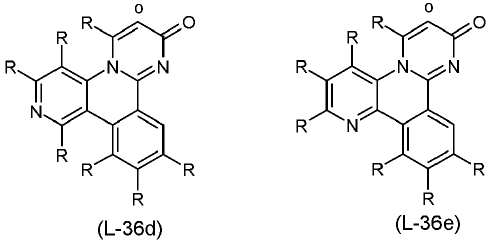 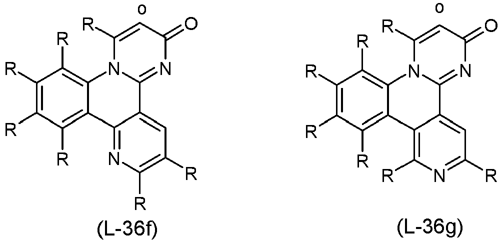 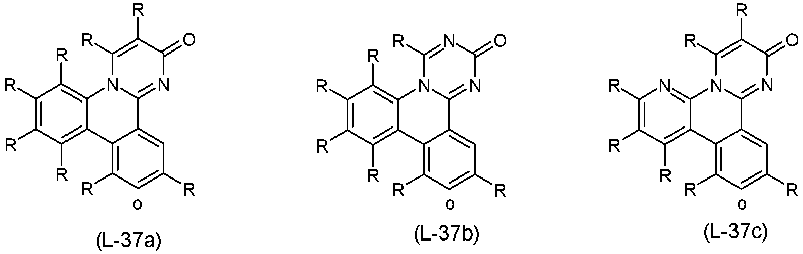 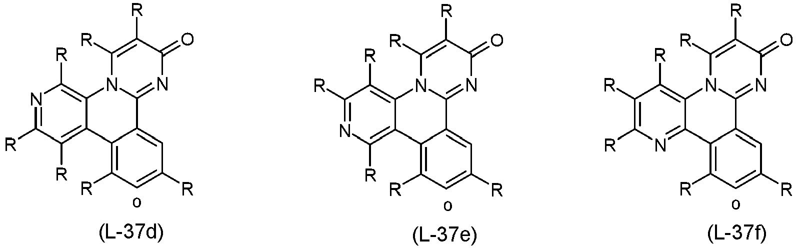 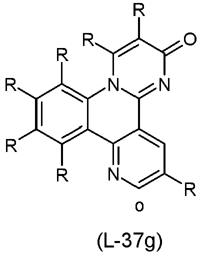 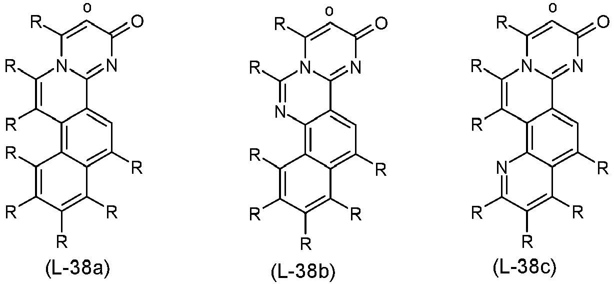 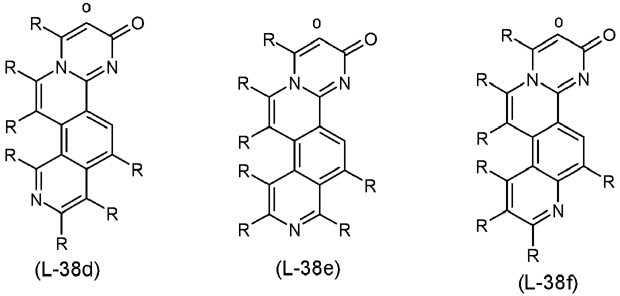 wobei die verwendeten Symbole die oben genannten Bedeutungen aufweisen und "o" die Position der Verknüpfung mit der Gruppe der Formel (4b), (5b), (6b) bzw. (7b) anzeigt.

In einer bevorzugten Ausführungsform der Erfindung steht die Gruppe X, die in ortho-Position zur Koordination an das Metall vorliegt, für CR. Dabei ist in dieser Rest R, der in ortho-Position zur Koordination an das Metall gebunden ist, bevorzugt ausgewählt aus der Gruppe bestehend aus H, D, F und Methyl.

In einer weiteren Ausführungsform der Erfindung ist es bevorzugt, falls eines der Atome X oder, wenn vorhanden, Y für N steht, wenn benachbart zu diesem Stickstoffatom eine Gruppe R als Substituent gebunden ist, welche ungleich Wasserstoff oder Deuterium ist.

Dabei ist dieser Substituent R bevorzugt eine Gruppe, ausgewählt aus CF₃, OCF₃, Alkylgruppen mit 1 bis 10 C-Atomen, insbesondere verzweigten oder cyclischen Alkylgruppen mit 3 bis 10 C-Atomen, OR¹, wobei R¹ für eine Alkylgruppe mit 1 bis 10 C-Atomen, insbesondere eine verzweigte oder cyclische Alkylgruppe mit 3 bis 10 C-Atomen steht, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Im Folgenden werden bevorzugte Substituenten beschrieben, wie sie an den oben beschriebenen Teilliganden L¹, L² und L³, aber auch an der bivalenten Arylengruppe in der Struktur der Formeln (4b) bis (7b) vorliegen können.

In einer Ausführungsform der Erfindung enthält die erfindungsgemäße Verbindung zwei Substituenten R, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Gruppe der Formel (4b), (5b), (6b) bzw. (7b) vorliegen und/oder an einem oder mehreren der bidentaten Teilliganden vorliegen. Der aliphatische Ring, der durch die Ringbildung von zwei Substituenten R miteinander gebildet wird, wird bevorzugt durch eine der folgenden Formeln (45) bis (51) beschrieben, 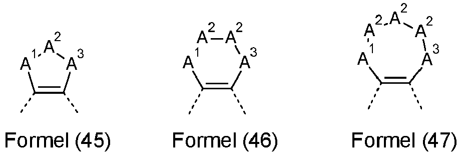 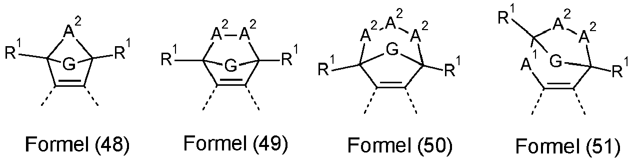 wobei R¹ und R² die oben genannten Bedeutungen aufweisen, die gestrichelten Bindungen die Verknüpfung der beiden Kohlenstoffatome im Liganden andeuten und weiterhin gilt:
- A¹, A³: ist gleich oder verschieden bei jedem Auftreten C(R³)₂, O, S, NR³ oder C(=O);
- A²: ist C(R¹)₂, O, S, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine gerad-kettige Alkyl- oder Alkoxygruppe mit 1 bis 10 C-Atomen, eine ver-zweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In den oben abgebildeten Strukturen der Formeln (45) bis (51) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (45) bis (47) dadurch erreicht, dass A¹ und A³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (48) bis (51) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (48) bis (51) für H steht, handelt es sich dabei daher um ein nicht-azides Proton im Sinne der vorliegenden Anmeldung.

In einer bevorzugten Ausführungsform der Erfindung ist R³ ungleich H.

In einer bevorzugten Ausführungsform der Struktur gemäß Formel (45) bis (51) steht maximal eine der Gruppen A¹, A² und A³ für ein Heteroatom, insbesondere für O oder NR³, und die anderen Gruppen stehen für C(R³)₂ bzw. C(R¹)₂ oder A¹ und A³ stehen gleich oder verschieden bei jedem Auftreten für O oder NR³ und A² steht für C(R¹)₂. In einer besonders bevorzugten Ausführungsform der Erfindung stehen A¹ und A³ gleich oder verschieden bei jedem Auftreten für C(R³)₂ und A² steht für C(R¹)₂ und besonders bevorzugt für C(R³)₂ oder CH₂.

Bevorzugte Ausführungsformen der Formel (45) sind somit die Strukturen der Formel (45-A), (45-B), (45-C) und (45-D), und eine besonders bevorzugte Ausführungsform der Formel (45-A) sind die Strukturen der Formel (45-E) und (45-F), 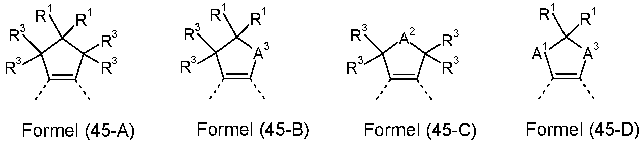 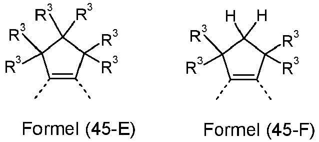 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (46) sind die Strukturen der folgenden Formeln (46-A) bis (46-F), 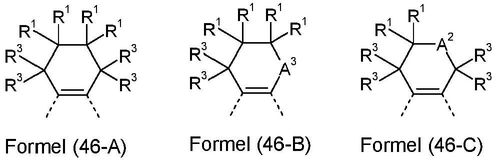 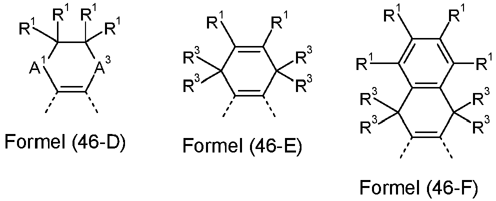 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (47) sind die Strukturen der folgenden Formeln (47-A) bis (47-E), 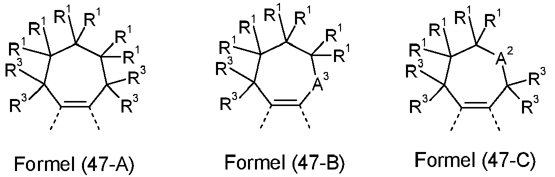 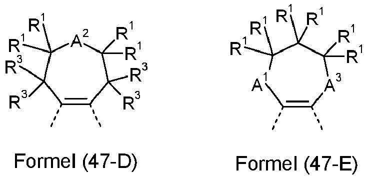 wobei R¹ und R³ die oben genannten Bedeutungen aufweisen und A¹, A² und A³ gleich oder verschieden bei jedem Auftreten für O oder NR³ steht.

In einer bevorzugten Ausführungsform der Struktur gemäß Formel (48) stehen die Reste R¹, die an den Brückenkopf gebunden sind, für H, D, F oder CH₃. Weiterhin bevorzugt steht A² für C(R¹)₂ oder O, und besonders bevorzugt für C(R³)₂. Bevorzugte Ausführungsformen der Formel (48) sind somit eine Strukturen der Formel (48-A) und (48-B), und eine besonders bevorzugte Ausführungsform der Formel (48-A) ist eine Struktur der Formel (48-C), 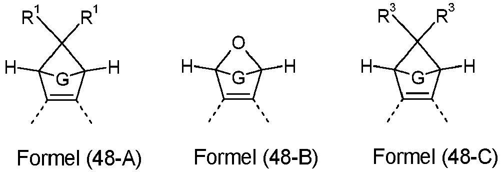 wobei die verwendeten Symbole die oben genannten Bedeutungen aufweisen.

In einer bevorzugten Ausführungsform der Struktur gemäß Formel (49), (50) und (51) stehen die Reste R¹, die an den Brückenkopf gebunden sind, für H, D, F oder CH₃. Weiterhin bevorzugt steht A² für C(R¹)₂. Bevorzugte Ausführungsformen der Formel (49), (50) und (51) sind somit die Strukturen der Formeln (49-A), (50-A) und (51-A), 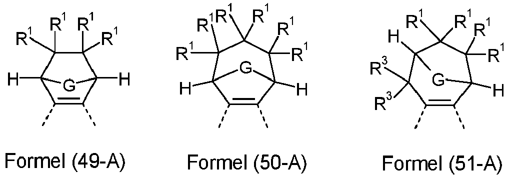 wobei die verwendeten Symbole die oben genannten Bedeutungen aufweisen.

Weiterhin bevorzugt steht die Gruppe G in den Formeln (48), (48-A), (48-B), (48-C), (49), (49-A), (50), (50-A), (51) und (51-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (45) bis (51) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (45) bis (51) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (45) sind die im Folgenden aufgeführten Strukturen:

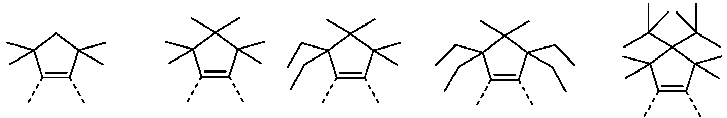

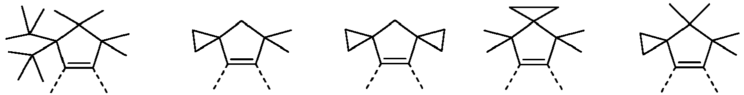

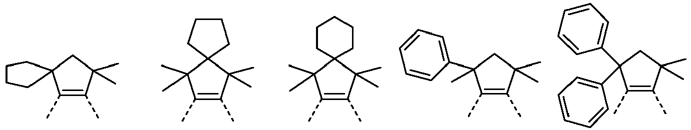

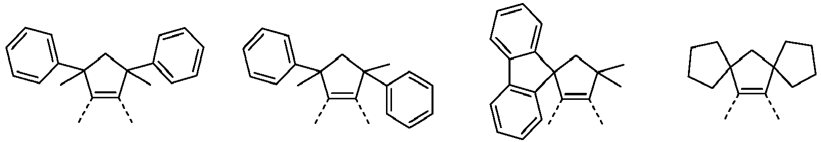

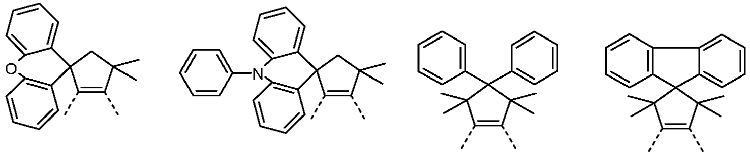

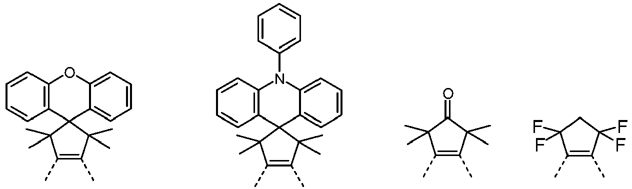

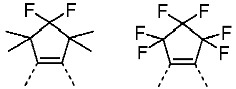

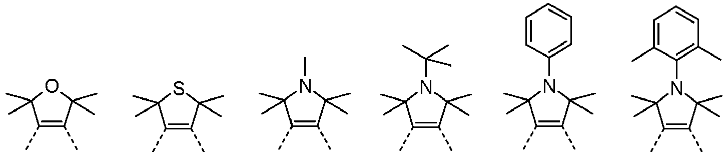

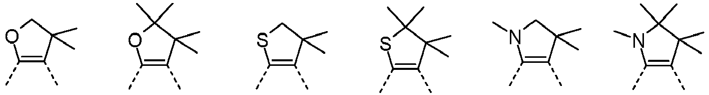

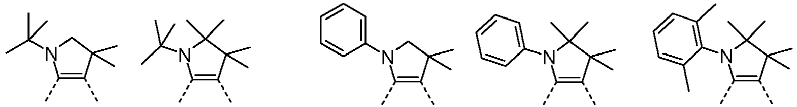

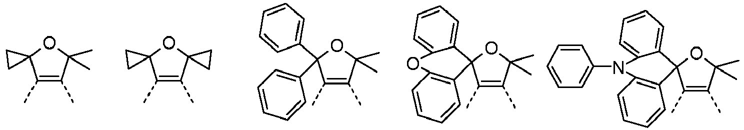

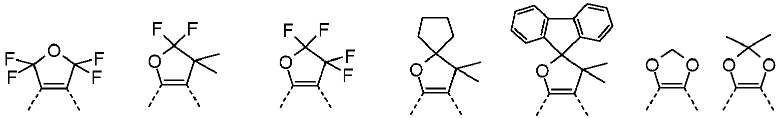

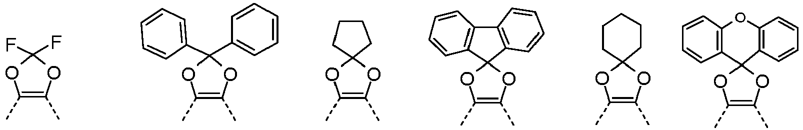

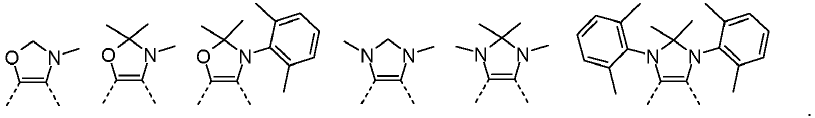

Beispiele für besonders geeignete Gruppen der Formel (46) sind die im Folgenden aufgeführten Strukturen:

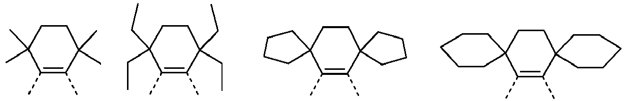

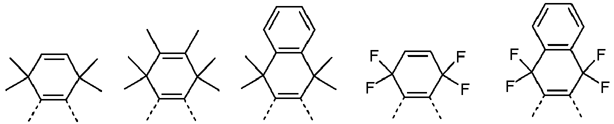

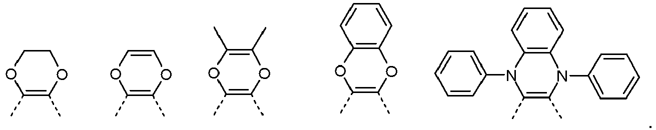

Beispiele für besonders geeignete Gruppen der Formel (47), (49) und (50) sind die im Folgenden aufgeführten Strukturen:

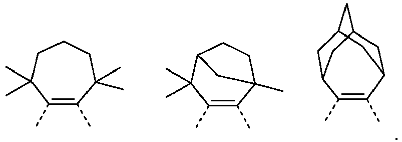

Beispiele für besonders geeignete Gruppen der Formel (48) sind die im Folgenden aufgeführten Strukturen:

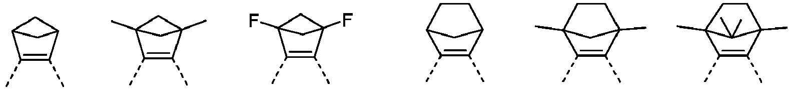

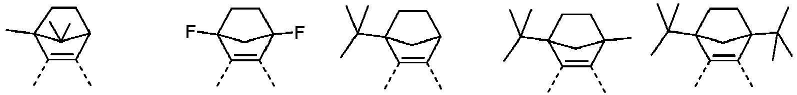

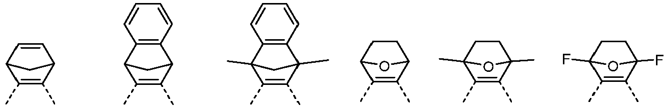

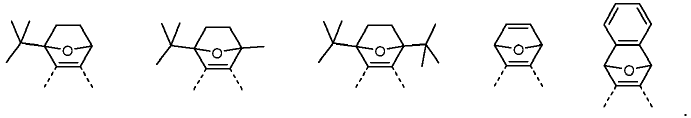

Beispiele für besonders geeignete Gruppen der Formel (49) sind die im Folgenden aufgeführten Strukturen:

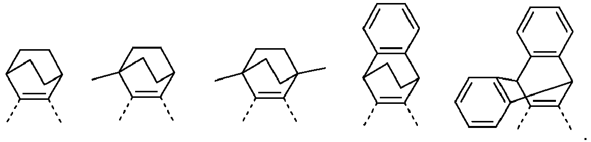

In einer weiteren Auführungsform der Erfindung ist der Teilligand L² mit einem Substituenten der folgenden Formel (52) oder (53) substituiert, bevorzugt in einer Position para zur Koordination an das Iridium, 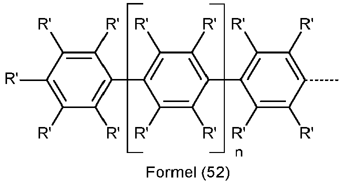 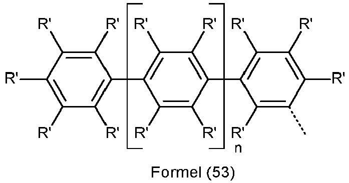 wobei die gestrichelte Bindung die Bindung an den Teilliganden L² andeutet und weiterhin gilt:
- R': ist gleich oder verschieden bei jedem Auftreten ausgewählt aus der Gruppe bestehend aus H, D, F, CN, einer geradkettigen Alkylgruppe mit 1 bis 10 C-Atomen, in der auch ein oder mehrere H-Atome durch D oder F ersetzt sein können, oder einer verzweigten oder cyclischen Alkylgruppe mit 3 bis 10 C-Atomen, in der auch ein oder mehrere H-Atome durch D oder F ersetzt sein können, oder einer Alkenylgruppe mit 2 bis 10 C-Atomen, in der auch ein oder mehrere H-Atome durch D oder F ersetzt sein können; dabei können auch zwei benachbarte Reste R' bzw. zwei Reste R' an benachbarten Phenylgruppen mitein-ander ein Ringsystem bilden; oder zwei R' an benachbarten Phenyl-gruppen stehen zusammen für eine Gruppe ausgewählt aus O oder S, so dass die beiden Phenylringe zusammen mit der verbrückenden Gruppe für ein Dibenzofuran oder Dibenzothiophen stehen, und die weiteren R' sind wie vorstehend definiert;
- n: ist 0, 1, 2, 3, 4 oder 5.

Durch die Anwesenheit eines Substituenten der Formel (52) oder (53) kann orientierte Emission und dadurch eine Effizienzsteigerung erreicht werden.

Wenn der Teilligand L² einen Substituenten der Formel (52) oder (53) aufweist und L³ ebenfalls für einen Teilliganden steht, der über ein Kohlenstoffatom und ein Stickstoffatom oder zwei Kohlenstoffatome an das Iridium koordiniert, so ist es bevorzugt, wenn dieser Teilligand L³ entweder keine aromatischen oder heteroaromatischen Substituenten aufweist oder als Substituenten nur Aryl- oder Heteroarylgruppen aufweist, die nicht mehr als 6 aromatische Ringatome enthalten und die nur durch nicht-aromatische Substituenten substituiert sein können.

Die Gruppen der Formeln (52) und (53) unterscheiden sich lediglich darin, dass die Gruppe der Formel (52) in der para-Position und die Gruppe der Formel (53) in der meta-Position mit dem Teilliganden L² verknüpft ist.

In einer bevorzugten Ausführungsform der Erfindung ist in den Formeln (52) und (53) n = 0, 1 oder 2, bevorzugt 0 oder 1 und ganz besonders bevorzugt 0.

In einer weiteren bevorzugten Ausführungsform der Erfindung sind beide Substituenten R', welche in den ortho-Positionen zu dem Kohlenstoffatom gebunden sind, mit dem die Gruppe der Formel (52) bzw. (53) an den Phenylpyridinliganden gebunden ist, gleich oder verschieden H oder D.

Bevorzugte Ausführungsformen der Struktur der Formel (52) sind die Strukturen der Formeln (52a) bis (52n), und bevorzugte Ausführungsformen der Struktur der Formel (53) sind die Strukturen der Formeln (53a) bis (53n), 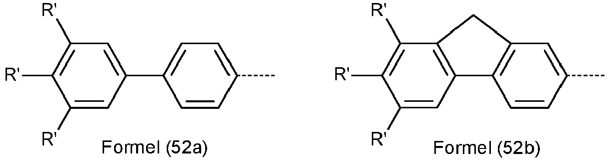 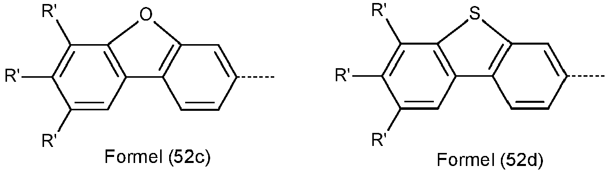 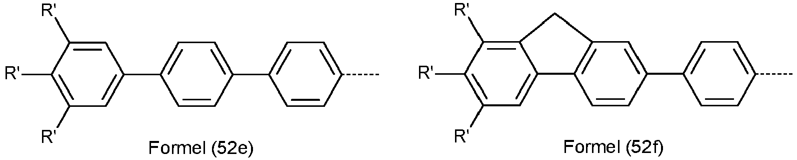 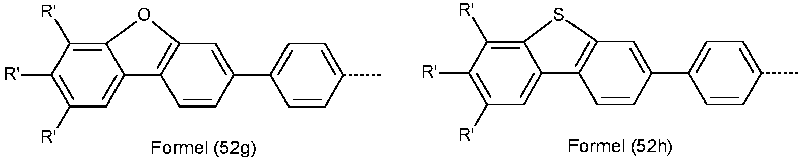 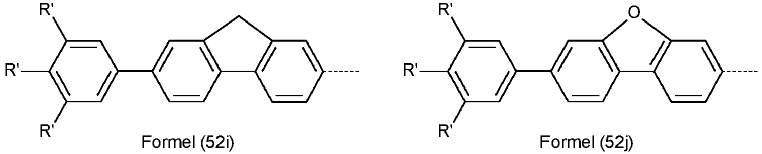 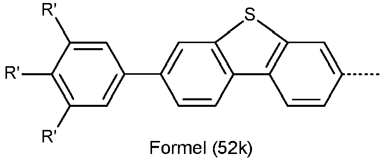 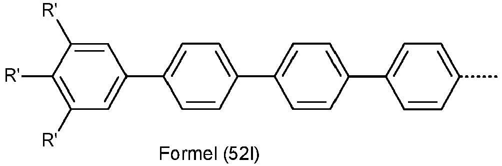 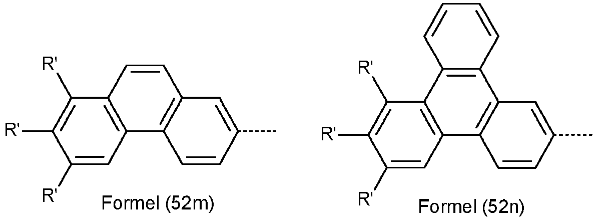 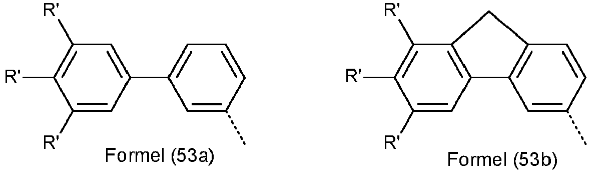 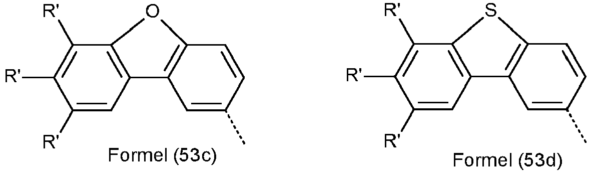 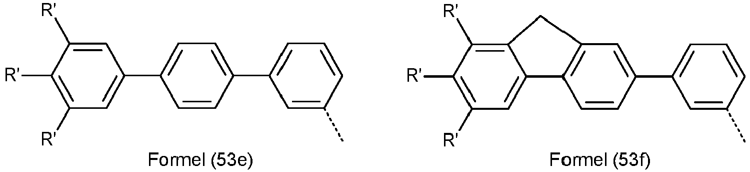 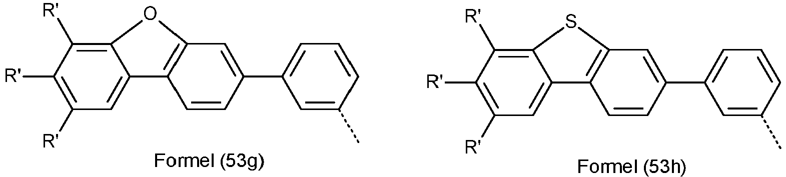 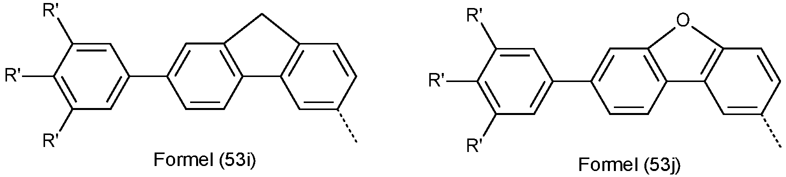 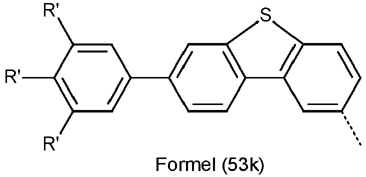 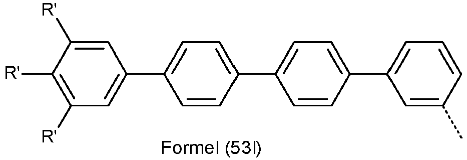 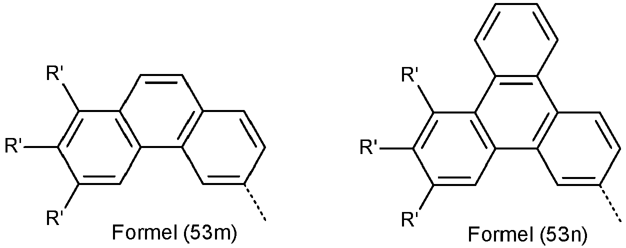 wobei die verwendeten Symbole die oben genannten Bedeutungen aufweisen und wobei die Fluorengruppe in 9-Position noch mit ein oder zwei Alkylgruppen mit jeweils 1 bis 6 C-Atomen substituiert sein kann, bevorzugt mit 1 bis 4 C-Atomen, besonders bevorzugt mit zwei Methylgruppen.

Bevorzugte Substituenten R' an den Gruppen der Formel (52) bzw. (53) bzw. den bevorzugten Ausführungsformen sind gewählt aus der Gruppe bestehend aus H, D, CN und einer Alkylgruppe mit 1 bis 4 C-Atomen, besonders bevorzugt H, D oder Methyl.

Die Substiutenten der Formeln (52) bzw. (53) werden bevorzugt in Komplexen eingesetzt, in denen der Teilligand L³ gleich oder verschieden dem Teiliganden L¹ ist, also in Komplexen, die zwei Teilliganden der Formel (2) aufweisen.

Wenn in den bidentaten Teilliganden bzw. in den bivalenten Arylengruppen in den Formeln (4b) bis (7b) gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, insbesondere mit 6 bis 13 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹ sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig. So ist es insbesondere bevorzugt, wenn die bevorzugten Ausführungsformen der Gruppe V mit den bevorzugten Ausführungsformen der Teilliganden L¹, L² und L³ und den bevorzugten Ausführungsformen der Substituenten kombiniert werden.

Beispiele für geeignete erfindungsgemäße Strukturen sind die nachfolgend abgebildeten Verbindungen.

| | |
|---|---|
| 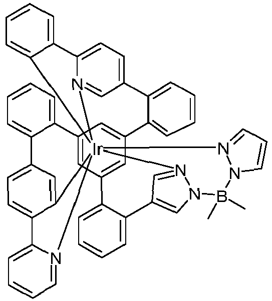 | 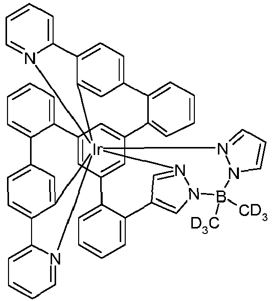 |
| 1 | 2 |
| 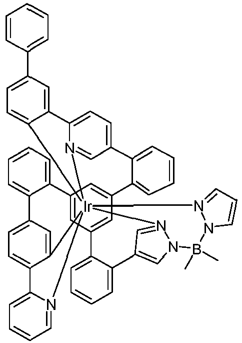 | 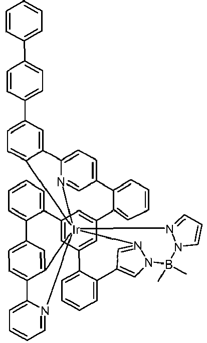 |
| 3 | 4 |
| 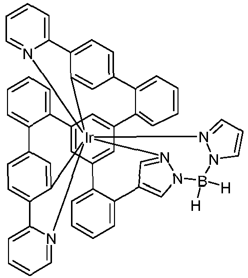 | 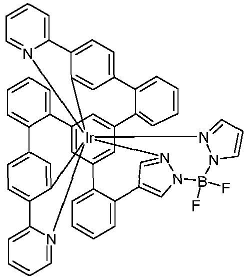 |
| 5 | 6 |
| 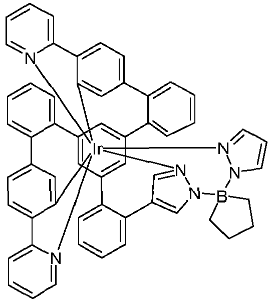 | 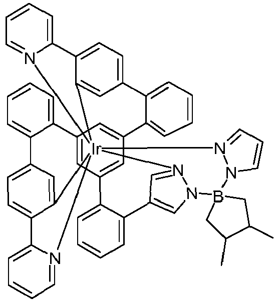 |
| 7 | 8 |
| 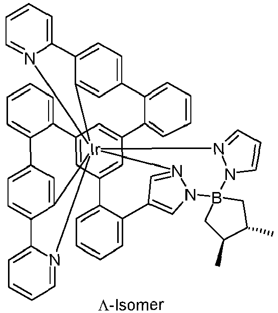 | 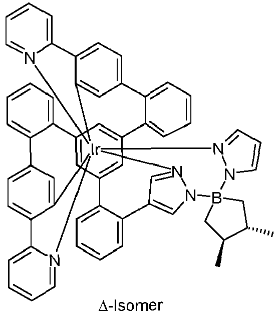 |
| 9 | 10 |
| 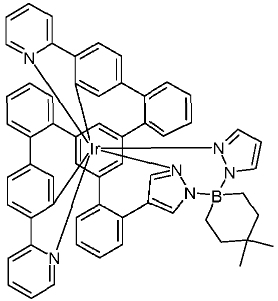 | 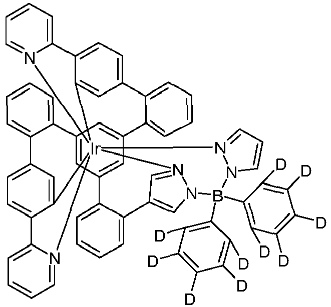 |
| 11 | 12 |
| 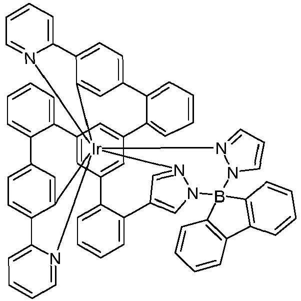 | 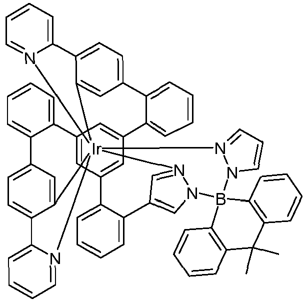 |
| 13 | 14 |
| 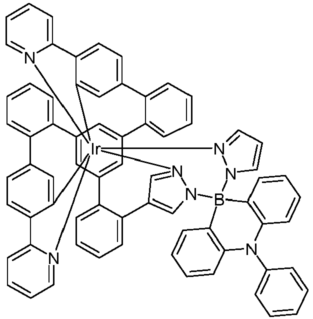 | 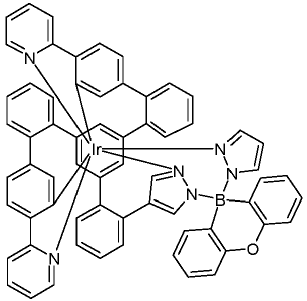 |
| 15 | 16 |
| 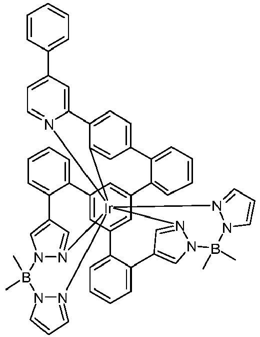 | 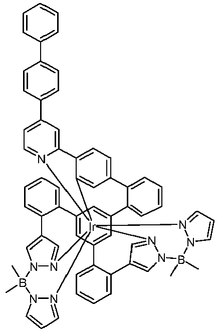 |
| 17 | 18 |
| 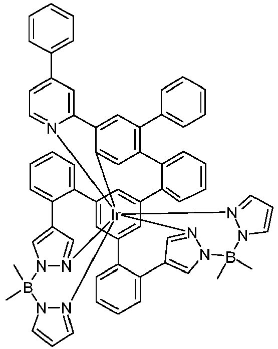 | 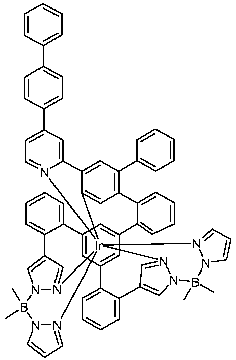 |
| 19 | 20 |
| 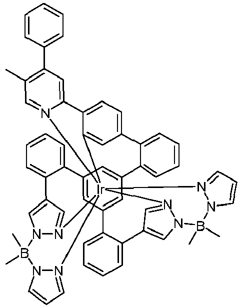 | 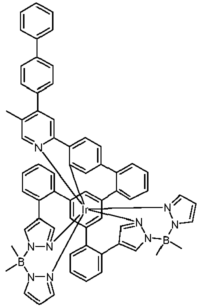 |
| 21 | 22 |
| 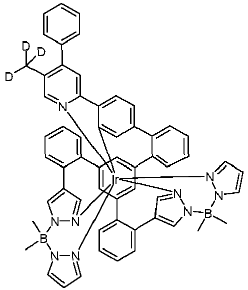 | 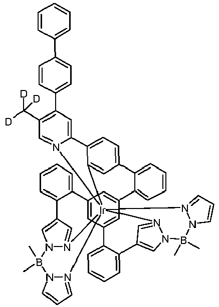 |
| 23 | 24 |
| 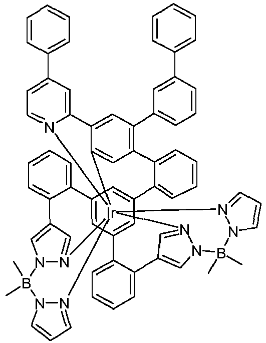 | 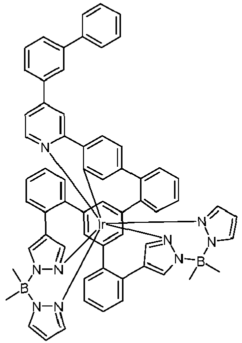 |
| 25 | 26 |
| 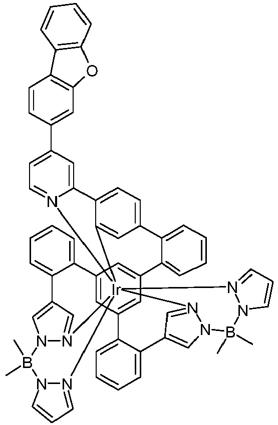 | 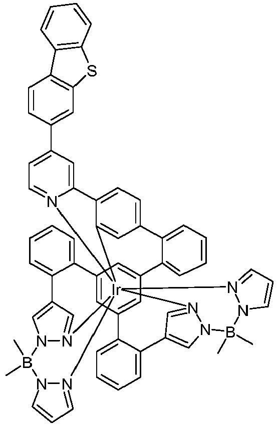 |
| 27 | 28 |
| 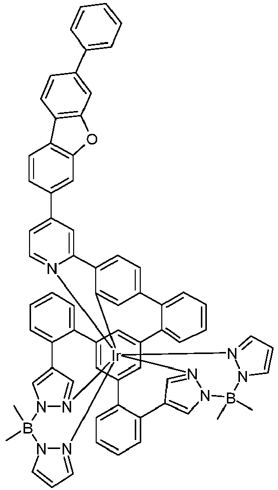 | 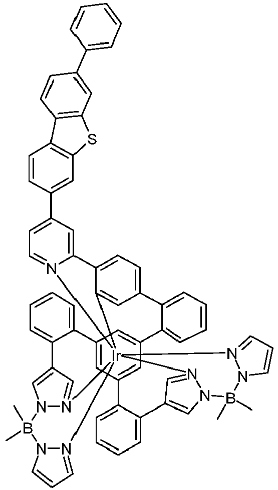 |
| 29 | 30 |
| 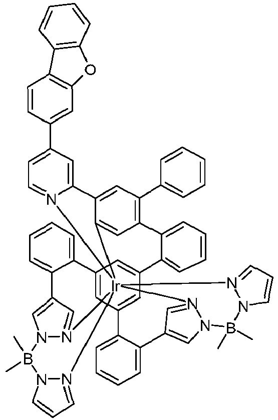 | 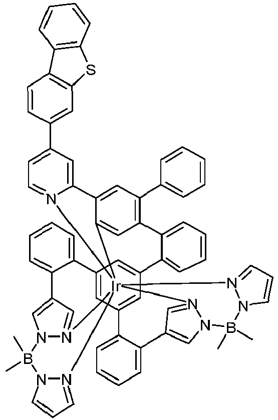 |
| 31 | 32 |
| 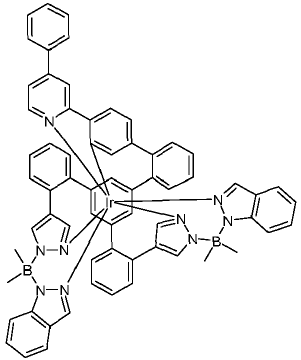 | 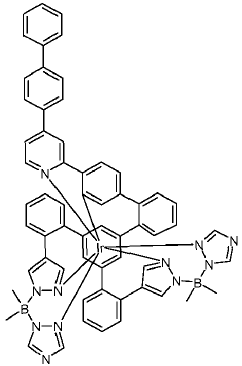 |
| 33 | 34 |
| 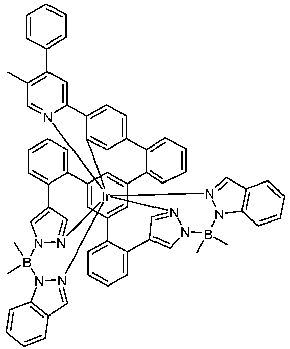 | 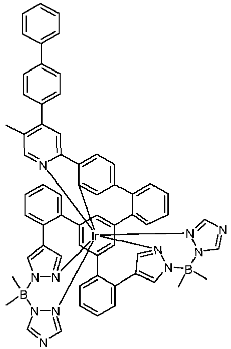 |
| 35 | 36 |
| 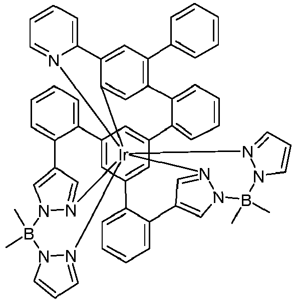 | 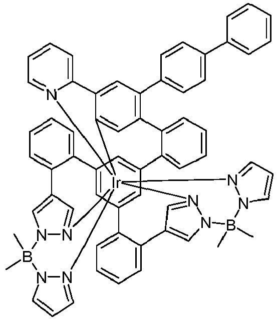 |
| 37 | 38 |
| 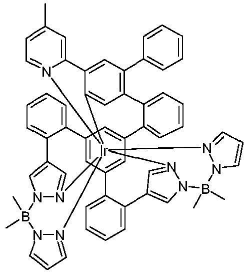 | 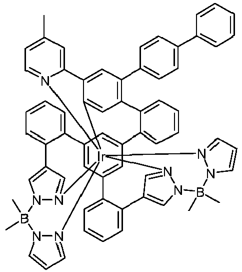 |
| 39 | 40 |
| 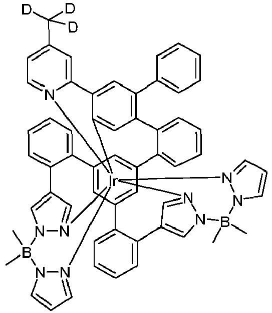 | 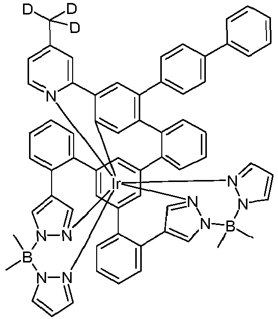 |
| 41 | 42 |
| 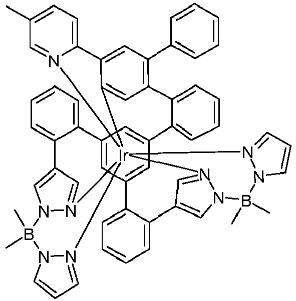 | 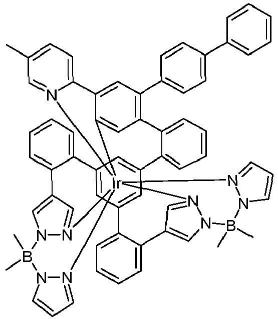 |
| 43 | 44 |
| 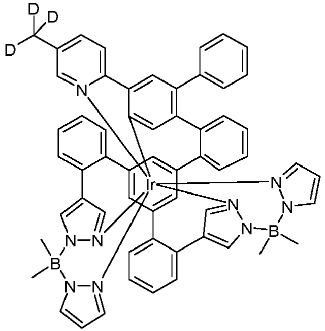 | 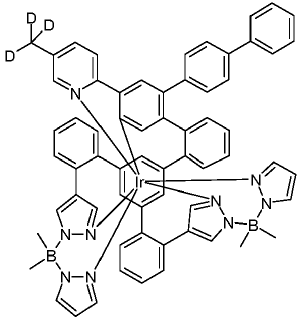 |
| 45 | 46 |
| 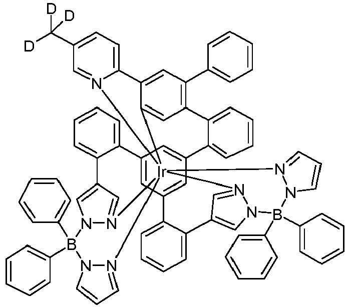 | 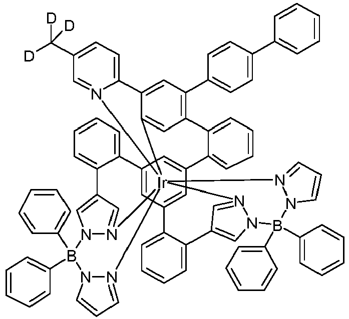 |
| 47 | 48 |
| 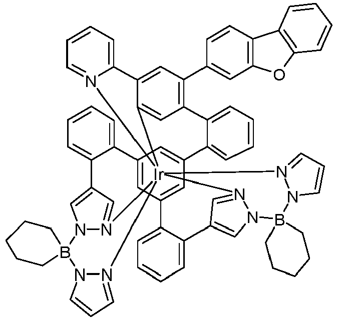 | 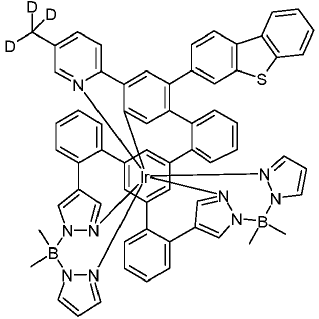 |
| 49 | 50 |
| 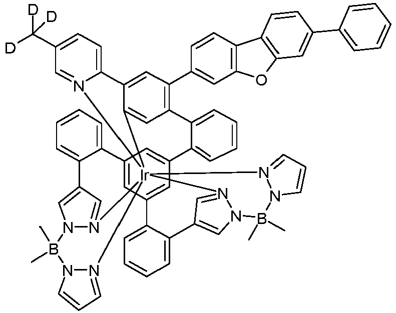 | 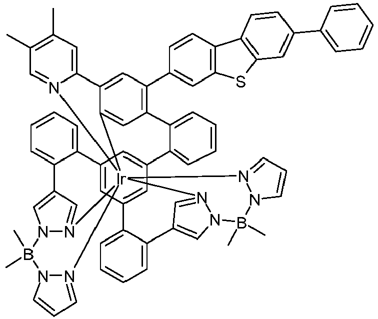 |
| 51 | 52 |
| 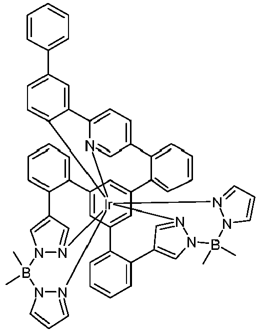 | 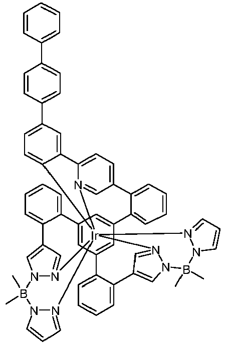 |
| 53 | 54 |
| 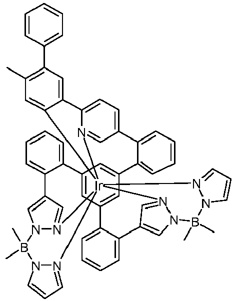 | 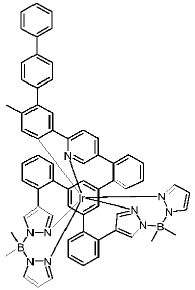 |
| 55 | 56 |
| 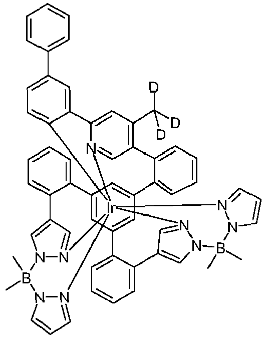 | 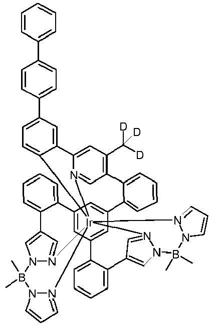 |
| 57 | R8 |
| 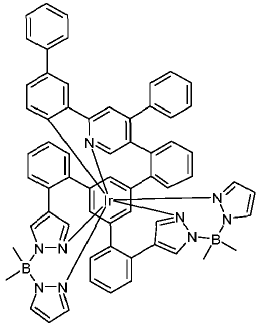 | 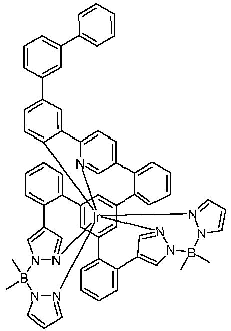 |
| 59 | 60 |
| 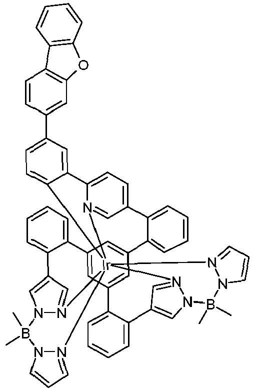 | 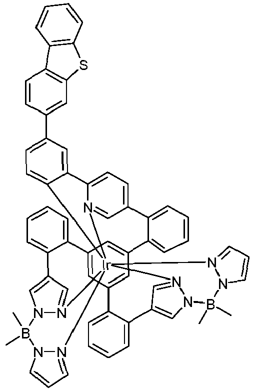 |
| 61 | 62 |
| 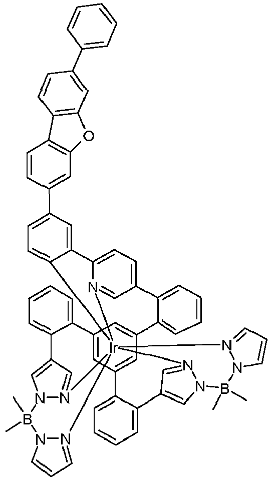 | 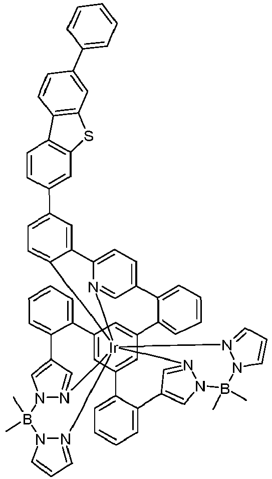 |
| 63 | 64 |
| 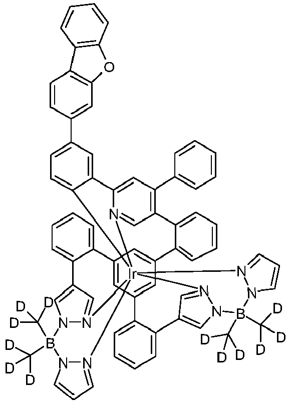 | 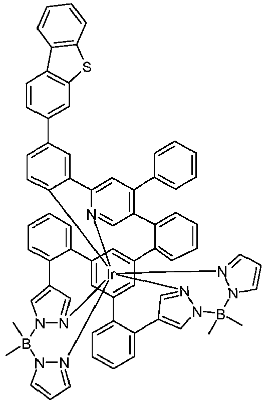 |
| 65 | 66 |
| 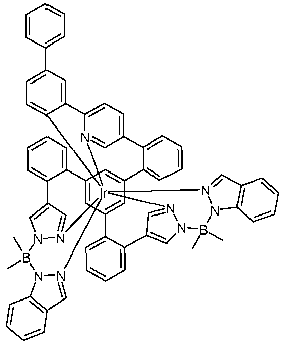 | 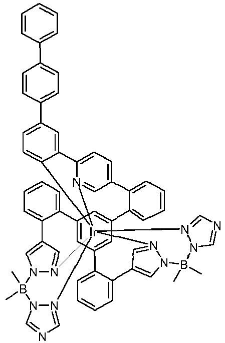 |
| 67 | 68 |
| 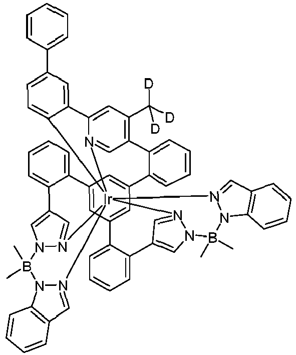 | 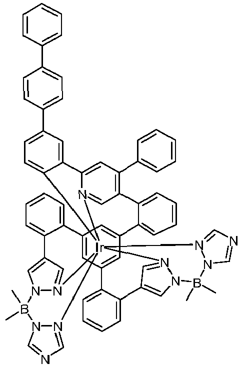 |
| 69 | 70 |
| 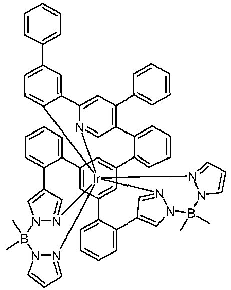 | 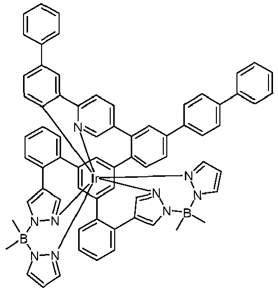 |
| 71 | 72 |
| 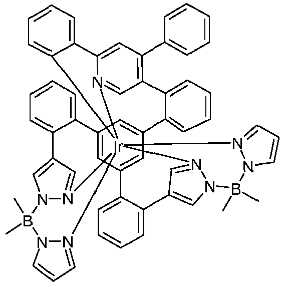 | 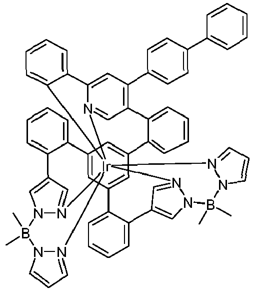 |
| 73 | 74 |
| 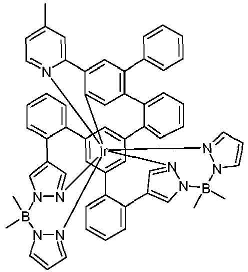 | 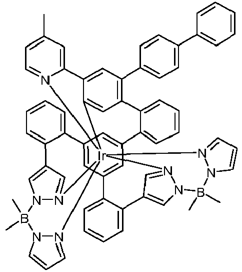 |
| 75 | 76 |
| 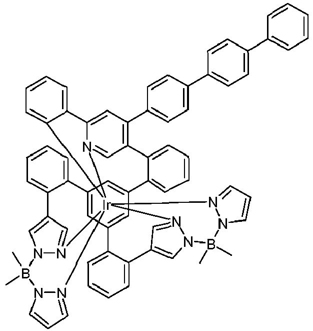 | 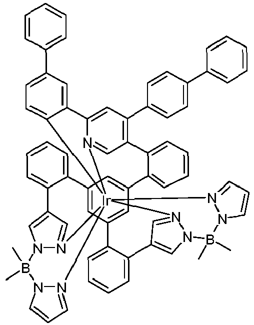 |
| 77 | 78 |
| 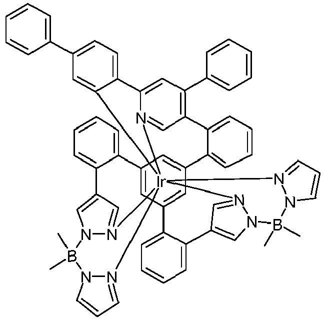 | 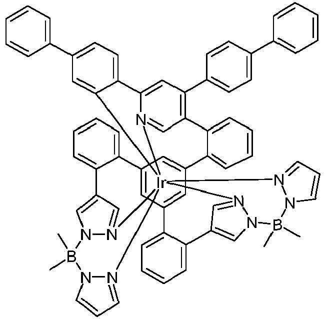 |
| 79 | 80 |
| 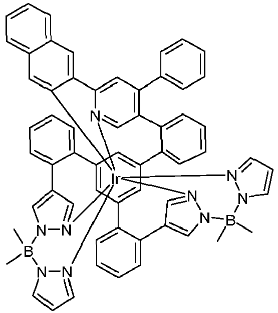 | 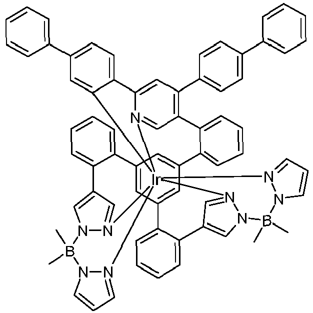 |
| 81 | 82 |
| 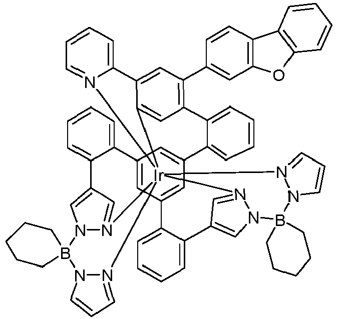 | 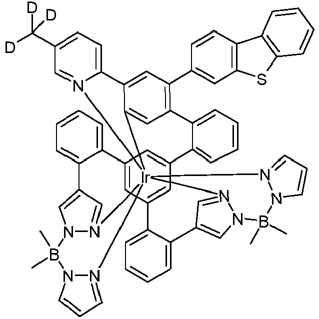 |
| 83 | 84 |
| 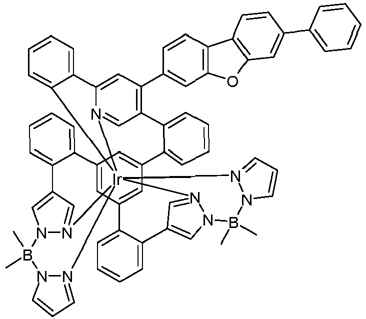 | 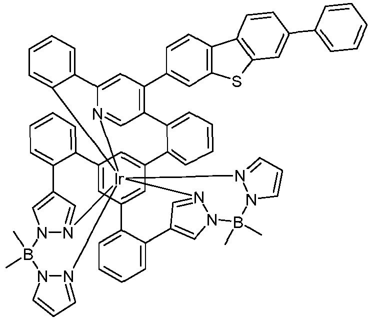 |
| 85 | 86 |
| 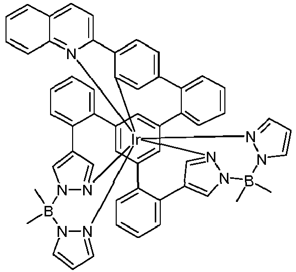 | 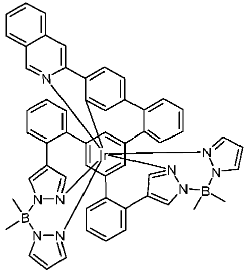 |
| 87 | 88 |
| 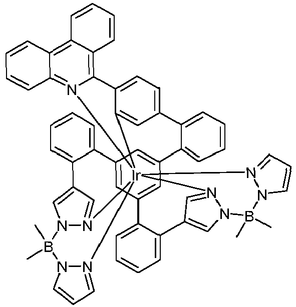 | 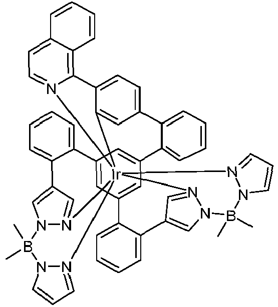 |
| 89 | 90 |
| 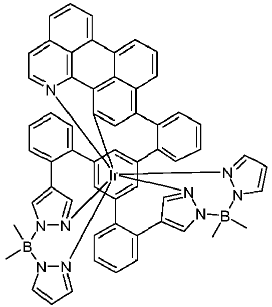 | 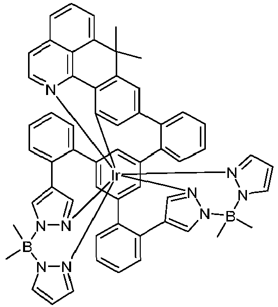 |
| 91 | 92 |
| 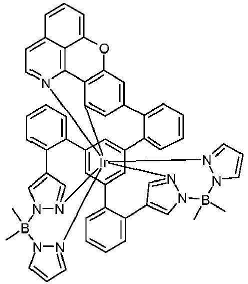 | 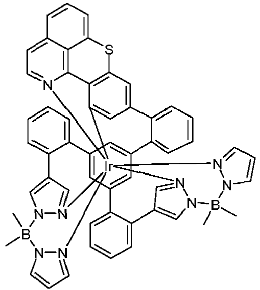 |
| 93 | 94 |
| 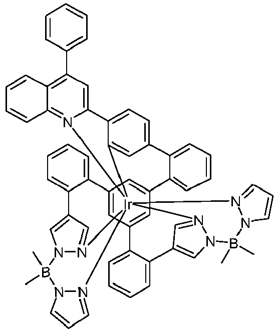 | 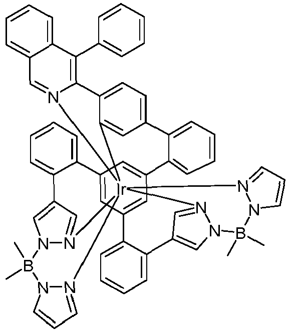 |
| 95 | 96 |
| 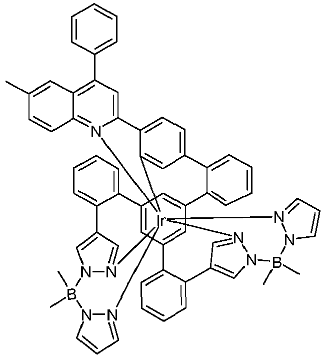 | 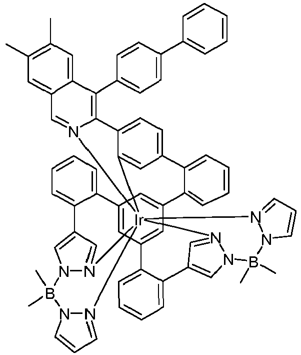 |
| 97 | 98 |
| 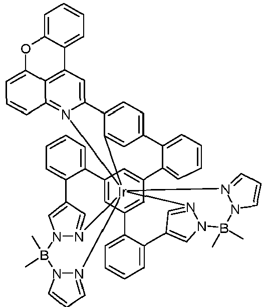 | 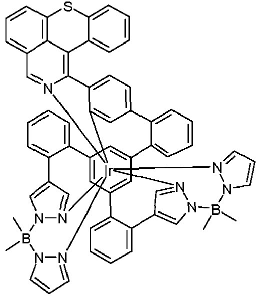 |
| 99 | 100 |
| 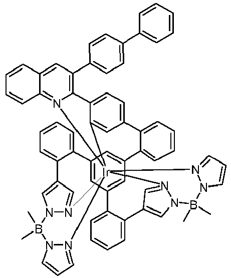 | 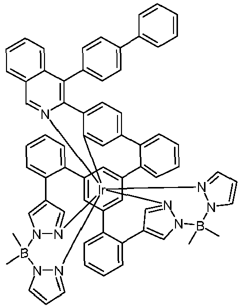 |
| 101 | 102 |
| 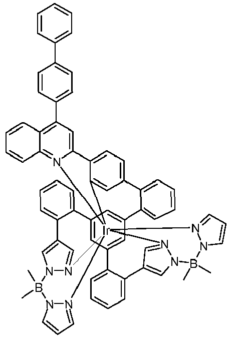 | 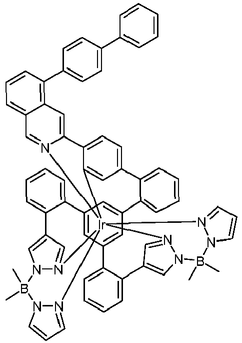 |
| 103 | 104 |
| 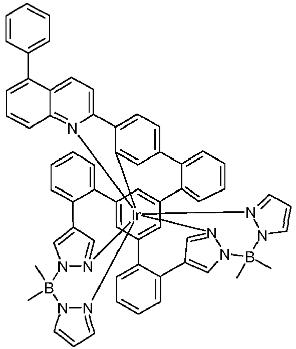 | 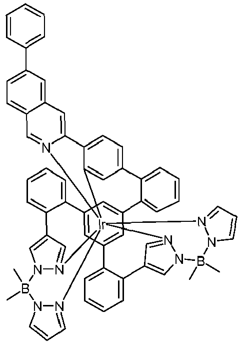 |
| 105 | 106 |
| 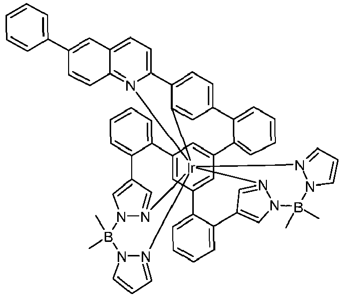 | 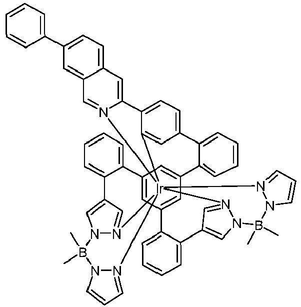 |
| 107 | 108 |
| 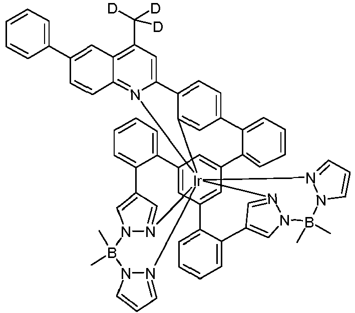 | 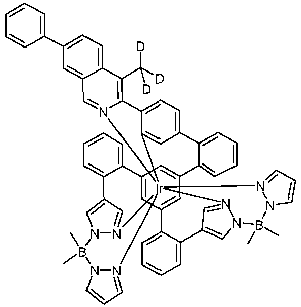 |
| 109 | 110 |
| 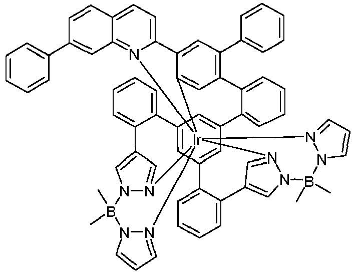 | 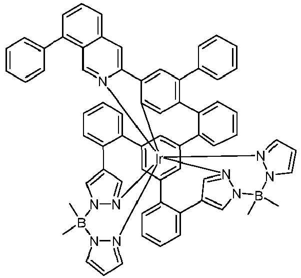 |
| 111 | 112 |
| 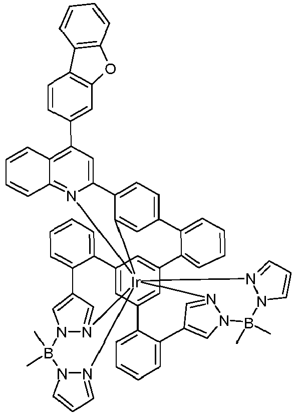 | 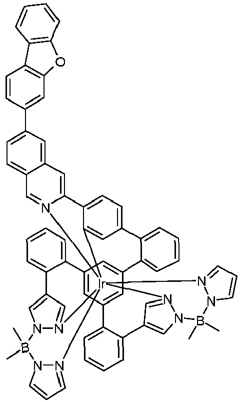 |
| 113 | 114 |
| 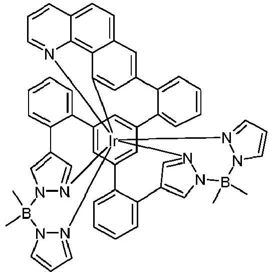 | 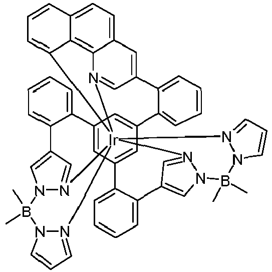 |
| 115 | 116 |
| 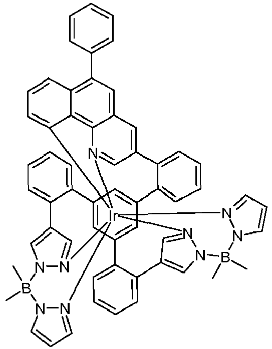 | 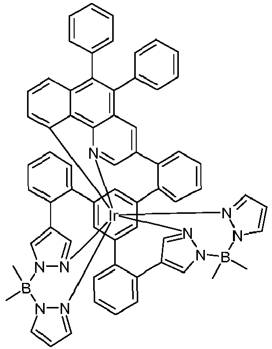 |
| 117 | 118 |
| 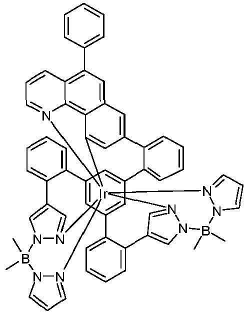 | 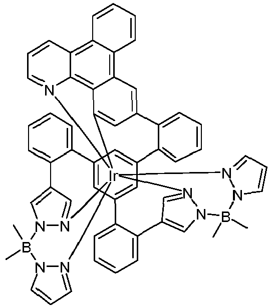 |
| 119 | 120 |
| 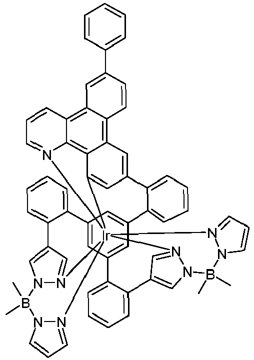 | 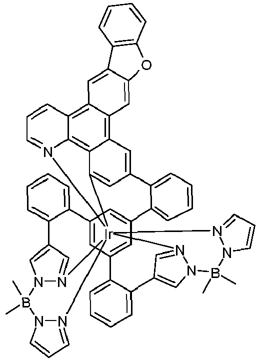 |
| 121 | 122 |
| 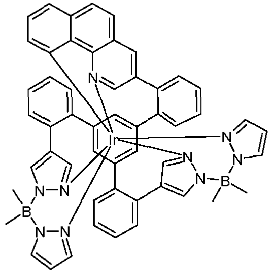 | 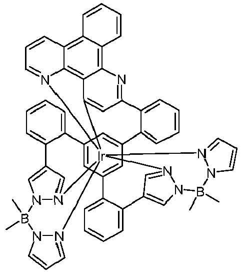 |
| 123 | 124 |
| 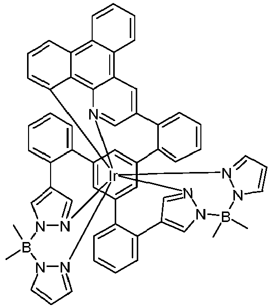 | 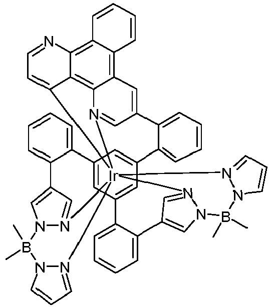 |
| 125 | 126 |
| 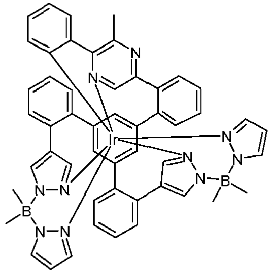 | 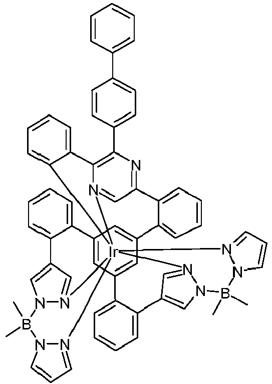 |
| 127 | 128 |
| 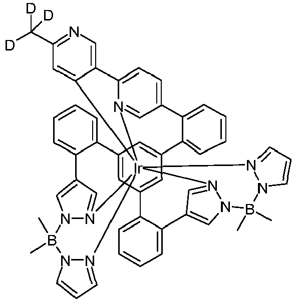 | 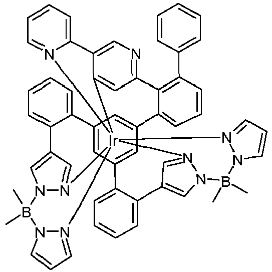 |
| 129 | 130 |
| 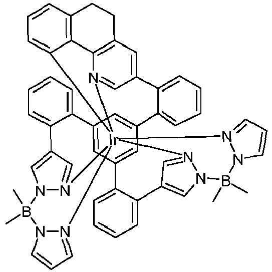 | 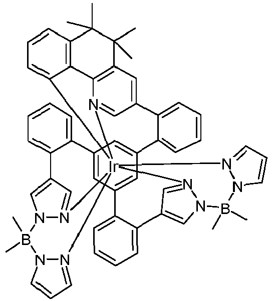 |
| 131 | 132 |
| 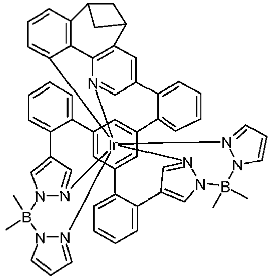 | 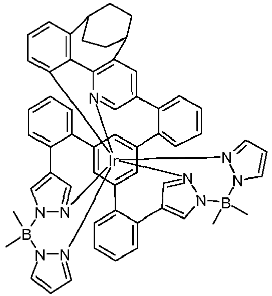 |
| 133 | 134 |
| 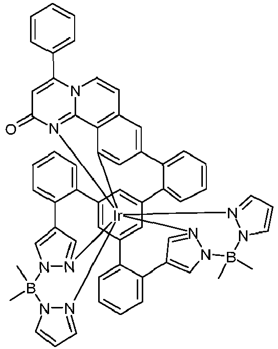 | 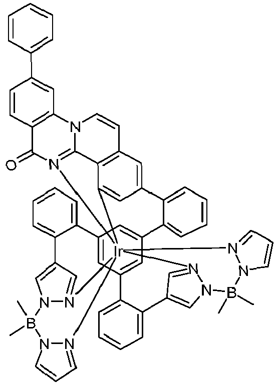 |
| 135 | 136 |
| 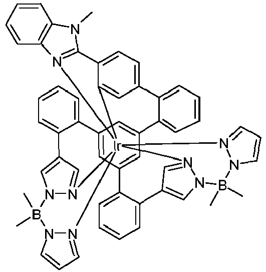 | 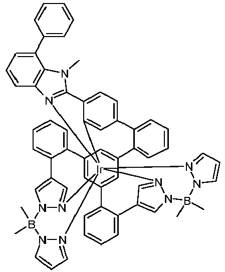 |
| 137 | 138 |
| 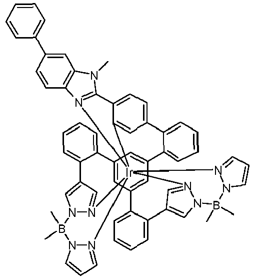 | 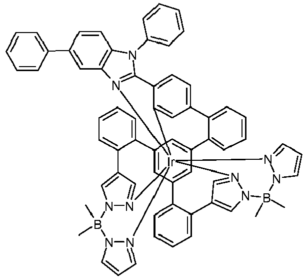 |
| 139 | 140 |
| 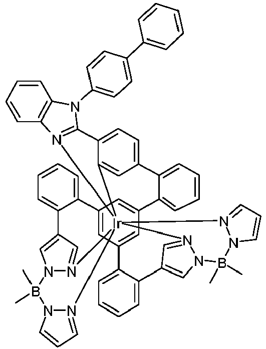 | 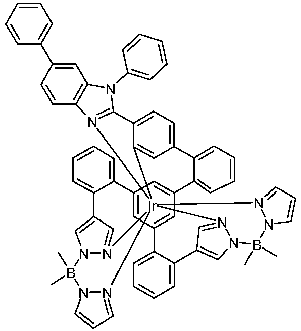 |
| 141 | 142 |
| 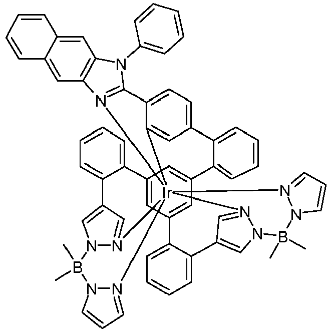 | 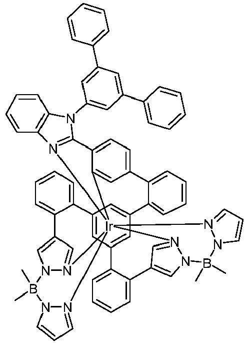 |
| 143 | 144 |
| 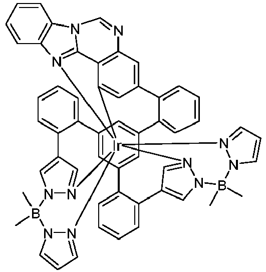 | 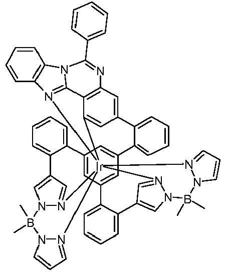 |
| 145 | 146 |
| 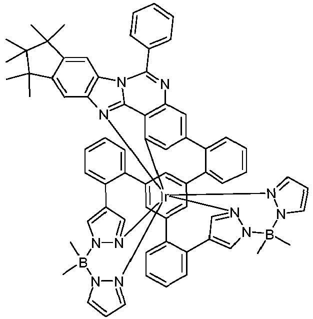 | 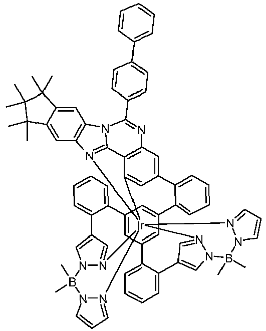 |
| 147 | 148 |
| 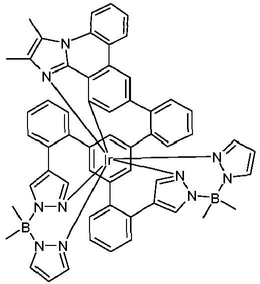 | 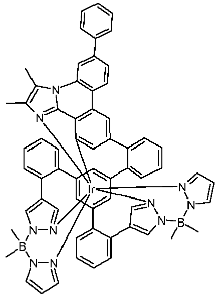 |
| 149 | 150 |
| 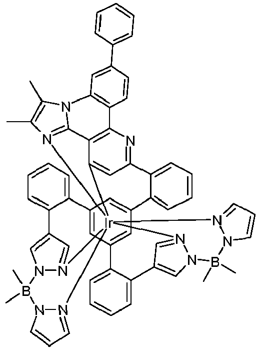 | 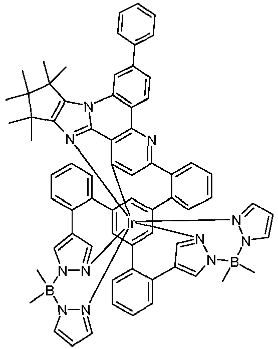 |
| 151 | 152 |
| 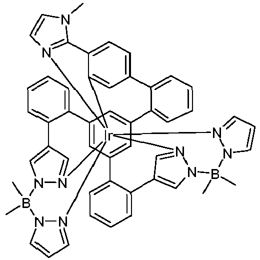 | 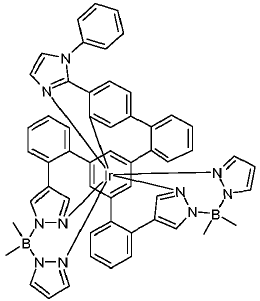 |
| 153 | 154 |
| 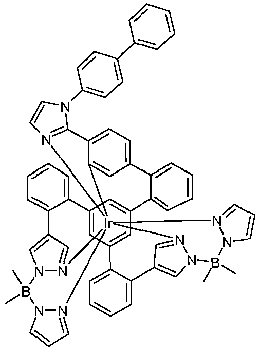 | 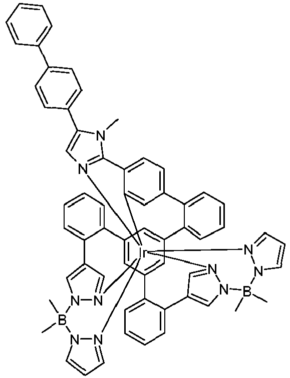 |
| 155 | 156 |
| 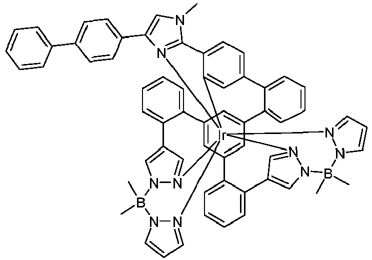 | 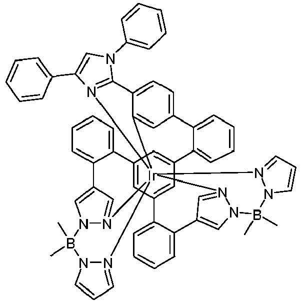 |
| 157 | 158 |
| 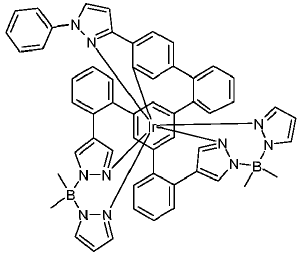 | 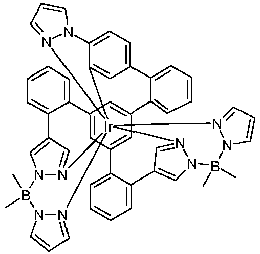 |
| 159 | 160 |
| 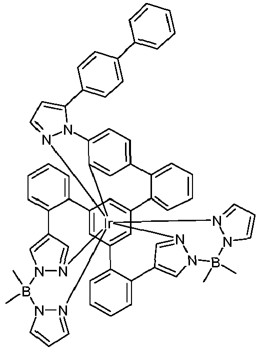 | 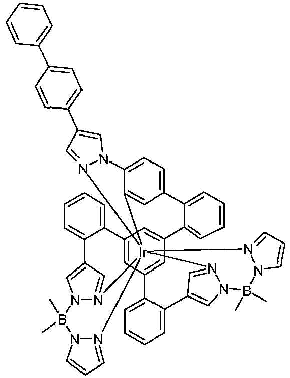 |
| 161 | 162 |
| 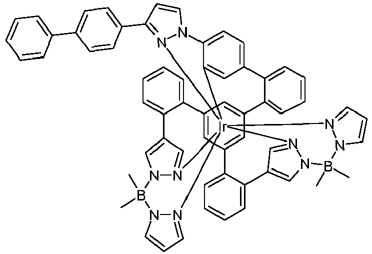 | 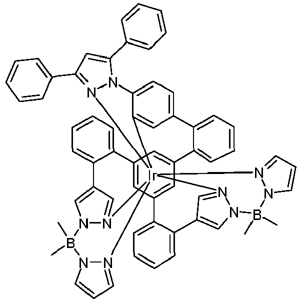 |
| 163 | 164 |
| 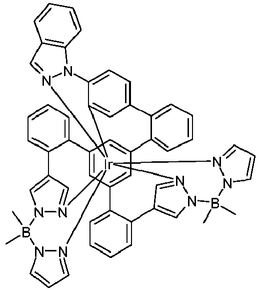 | 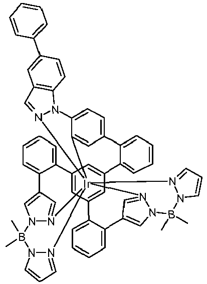 |
| 165 | 166 |
| 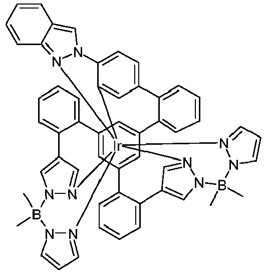 | 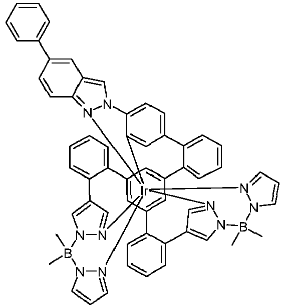 |
| 167 | 168 |
| 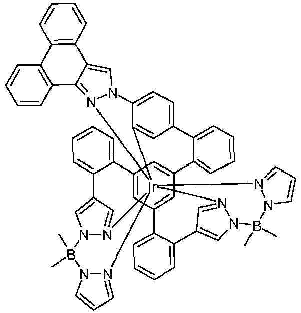 | 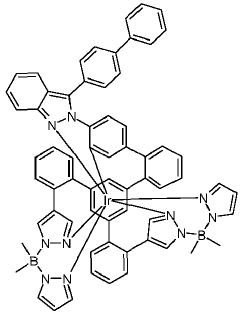 |
| 169 | 170 |
| 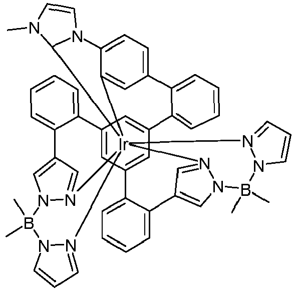 | 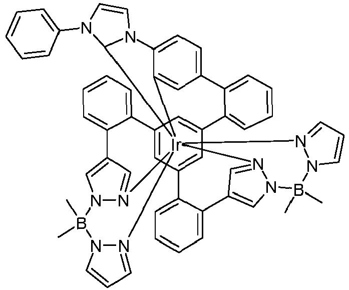 |
| 171 | 172 |
| 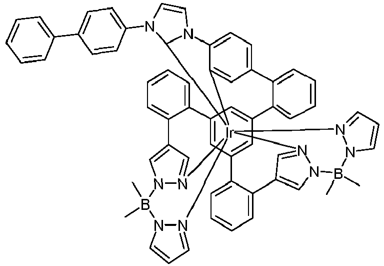 | 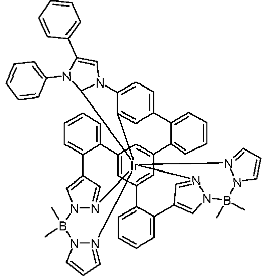 |
| 173 | 174 |
| 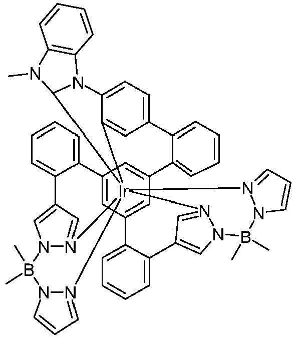 | 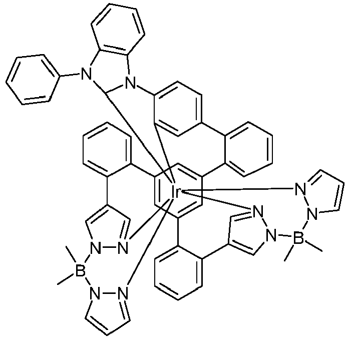 |
| 175 | 176 |
| 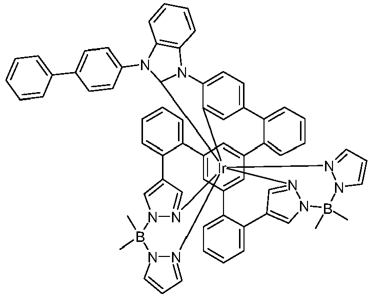 | 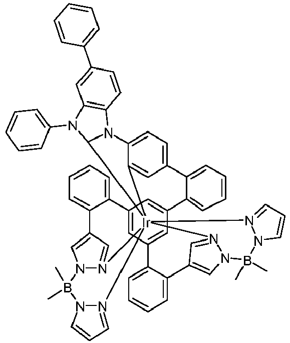 |
| 177 | 178 |
| 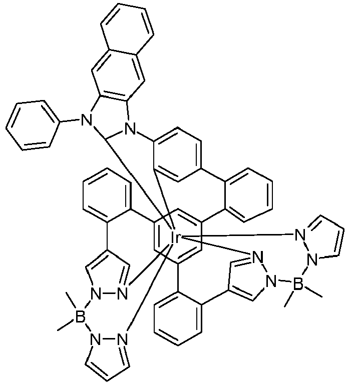 | 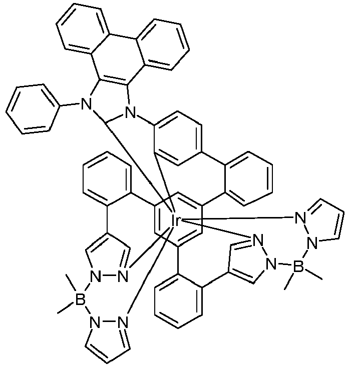 |
| 179 | 180 |
| 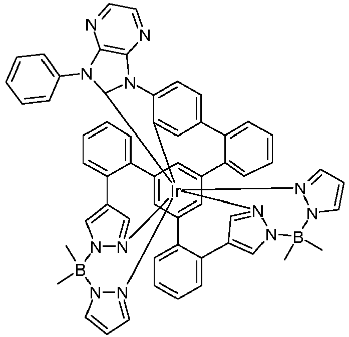 | 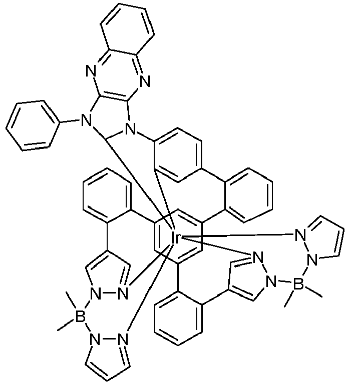 |
| 181 | 182 |
| 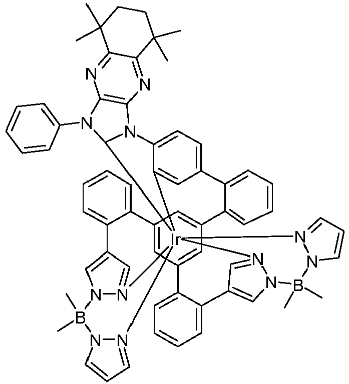 | 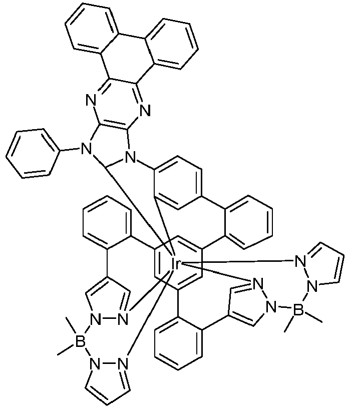 |
| 183 | 184 |
| 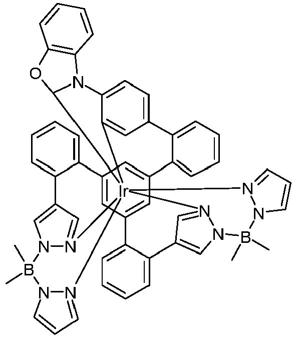 | 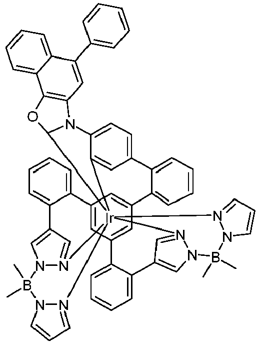 |
| 185 | 186 |
| 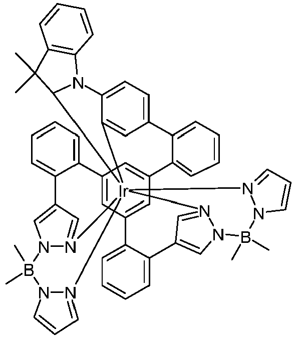 | 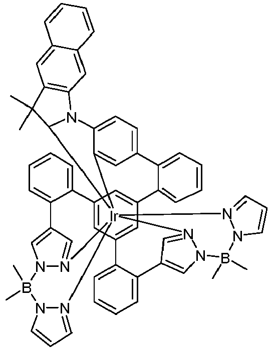 |
| 187 | 188 |

Bei den erfindungsgemäßen Iridiumkomplexen handelt es sich um chirale Strukturen. Wenn zusätzlich auch der tripodale Ligand der Komplexe chiral ist, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate, wie auch die einzelnen isolierten Diastereomere bzw. Enantiomere.

Werden in der Komplexierungsreaktion Cₛ-symmetrische Ligandenvorstufen mit zwei identischen Vorstufen für Teilliganden L¹ oder zwei identischen Teilliganden L² eingesetzt, fällt üblicherweise ein racemisches Gemisch der C₁-symmetrischen Komplexe, also des Δ- und des Λ-Enantiomers, an. Diese können durch gängige Methoden (Chromatographie an chiralen Materialien / Säulen oder Racemattrennung durch Kristallisation) getrennt werden. Dies ist im folgenden Schema am Beispiel einer Cₛ-symmetrischen Ligandenvorstufe, die zwei identische Phenylpyridin-Teilliganden trägt, gezeigt und gilt in analoger Form auch für alle anderen Cₛ-symmetrischen Ligandenvorstufen.

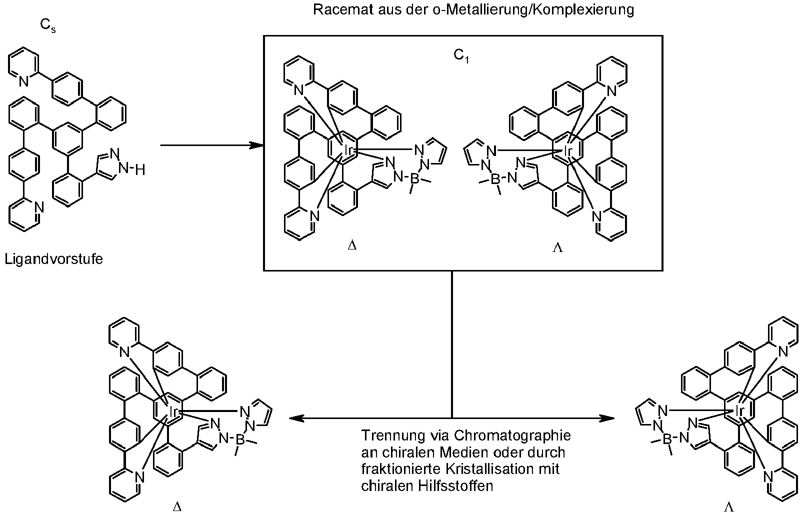

Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie im Folgenden schematisch dargestellt.

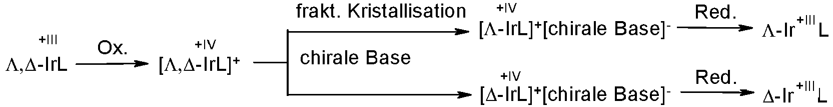

Daneben ist eine enantiomerenreine bzw. enantiomerenanreichernde Synthese durch Komplexierung in einem chiralen Medium (z. B. R- oder S-1,1-Binaphthol) möglich.

Analoge Verfahren können auch mit Komplexen C₁-symmetrischer Ligandenvorstufen durchgeführt werden.

Werden in der Komplexierung C₁-symmetrische Liganden eingesetzt, fällt üblicherweise ein Diastereomerengemisch der Komplexe an, das durch gängige Methoden (Chromatographie, Kristallisation) getrennt werden kann.

Die erfindungsgemäßen Verbindungen sind prinzipiell durch verschiedene Verfahren darstellbar. Generell wird hierzu ein Iridiumsalz mit einer entsprechenden Ligandenvorstufe in Gegenwart eines Halogenfängers, wie z. B. eines Sibersalzes (AgNO₃, Ag₂O, Ag₂CO₃, AgOTf etc.), und in Gegenwart des gewünschten Pyrazolylborat-Synthons, umgesetzt. Geeignete Pyrazolylborat-Synthone können neutral oder anionisch sein. Im Laufe der Reaktion findet neben der o-Metallierungsreaktion eine Koordinationsreaktion und der templatgesteuerte Aufbau der Bis-pyrazolylborato-Teilliganden statt.

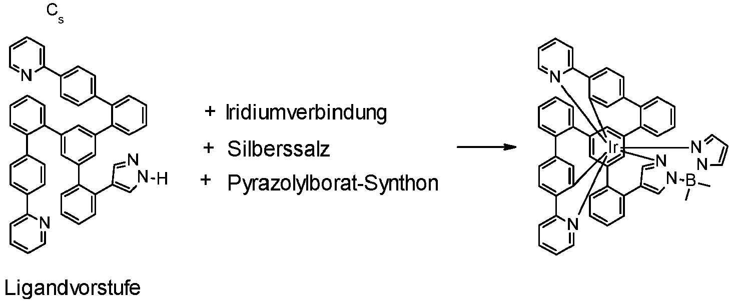

Daher ist ein weiterer Gegenstand der vorliegenden Erfindung ein Verfahren zur Herstellung der erfindungsgemäßen Verbindungen durch Umsetzung der entsprechenden Ligandenvorstufe mit einem Pyrazolylborat-Synthon und mit Iridiumalkoholaten der Formel (54), mit Iridiumketoketonaten der Formel (55), mit Iridiumhalogeniden der Formel (56), sowie deren Tris-acetonitril-, Tris-benzonitril- oder Tris-tetrahydrothiophen-Adukte, oder mit Iridiumcarboxylaten der Formel (57), 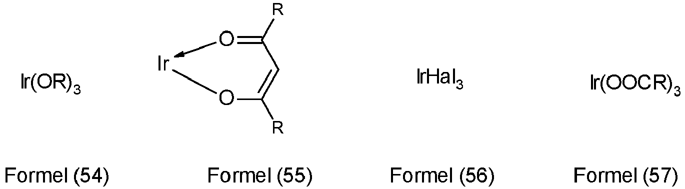 wobei R die oben angegebenen Bedeutungen hat, Hal = F, Cl, Br oder I ist und die Iridiumedukte auch als die entsprechenden Hydrate vorliegen können. Dabei steht R bevorzugt für eine Alkylgruppe mit 1 bis 4 C-Atomen.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Gegebenenfalls können weitere Additive wie Säuren oder Basen zugesetzt werden.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (45) bis (51) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Iridiumkomplexe aus flüssiger Phase, beispielsweise durch Spin-Coating oder durch Druckverfahren, sind Formulierungen der erfindungsgemäßen Iridiumkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäßen Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die erfindungsgemäße Verbindung kann in der elektronischen Vorrichtung als aktive Komponente, bevorzugt als Emitter in der emissiven Schicht oder als Loch- oder Elektronentransportmaterial in einer loch- bzw. elektronentransportierenden Schicht, oder als Sauerstoff-Sensibilisatoren oder als Photoinitiator oder Photokatalysator verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder als Photoinitiator oder Photokatalysator. Enantiomerenreine erfindungsgemäße Iridiumkomplexe eignen sich als Photokatalysatoren für chirale photoinduzierte Synthesen.

Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Iridiumkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens eine erfindungsgemäße Verbindung. Verbindungen, die im Infraroten emittieren, eignen sich für den Einsatz in organischen Infrarot-Elektrolumineszenzvorrichtungen und InfrarotSensoren. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃, oder mit (per)fluorierten elektronenarmen Aromaten oder mit elektronenarmen Cyano-substituieren Heteroaromaten (z. B. gemäß JP 4747558, JP 2006-135145, US 2006/0289882, WO 2012/095143), oder mit chinoiden Systemen (z. B. gemäß EP1336208) oder mit LewisSäuren, oder mit Boranen (z. B. gemäß US 2003/0006411, WO 2002/051850, WO 2015/049030) oder mit Carboxylaten der Elemente der 3. , 4. oder 5. Hauptgruppe (WO 2015/018539) und/oder dass eine oder mehrere Elektronentransportschichten n-dotiert sind.

Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern und/oder Ladungen erzeugen (Charge-Generation-Layer, z. B. in Schichtsystemen mit mehreren emittierenden Schichten, z. B. in weiß emittierenden OLED-Bauteilen) . Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Eine bevorzugte Ausführungsform sind Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Iridiumkomplex als emittierende Verbindung in einer oder mehreren emittierenden Schichten.

Wenn der erfindungsgemäße Iridiumkomplex als emittierende Verbindung in einer emittierenden Schicht eingesetzt wird, wird er bevorzugt in Kombination mit einem oder mehreren Matrixmaterialien eingesetzt.

Wenn die organische Elektrolumineszenzvorrichtung durch Vakuumaufdampfung hergestellt wird, enthält die Mischung aus dem erfindungsgemäßen Iridiumkomplex und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% des erfindungsgemäßen Iridiumkomplexes bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Wenn die organische Elektrolumineszenzvorrichtung aus Lösung hergestellt wird, enthält die Mischung aus dem erfindungsgemäßen Iridiumkomplex und dem Matrixmaterial zwischen 0.1 und 99 Gew.-%, vorzugsweise zwischen 1 und 90 Gew..-%, besonders bevorzugt zwischen 3 und 30 Gew.-%, insbesondere zwischen 3 und 20 Gew.-% des erfindungsgemäßen Iridiumkomplexes bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 70 Vol.-%, insbesondere zwischen 97 und 80 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Biscarbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877. Für lösungsprozessierte OLEDs eignen sich als Matrixmaterialien auch Polymere, z. B. gemäß WO 2012/008550 oder WO 2012/048778, Oligomere oder Dendrimere, z. B. gemäß Journal of Luminescence 183 (2017), 150-158.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial (so genannter "wide bandgap host"), welches nicht bzw. nicht in wesentlichem Maße am Ladungstransport beteiligt ist, wie z. B. in WO 2010/108579 oder WO 2016/184540 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Nachfolgend sind Beispiele für Verbindungen abgebildet, die sich als Matrixmaterialien für die erfindungsgemäßen Verbindungen eignen.

Beispiele für Triazine und Pyrimidine, welche als elektronentransportierende Matrixmaterialien eingesetzt werden können, sind die folgenden Strukturen:

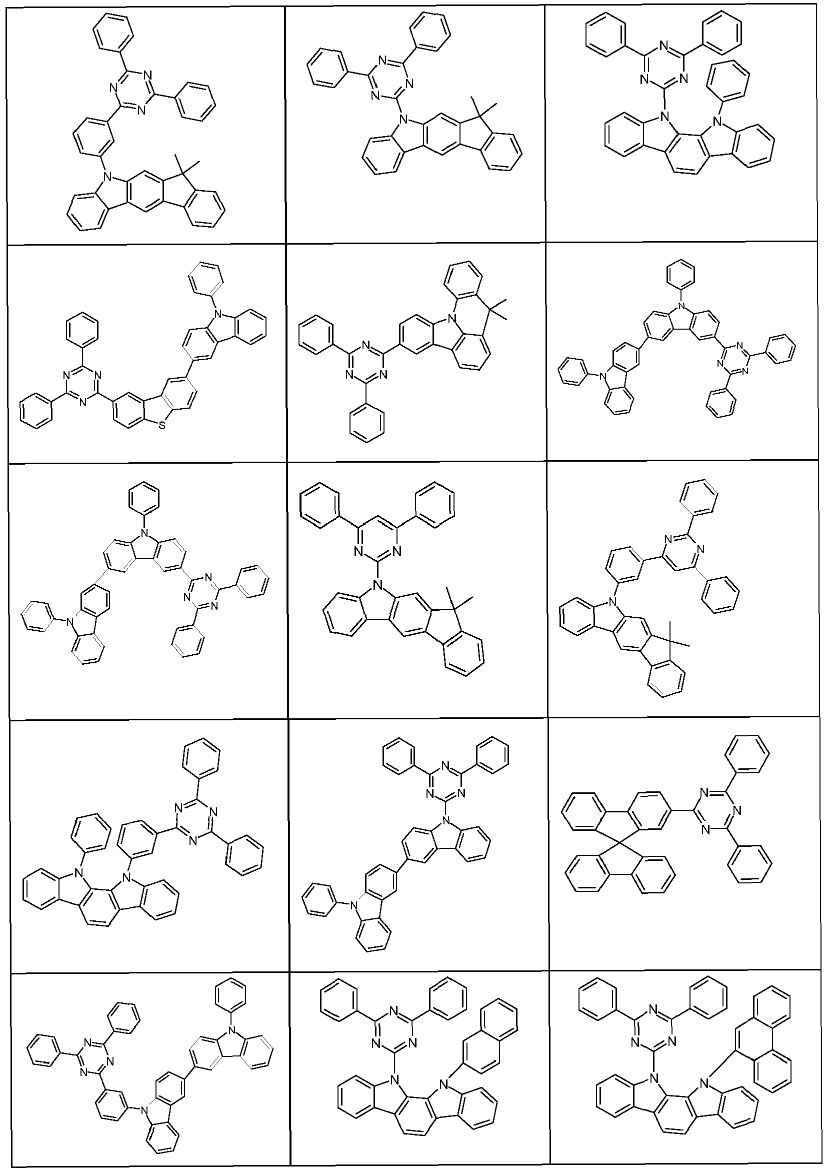

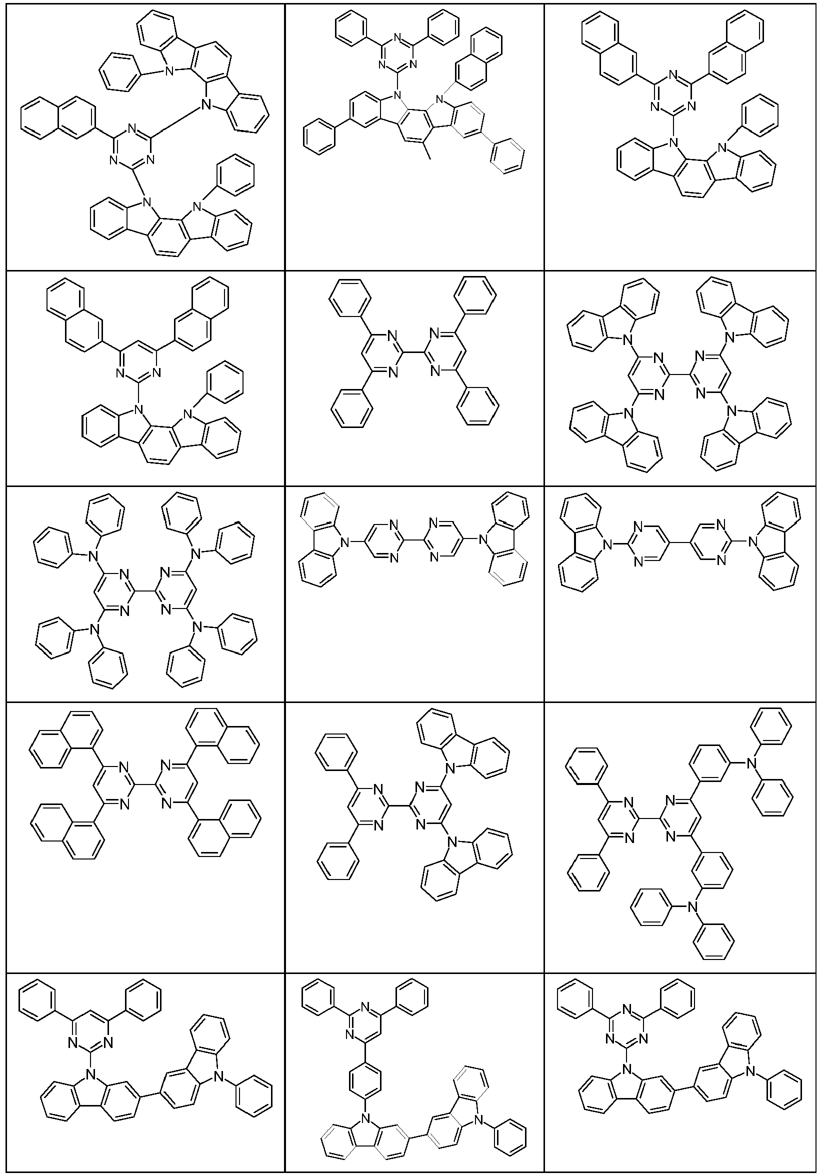

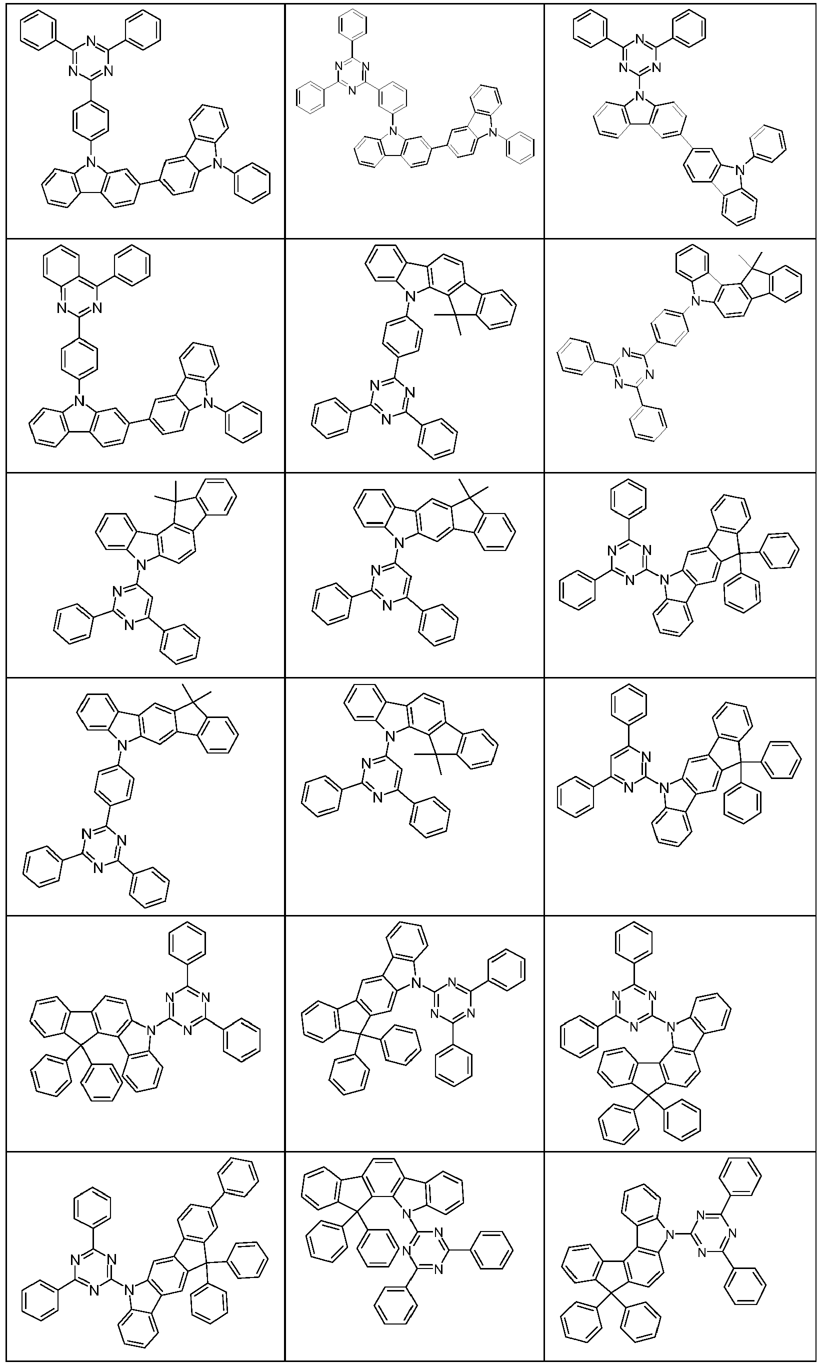

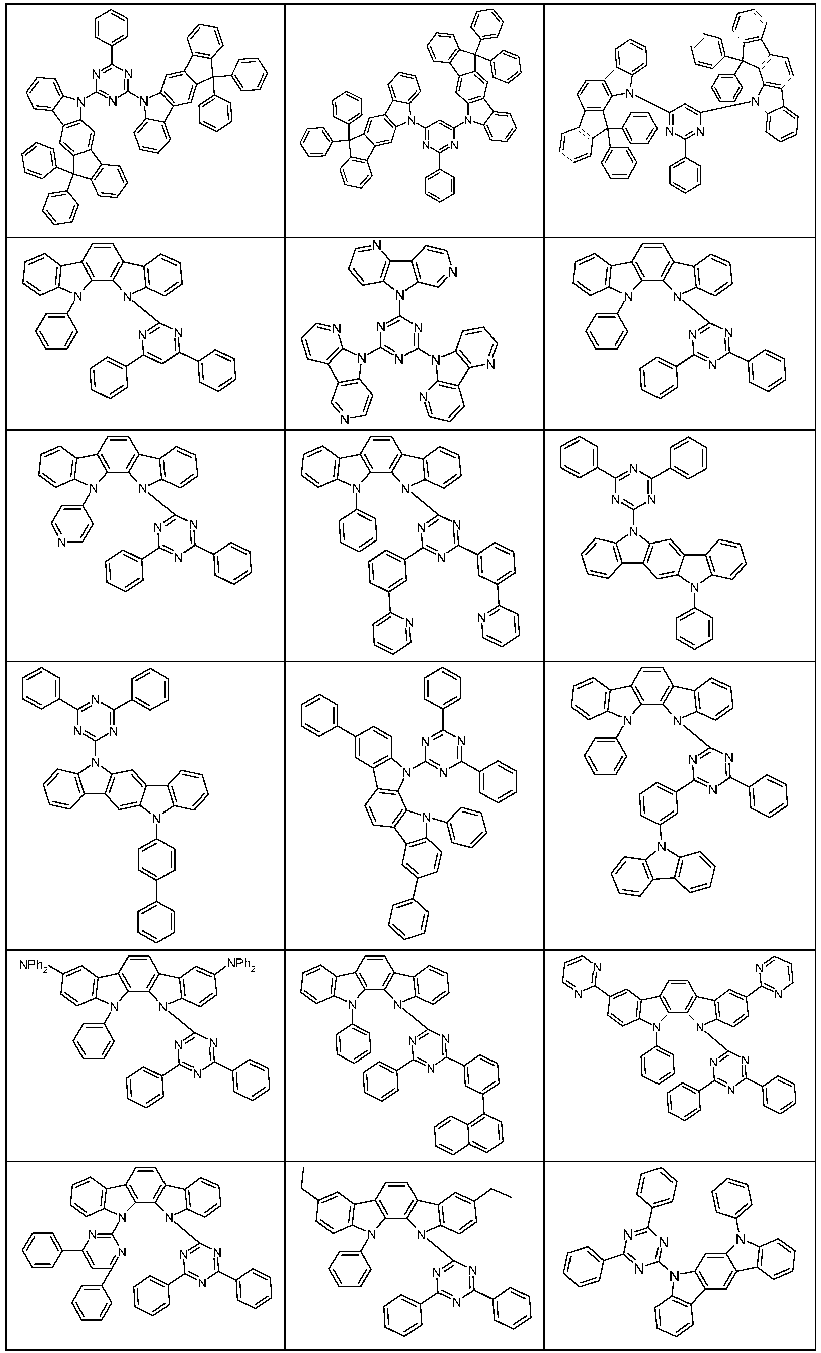

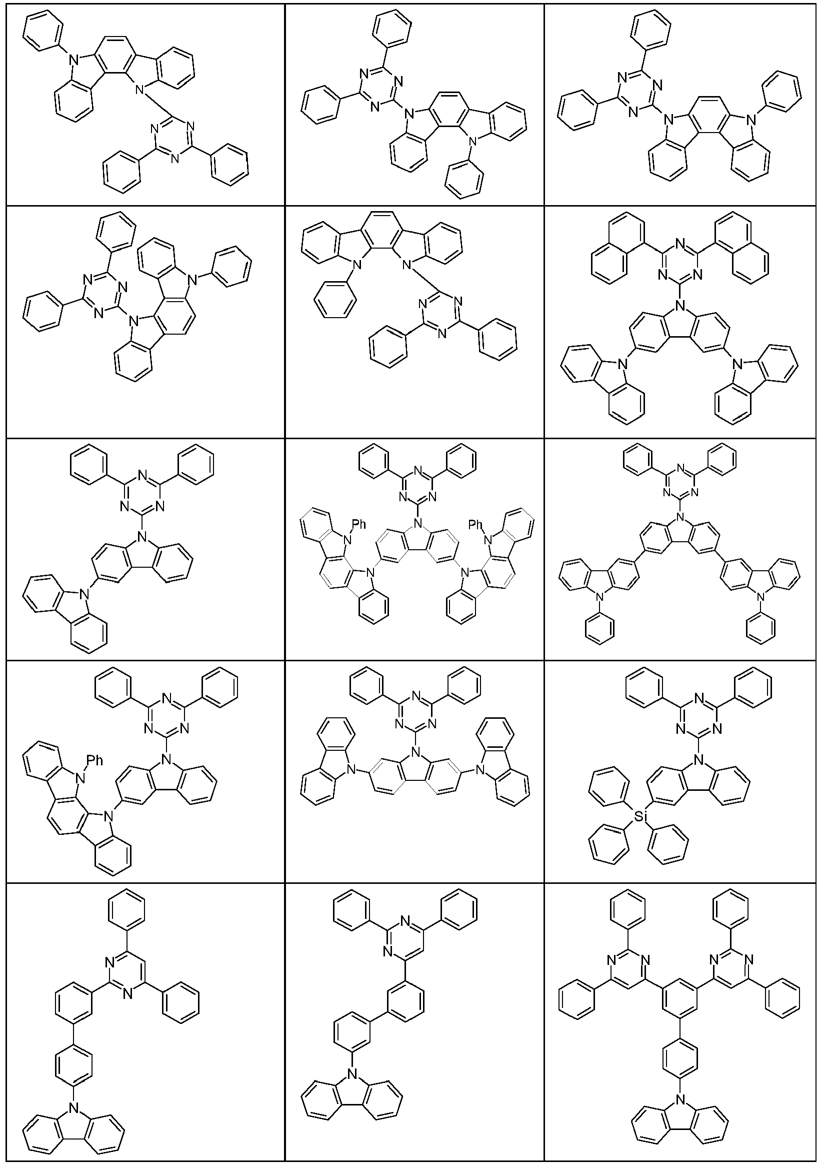

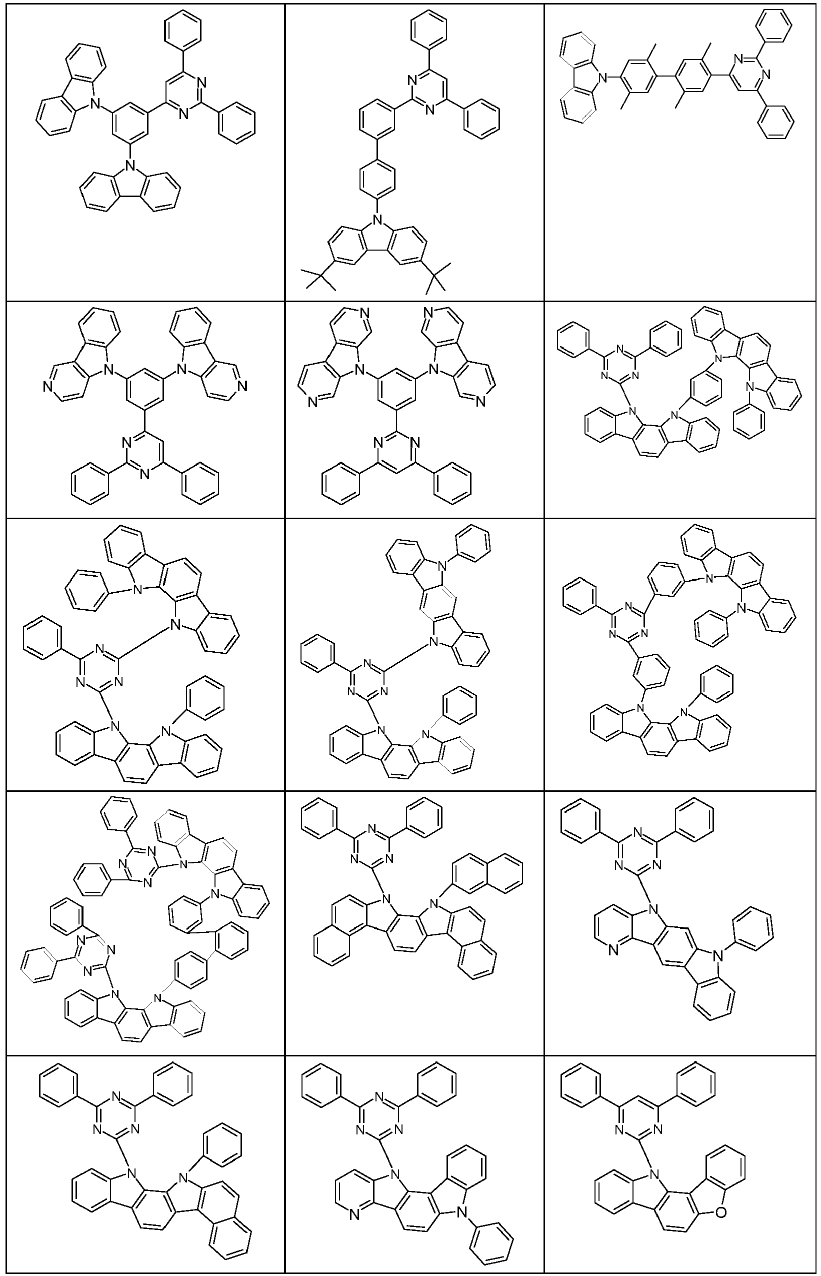

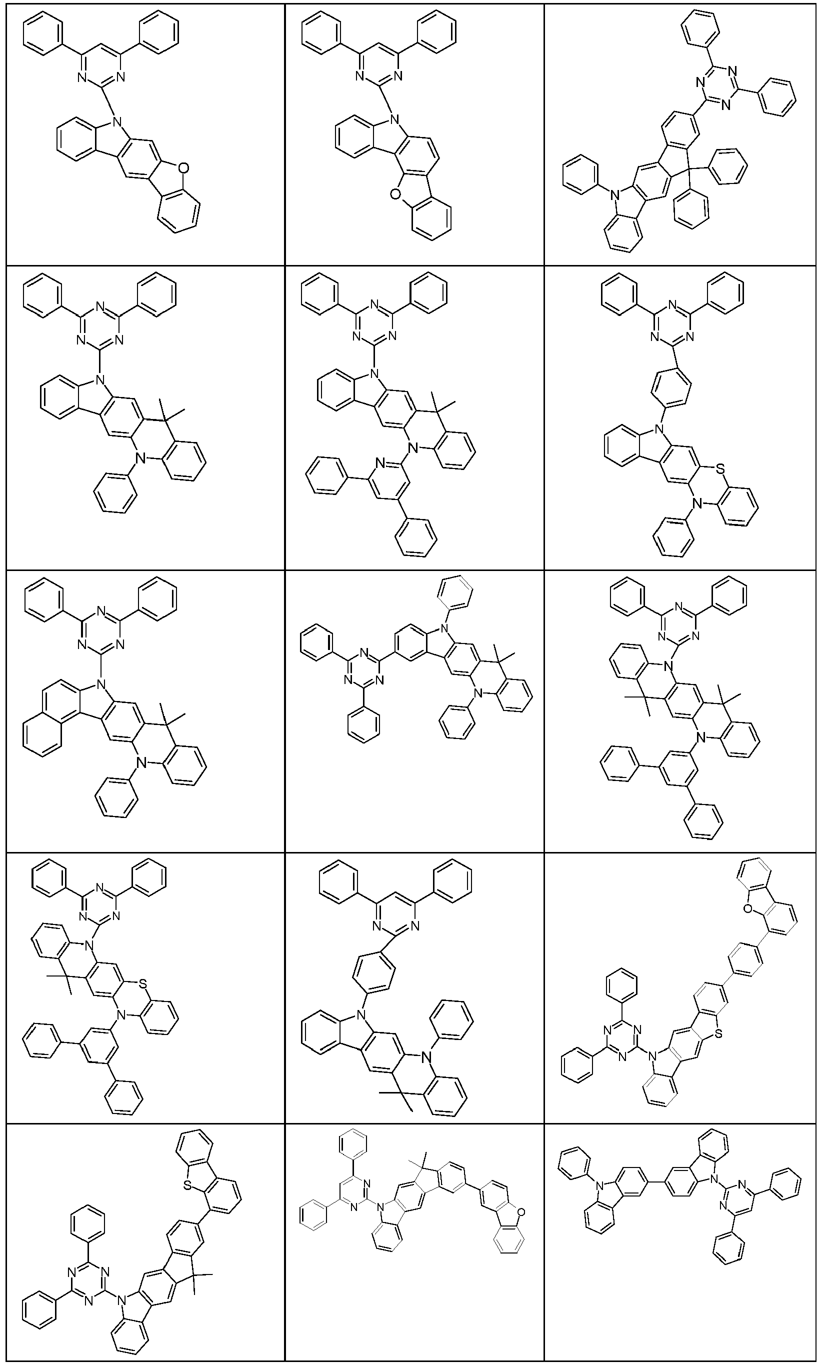

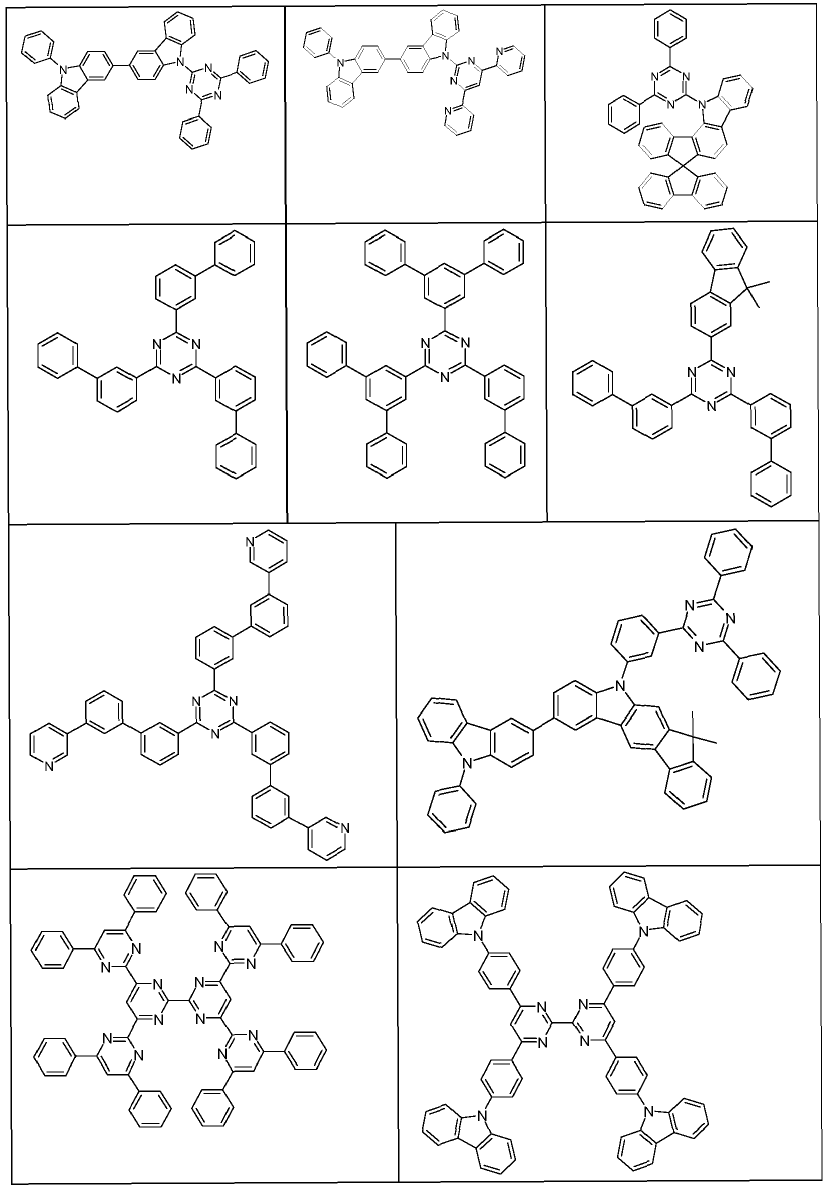

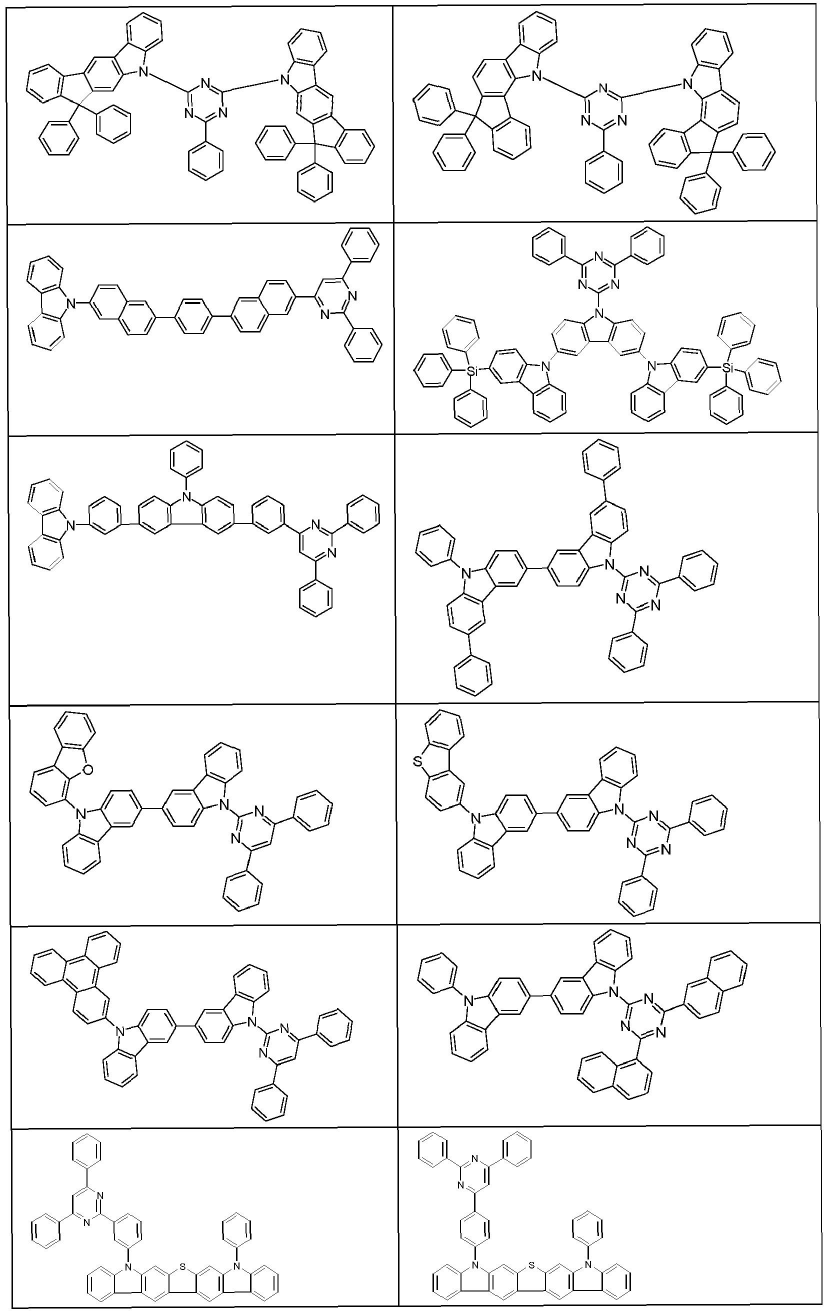

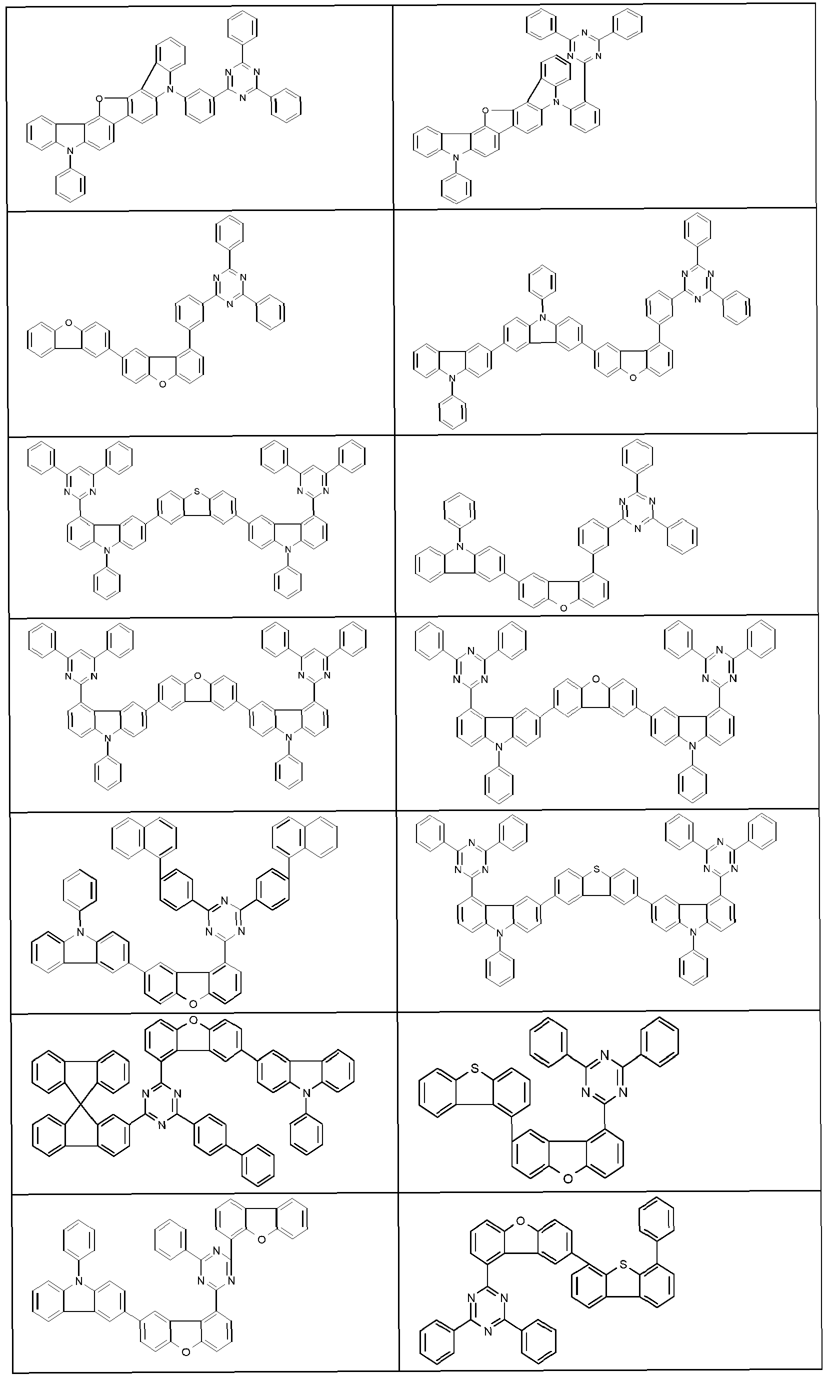

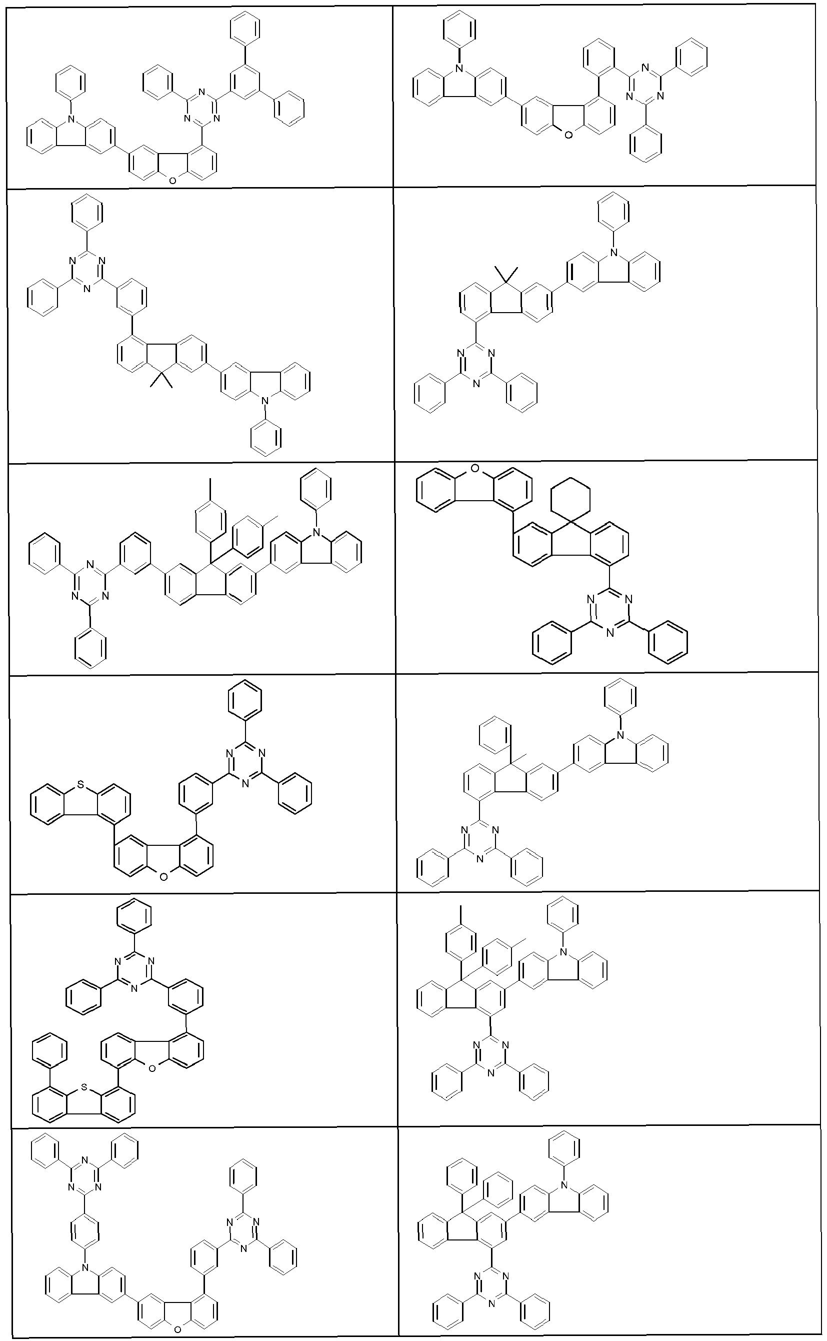

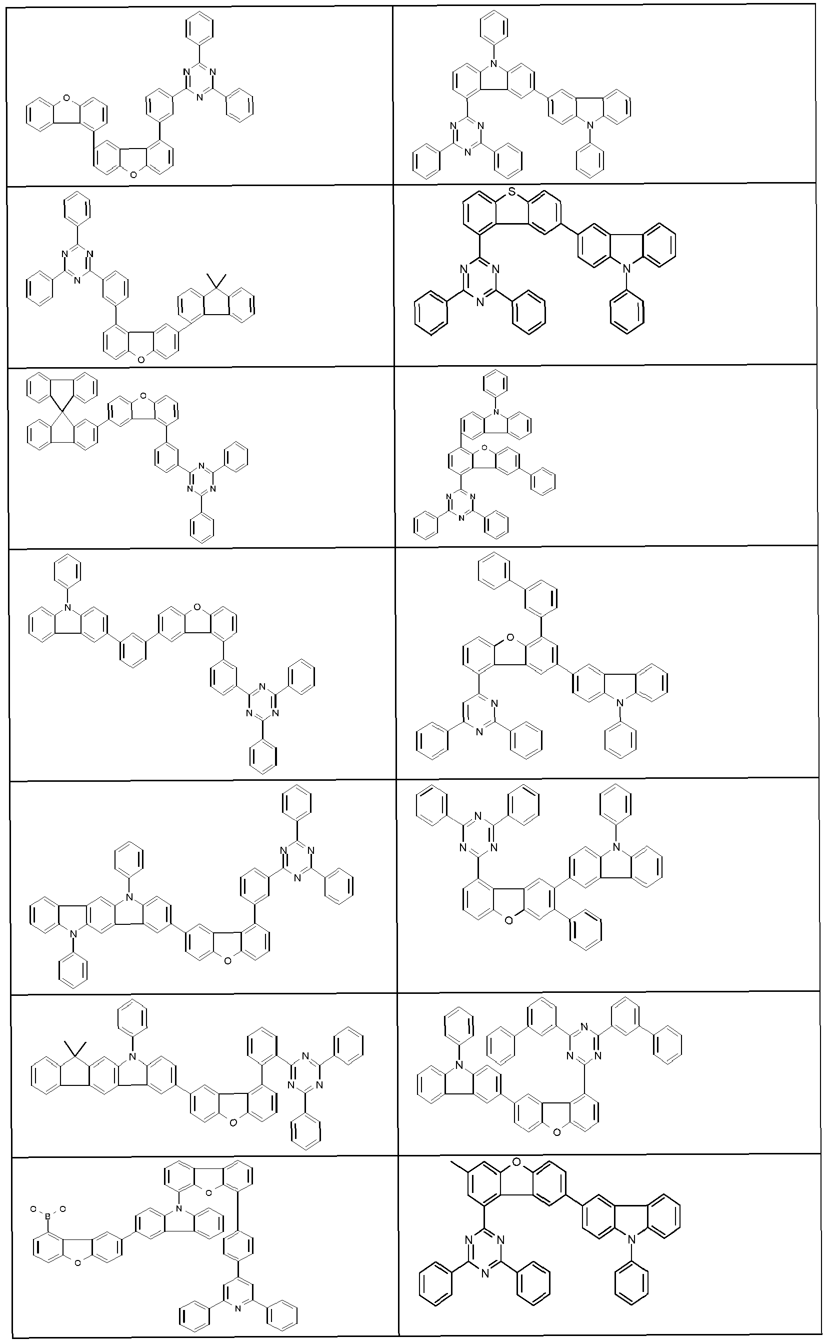

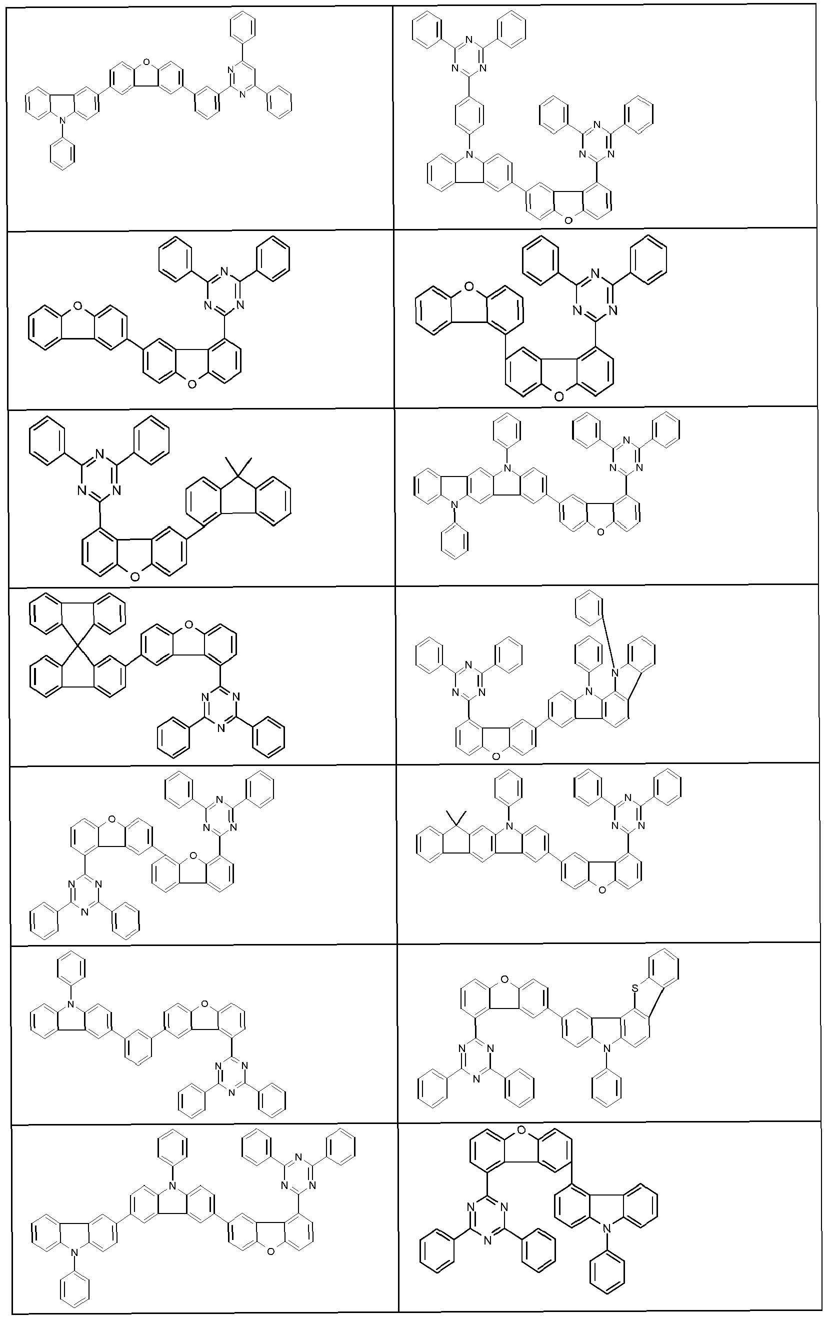

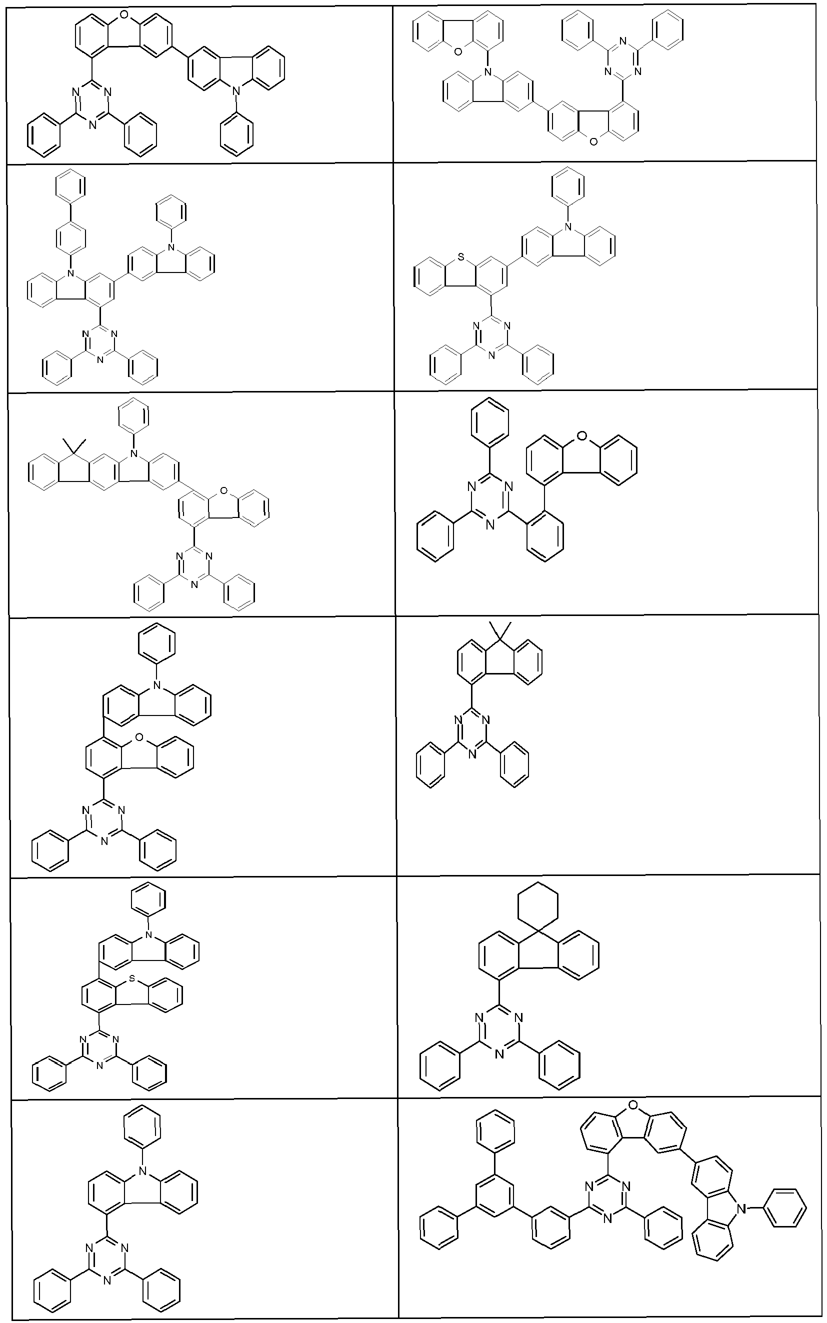

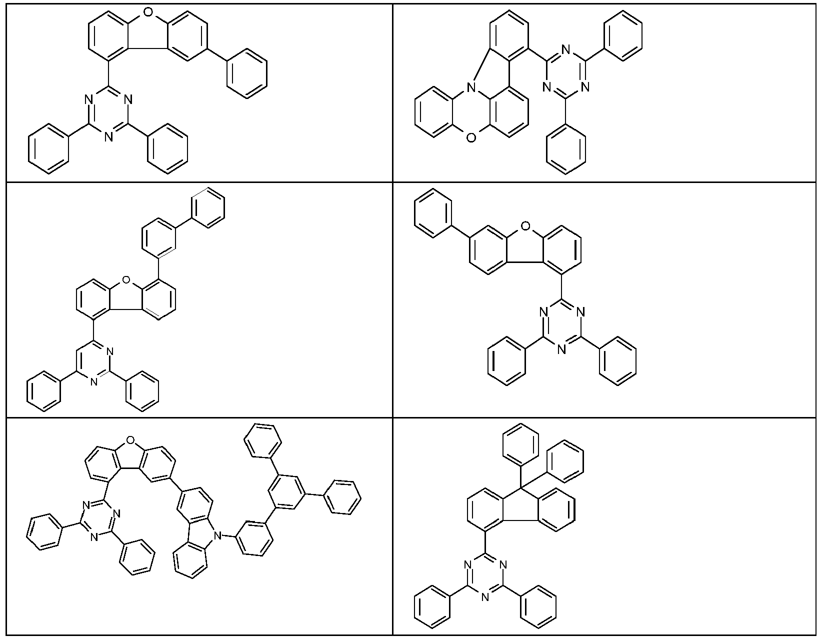

Beispiele für Lactame, welche als elektronentransportierende Matrixmaterialien eingesetzt werden können sind die folgenden Strukturen:

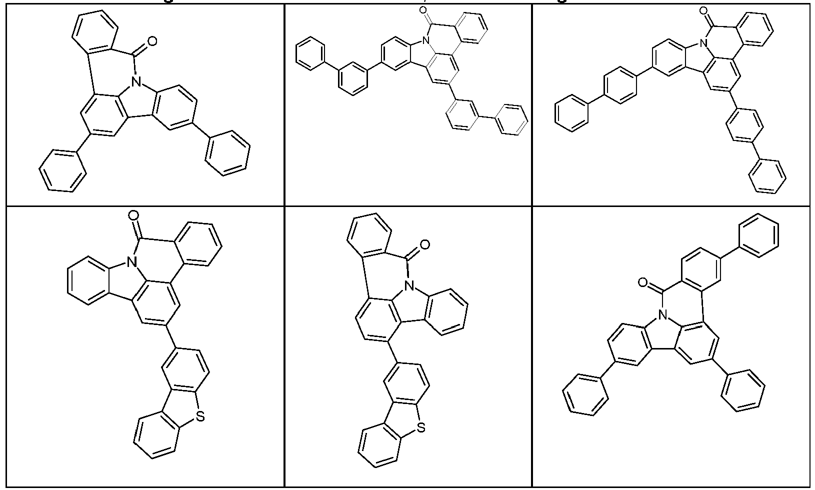

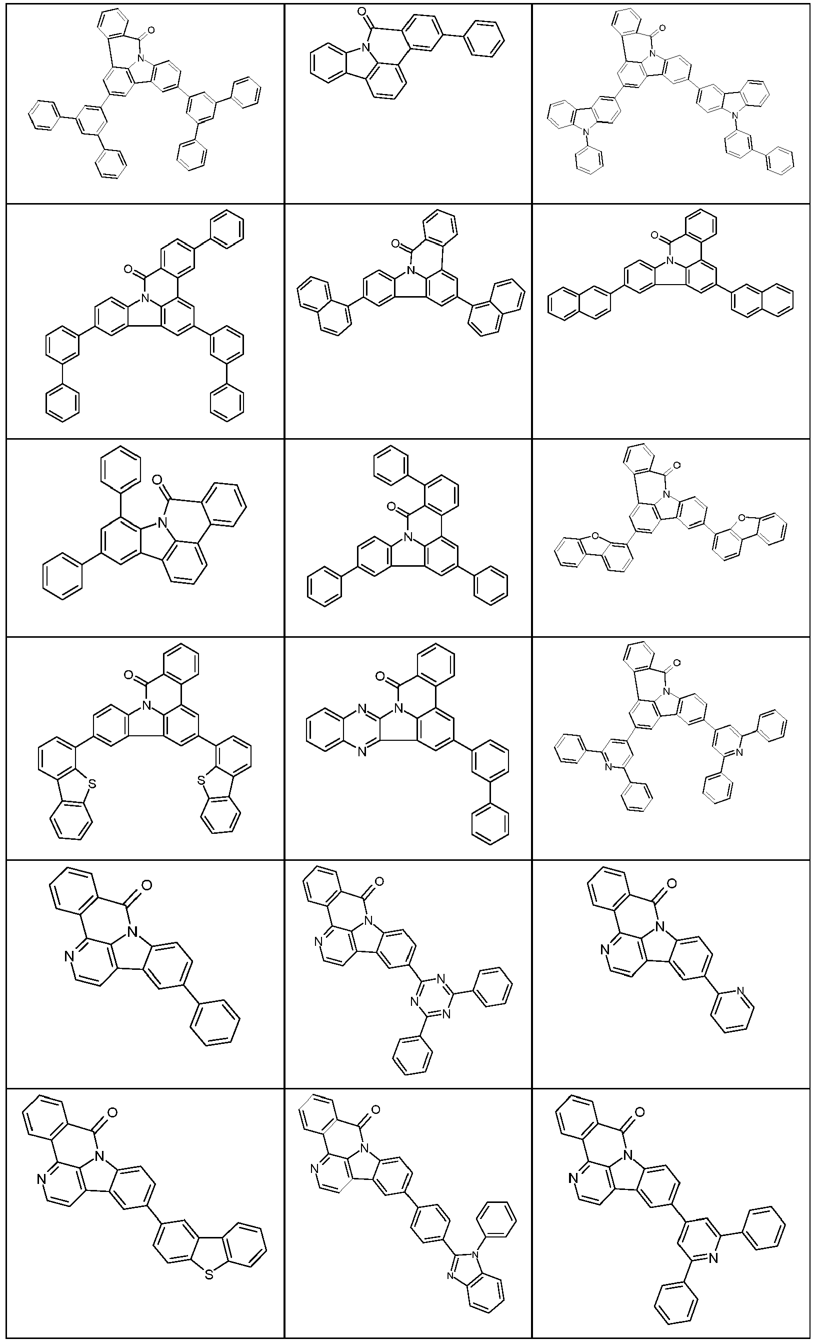

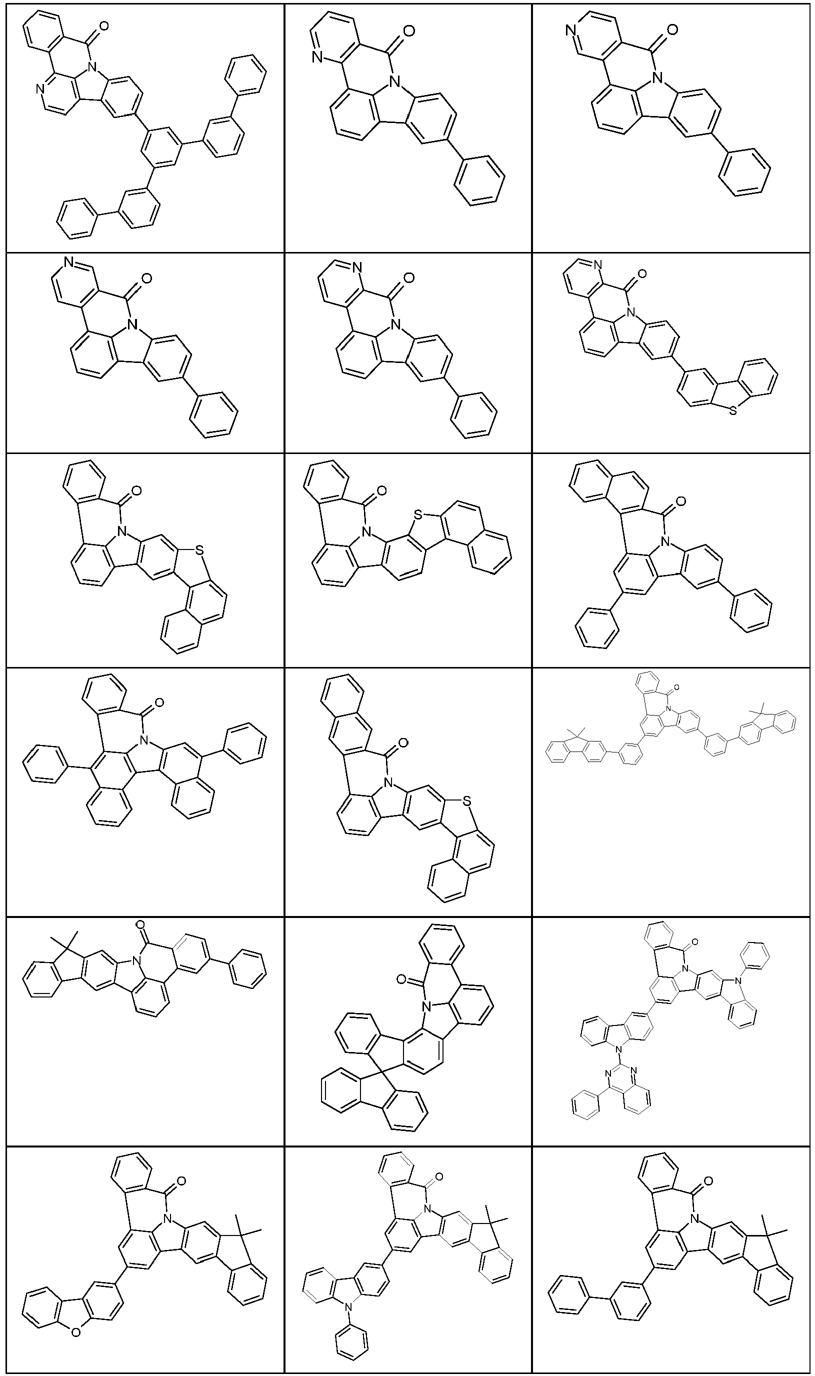

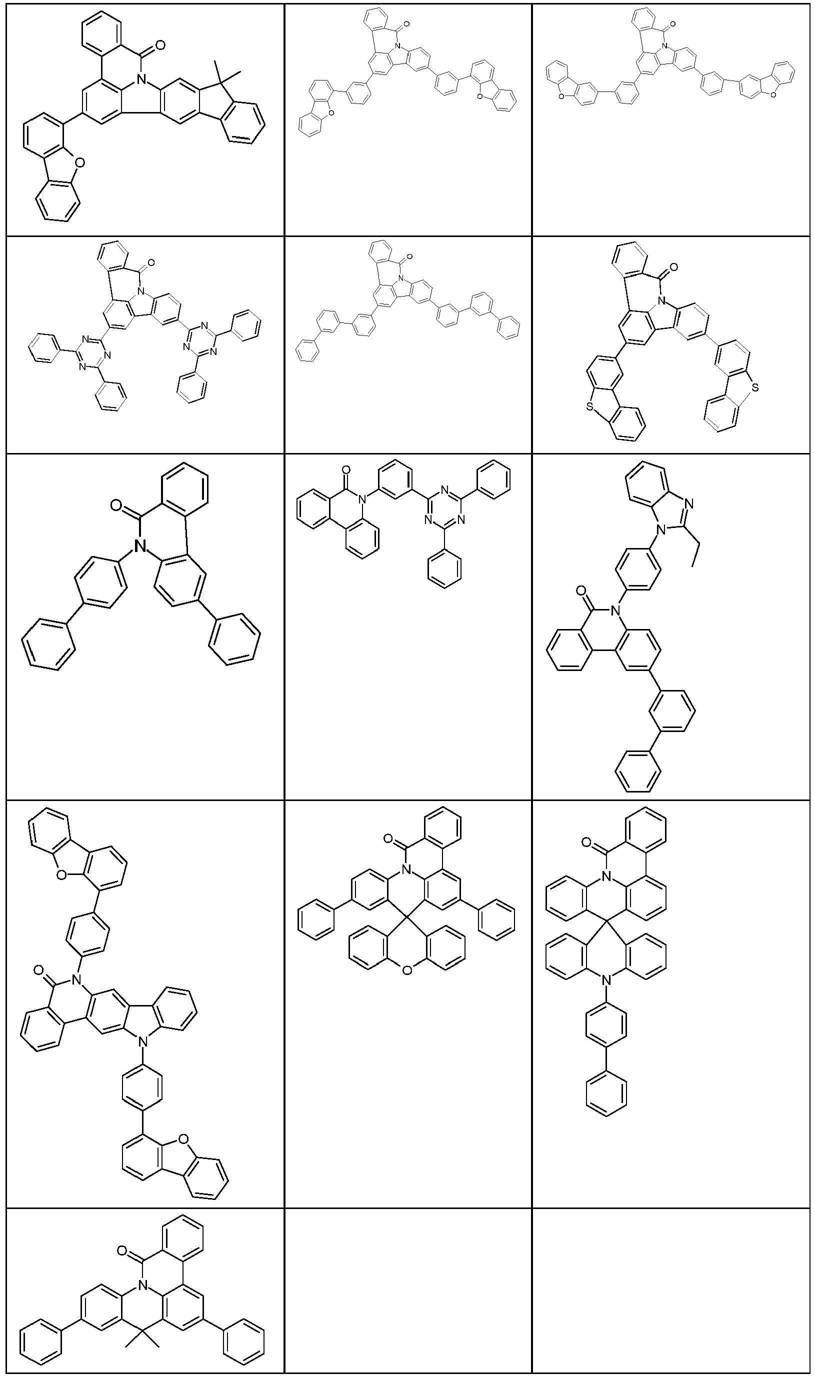

Beispiele für Indolo- und Indenocarbazolderivate im weitesten Sinn, welche je nach Substitutionsmuster als loch- oder elektronentransportierende Matrixmaterialien eingesetzt werden können, sind die folgenden Strukturen:

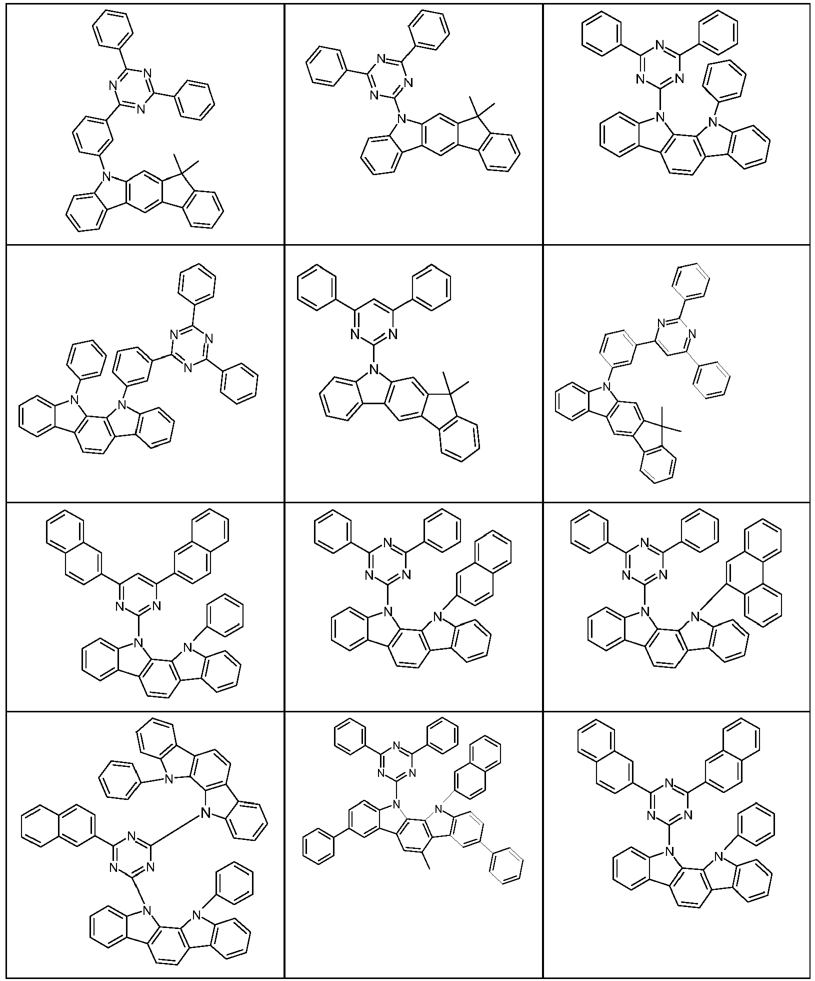

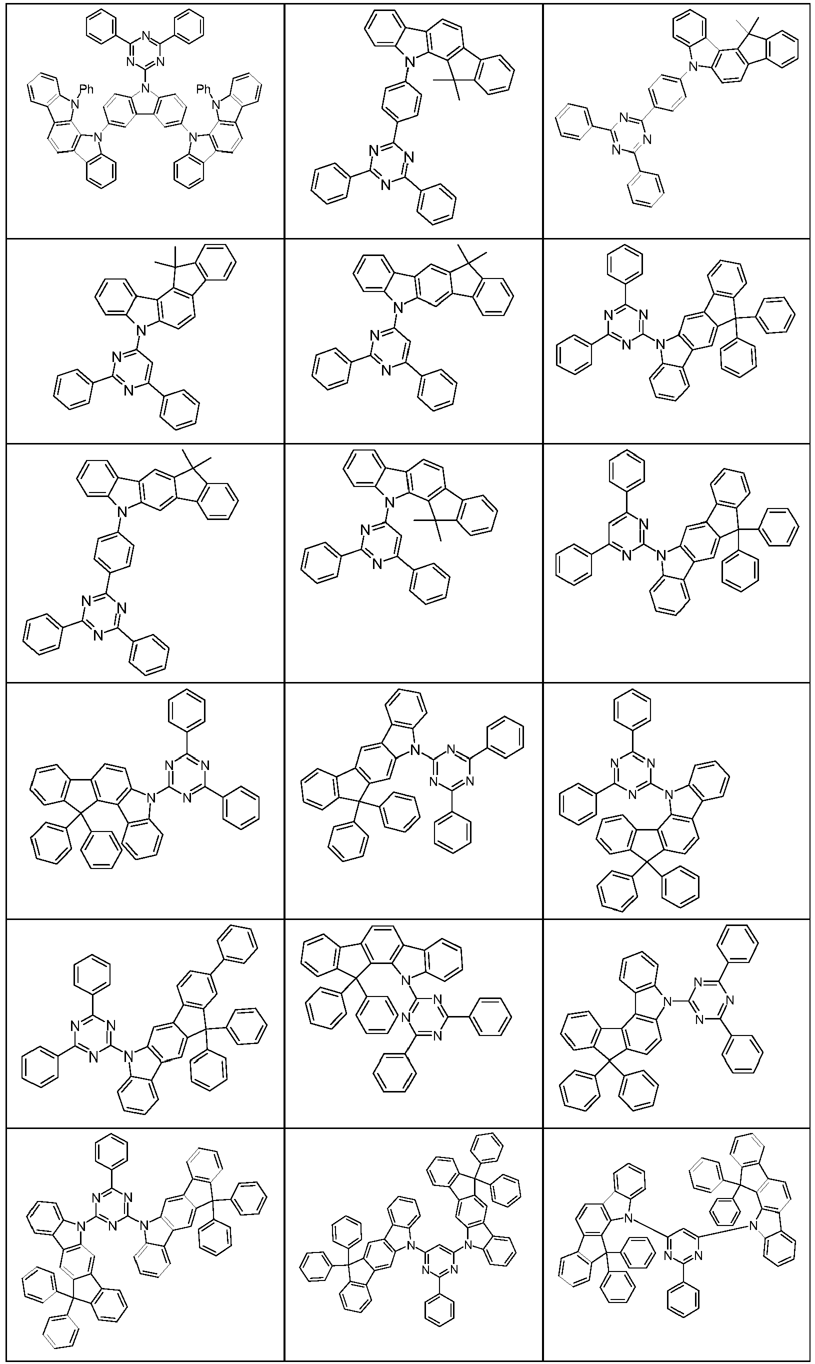

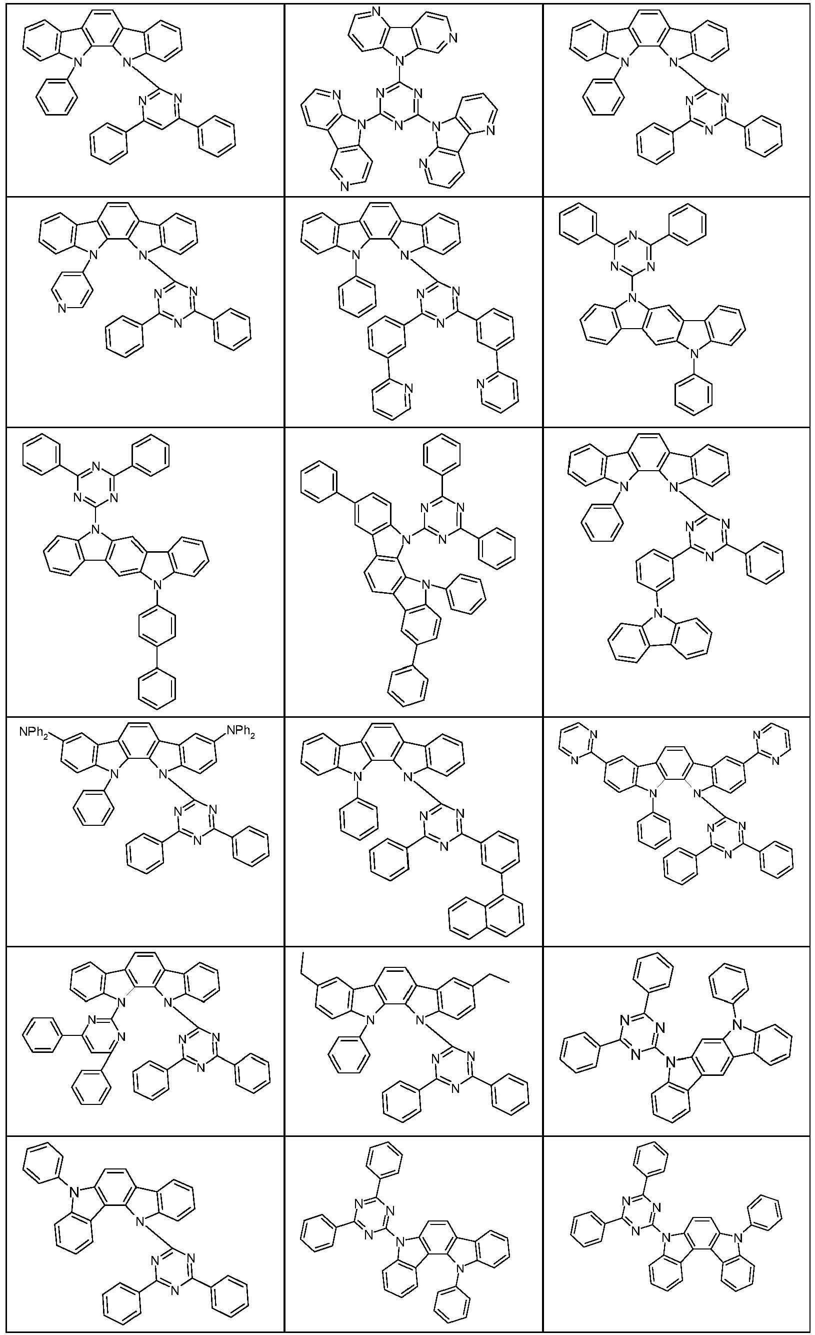

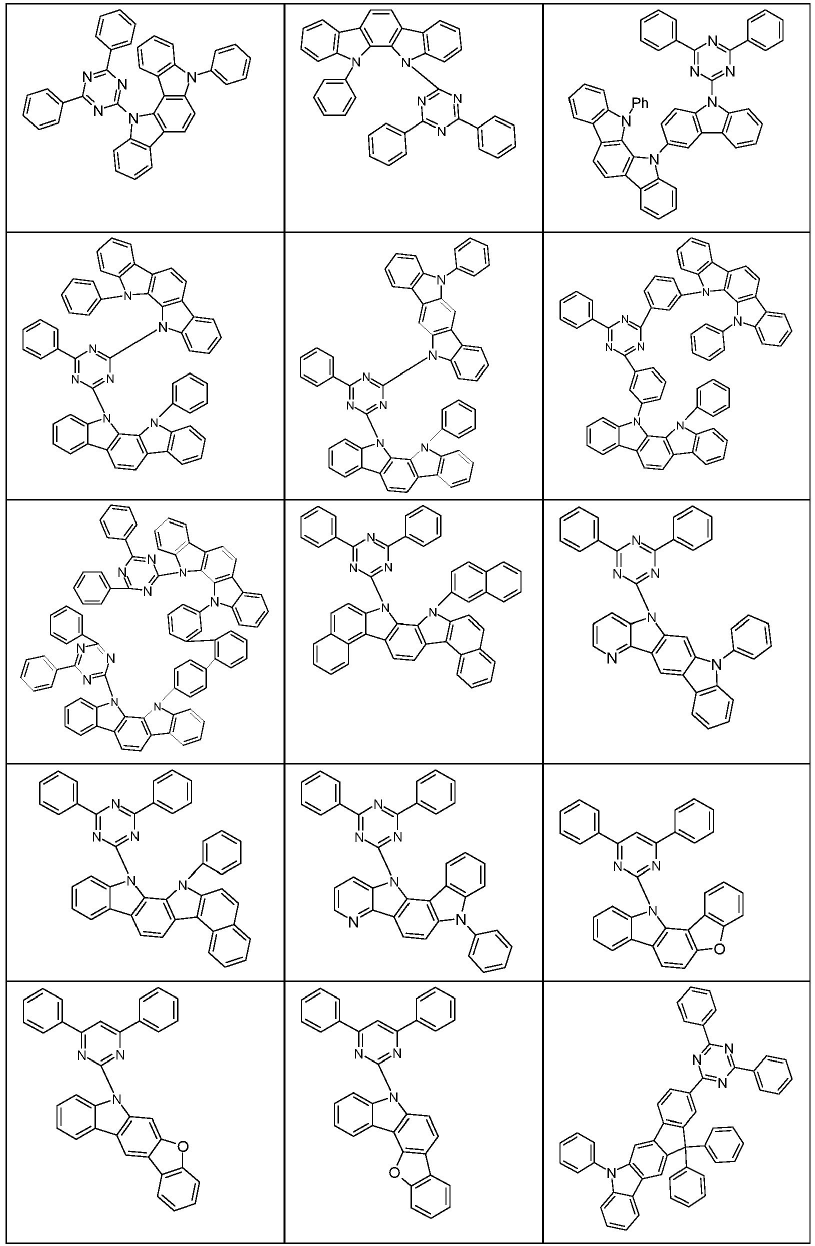

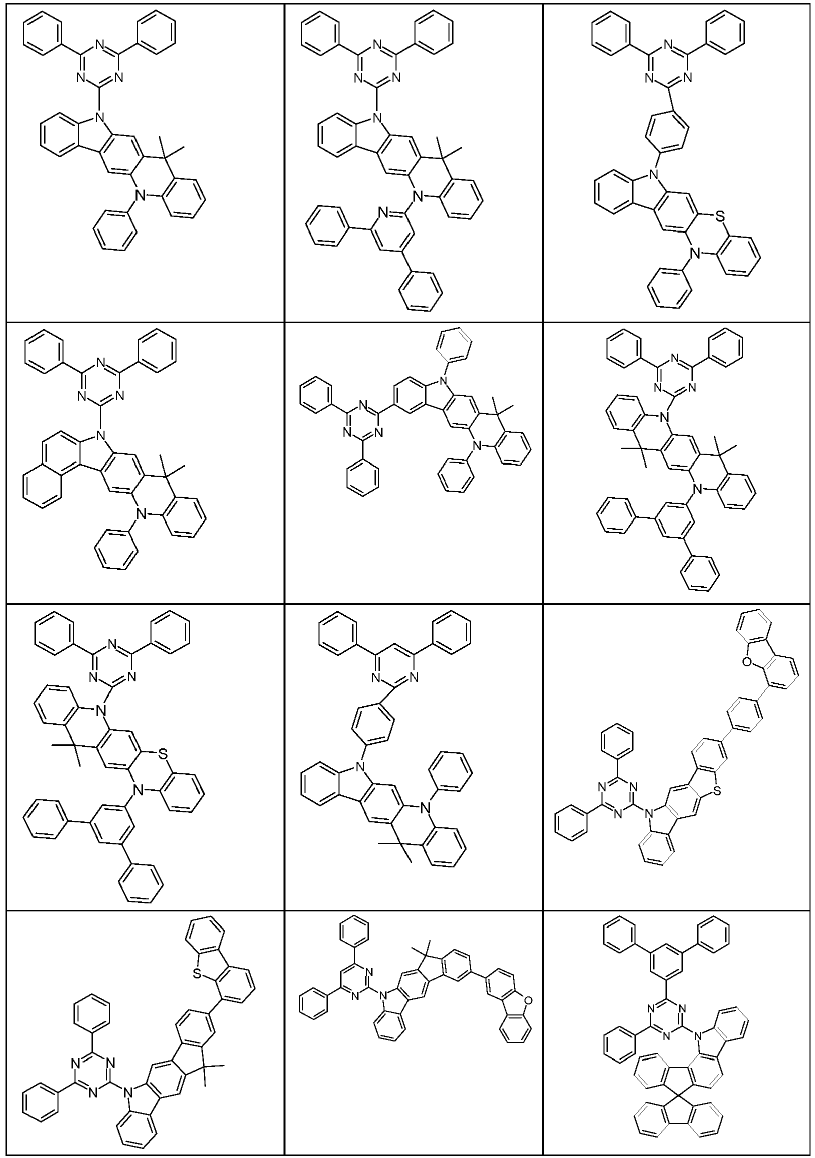

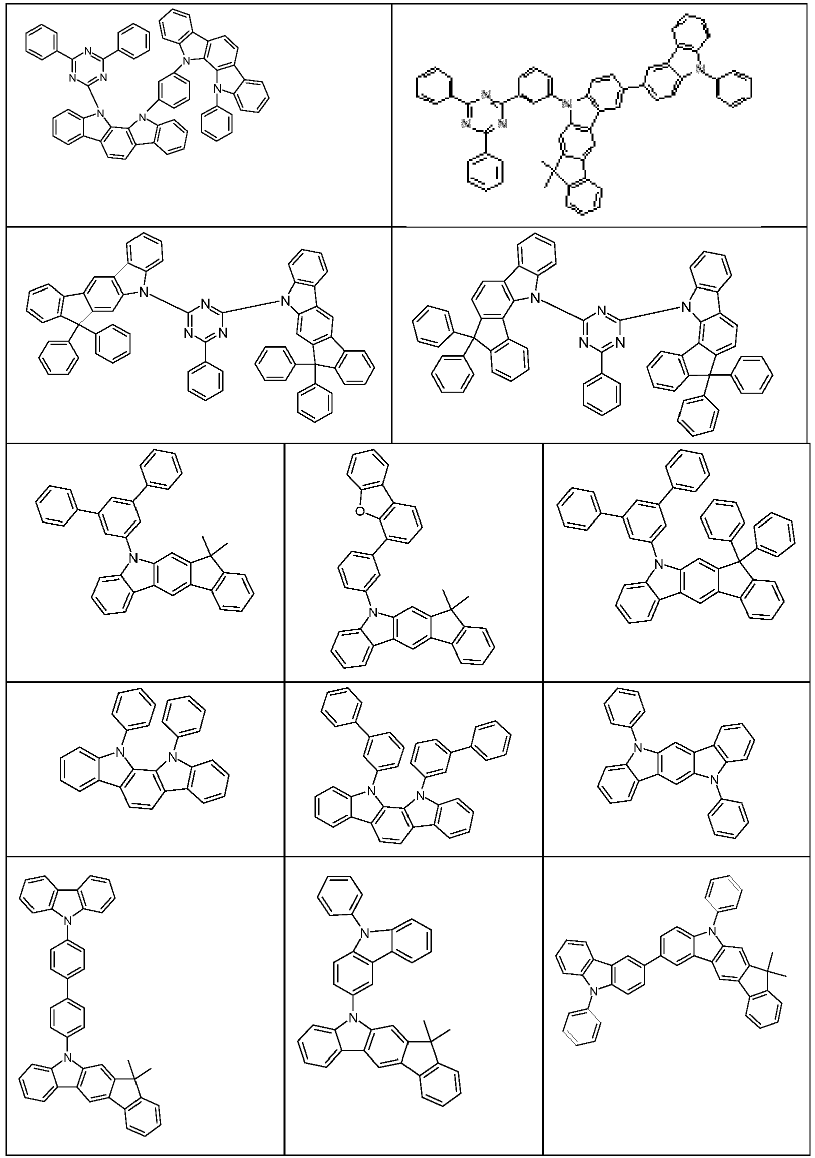

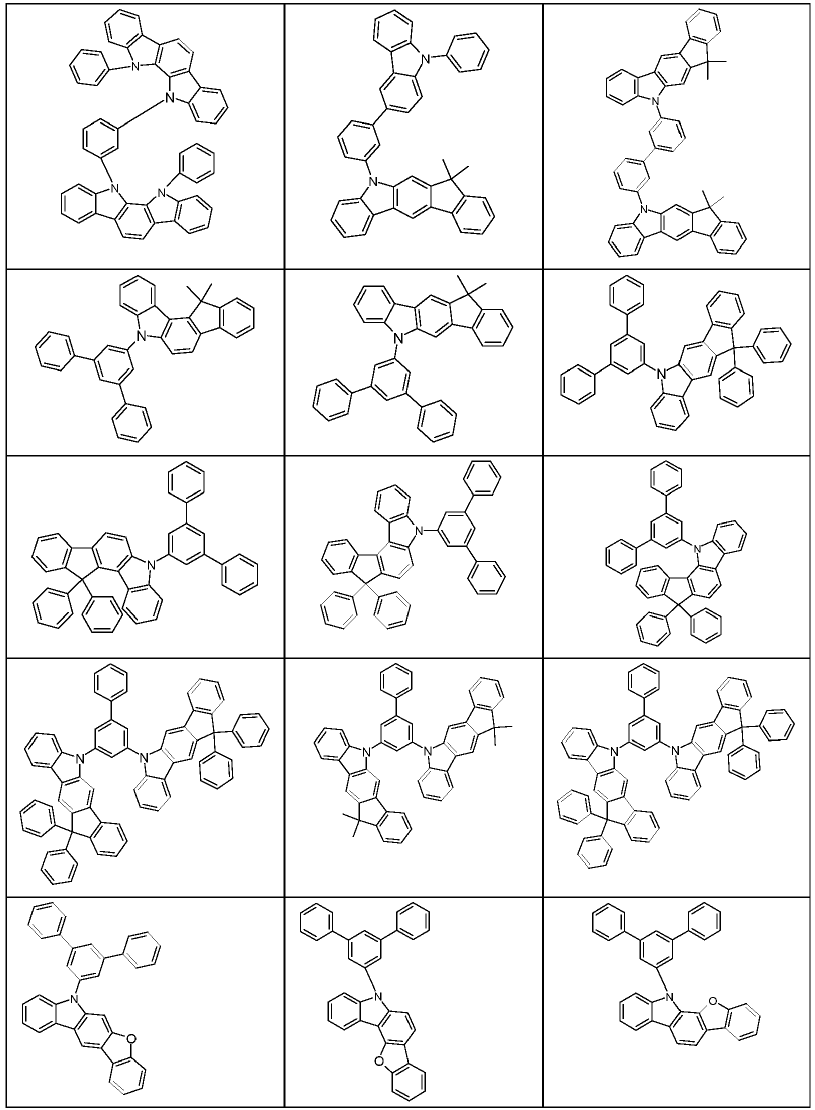

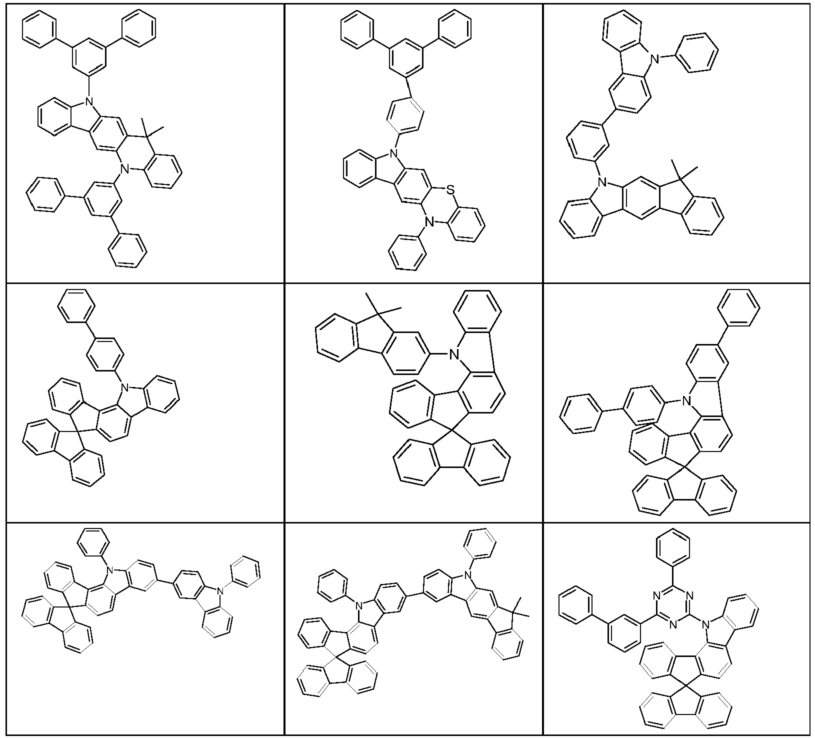

Beispiele für Carbazolderivate, welche je nach Substitutionsmuster als loch- oder elektronentransportierende Matrixmaterialien eingesetzt werden können sind die folgenden Strukturen:

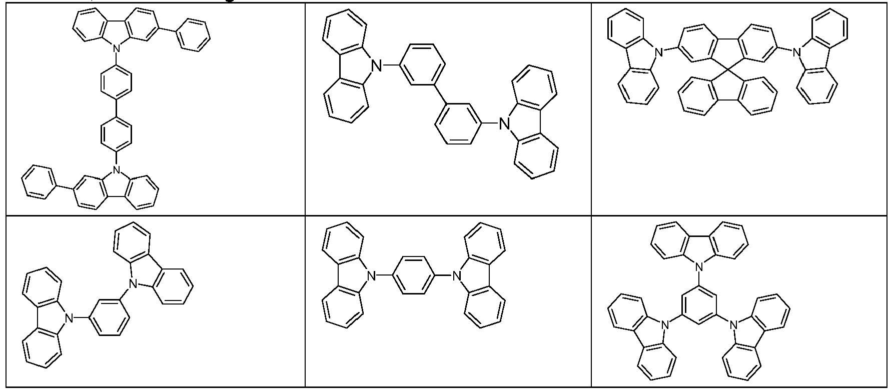

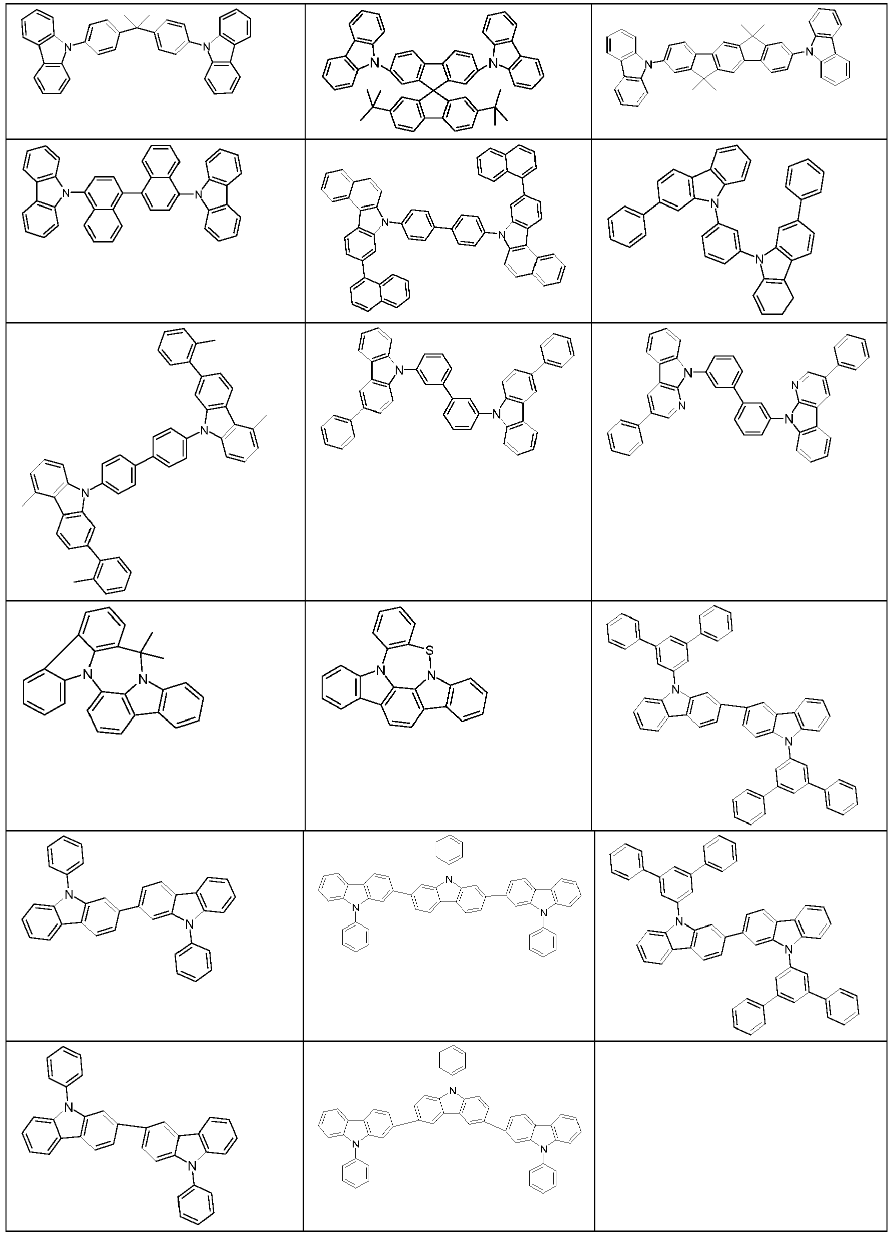

Beispiele für verbrückte Carbazolderivate, welche als lochtransportierende Matrixmaterialien eingesetzt werden können, sind die folgenden Strukturen:

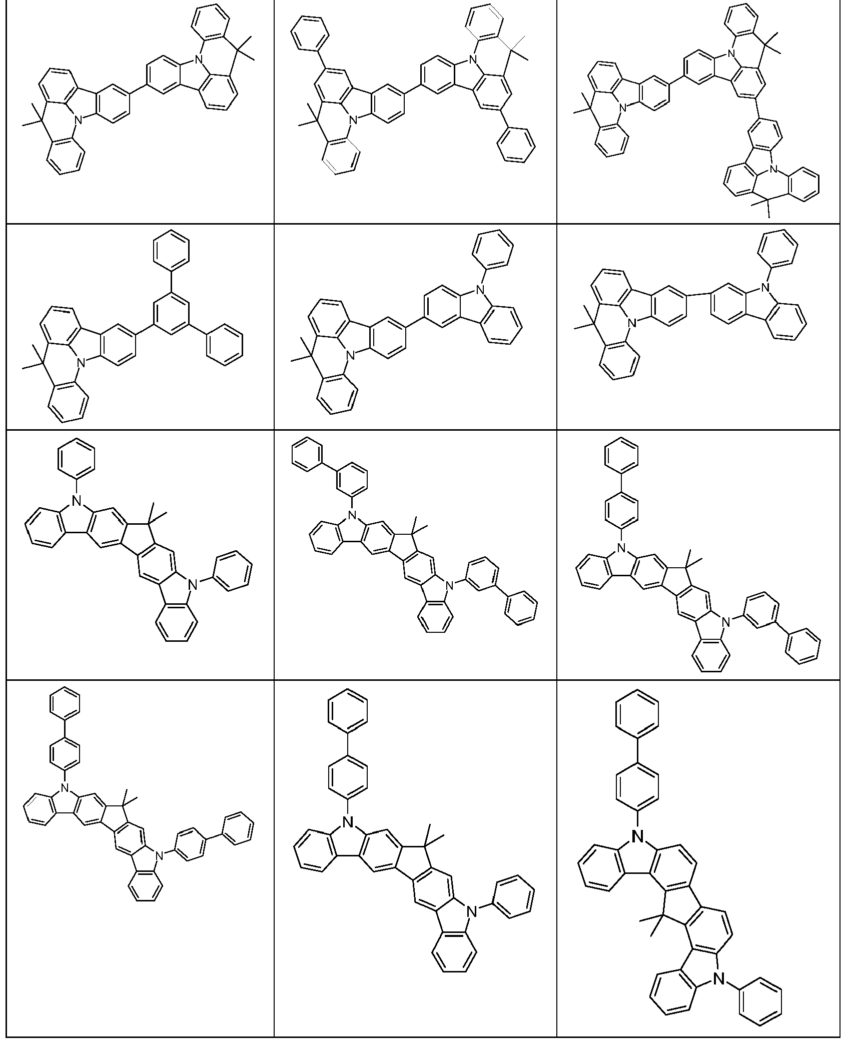

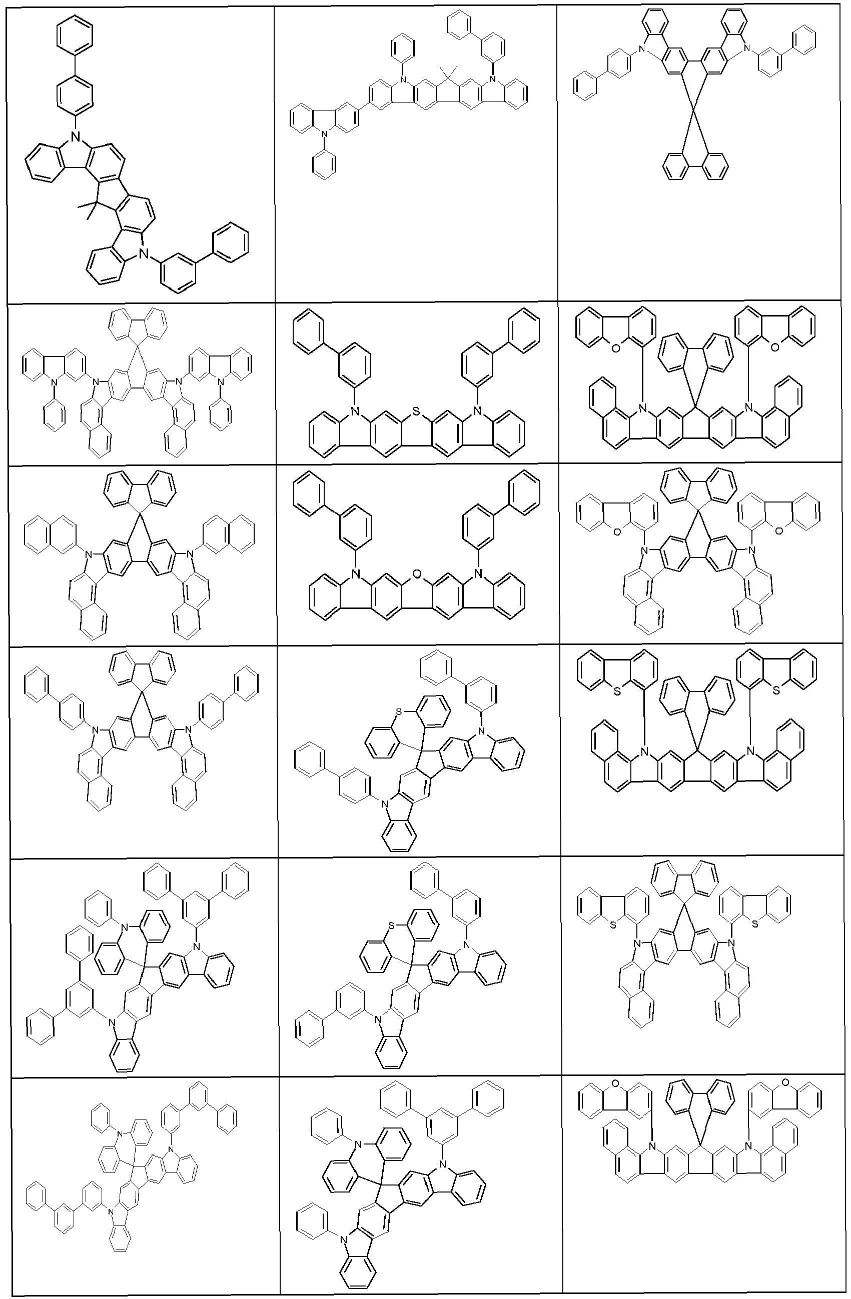

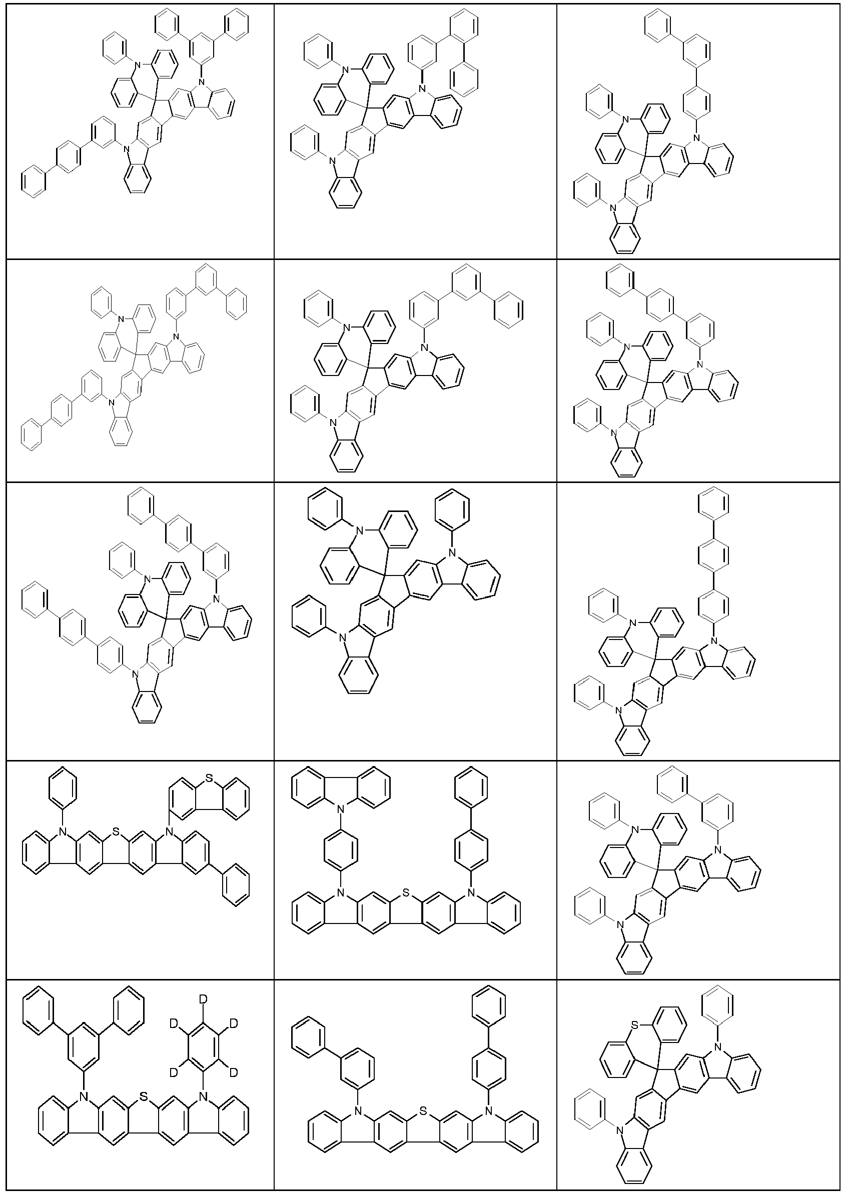

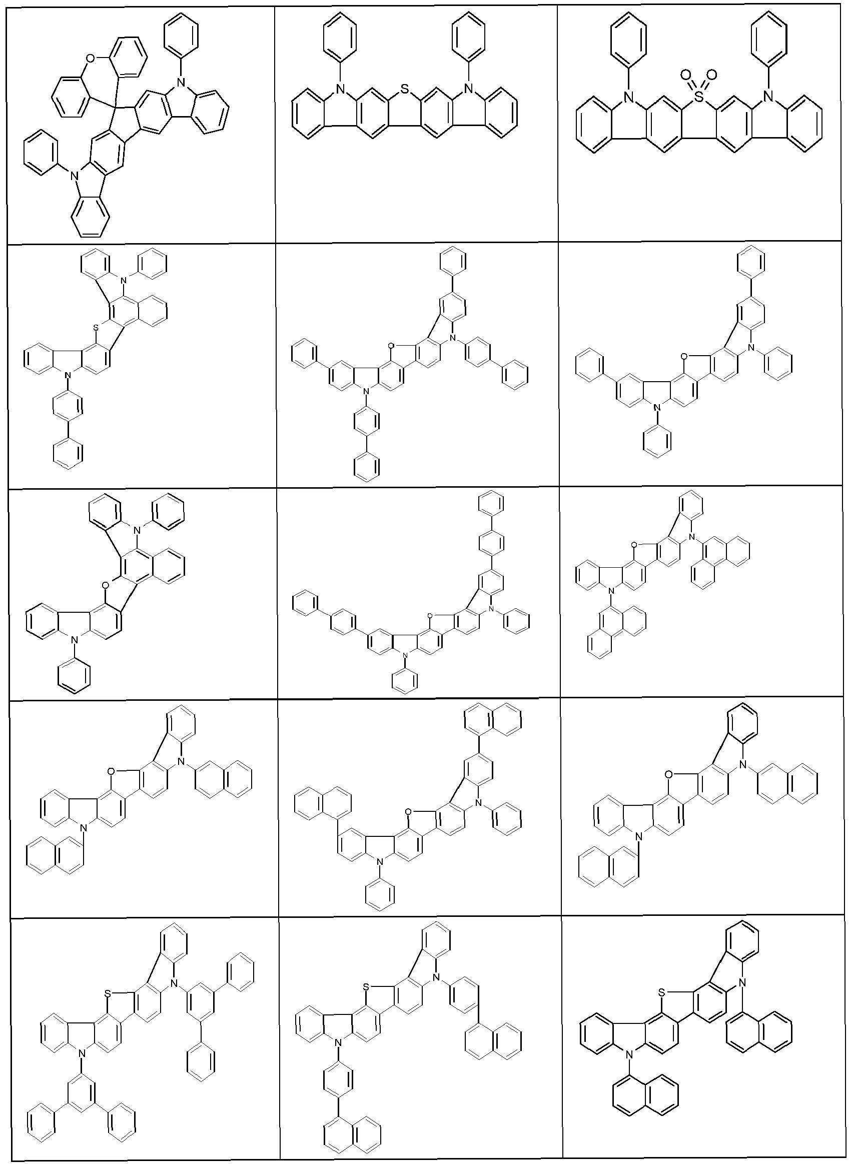

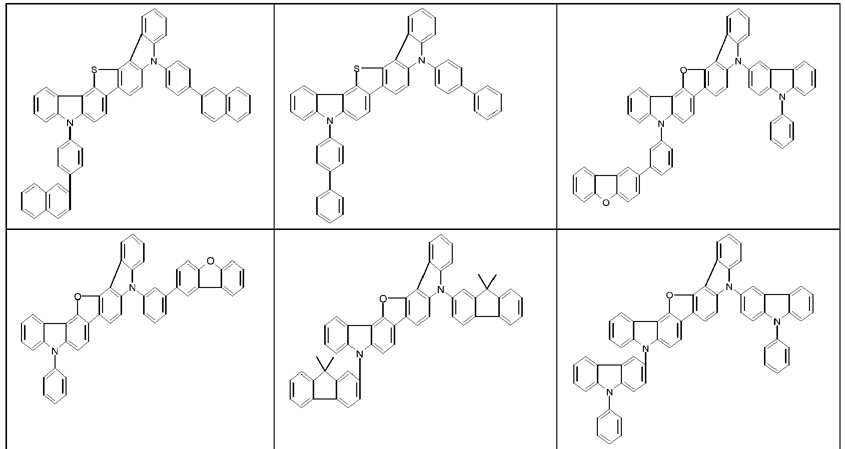

Beispiele für Biscarbazolderivate, welche als lochtransportierende Matrixmaterialien eingesetzt werden können, sind die folgenden Strukturen:

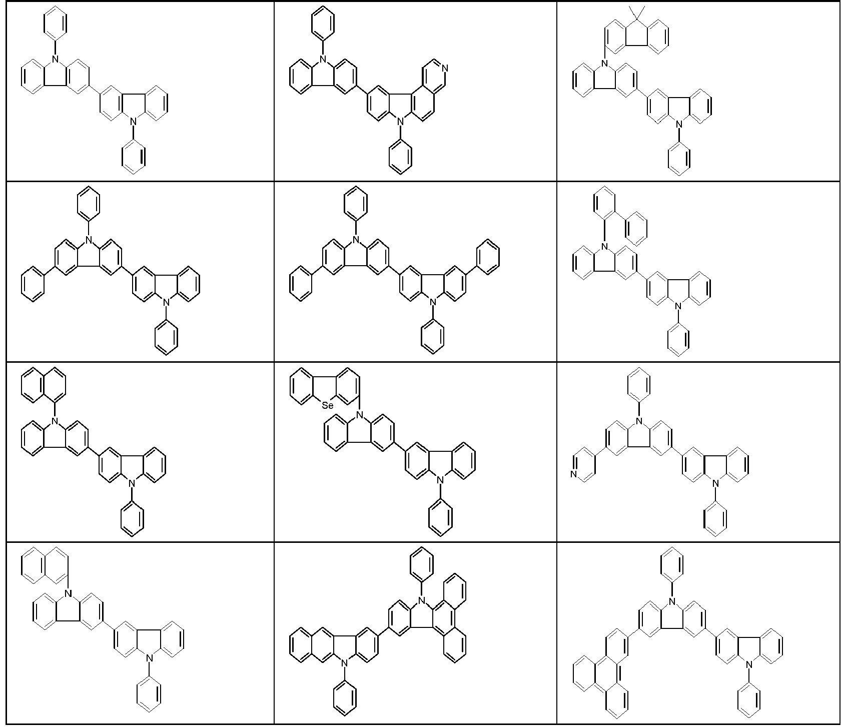

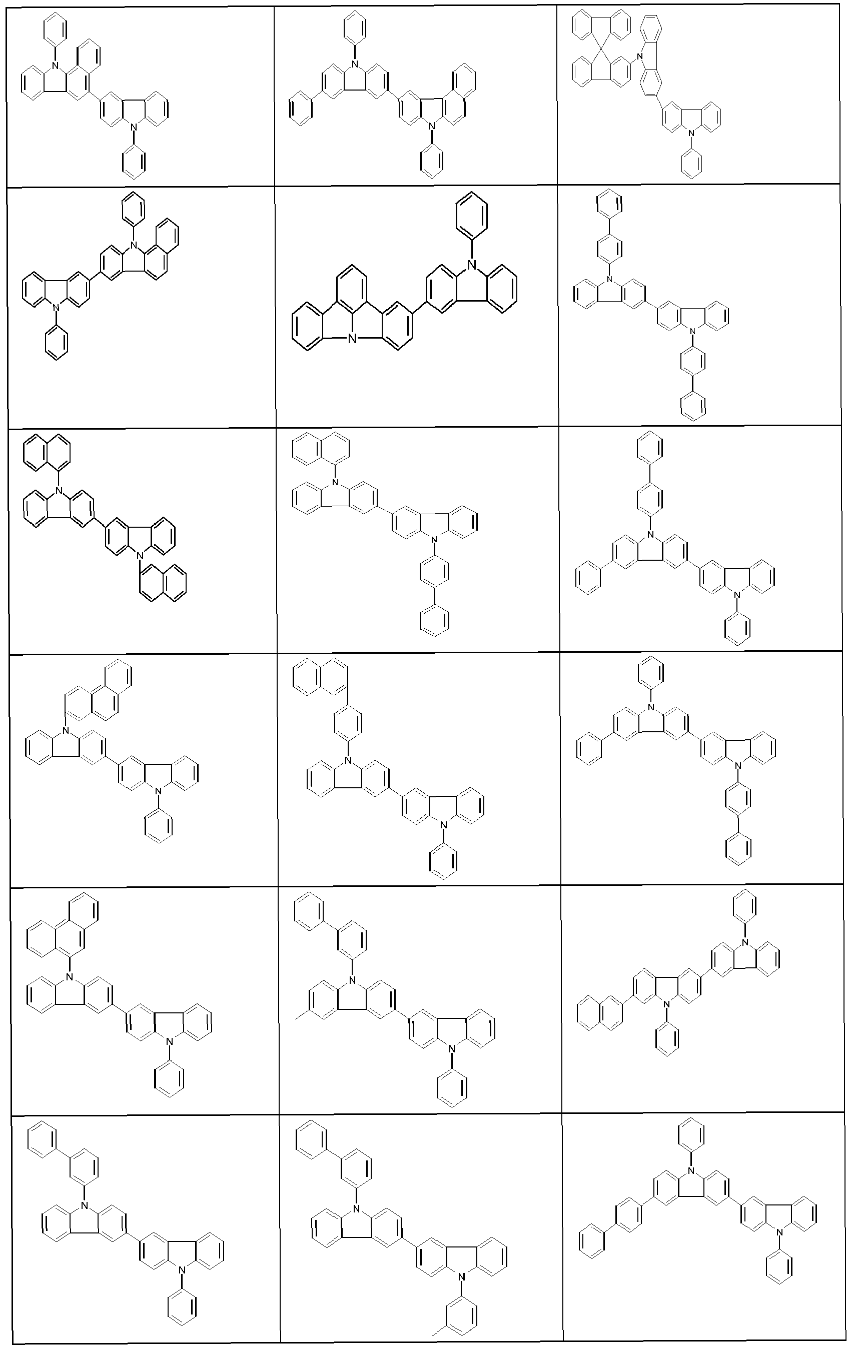

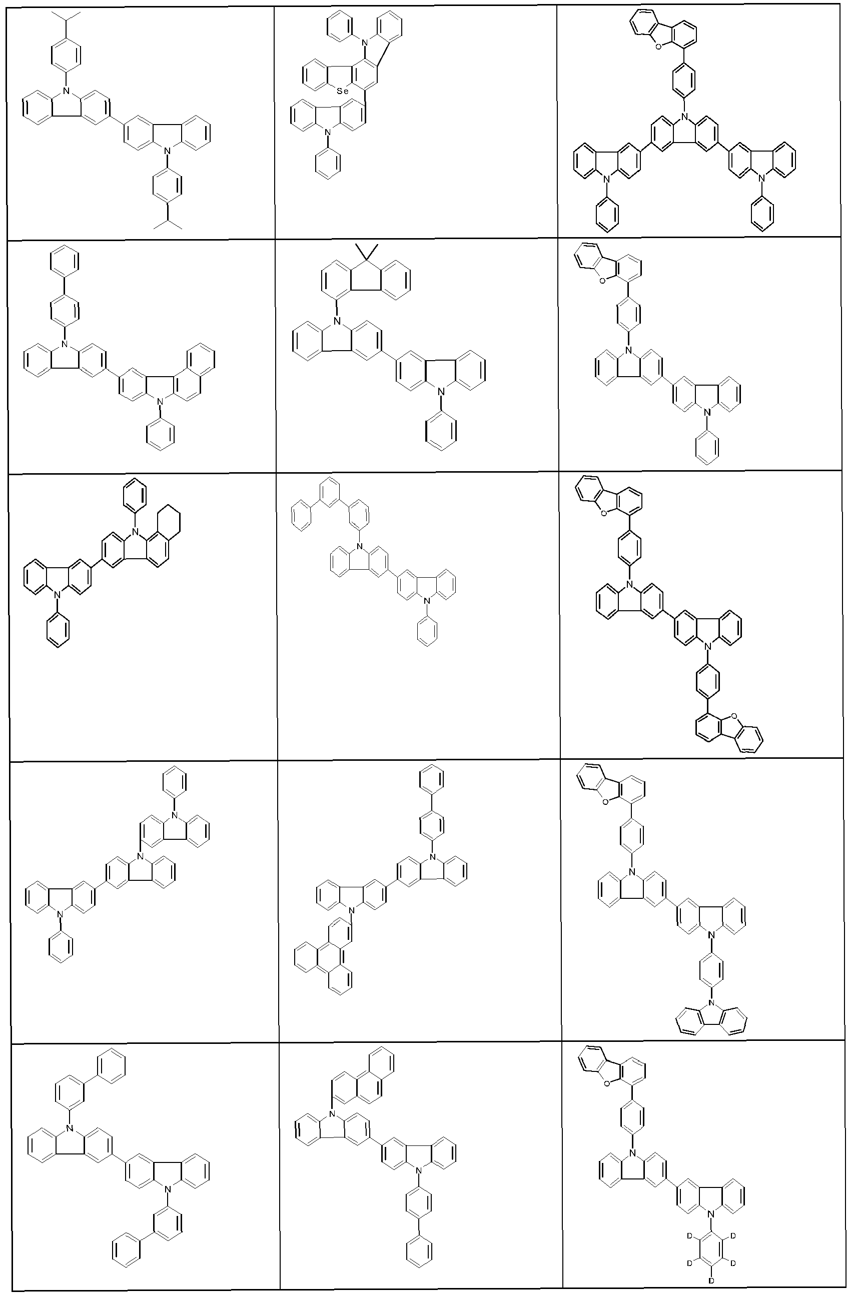

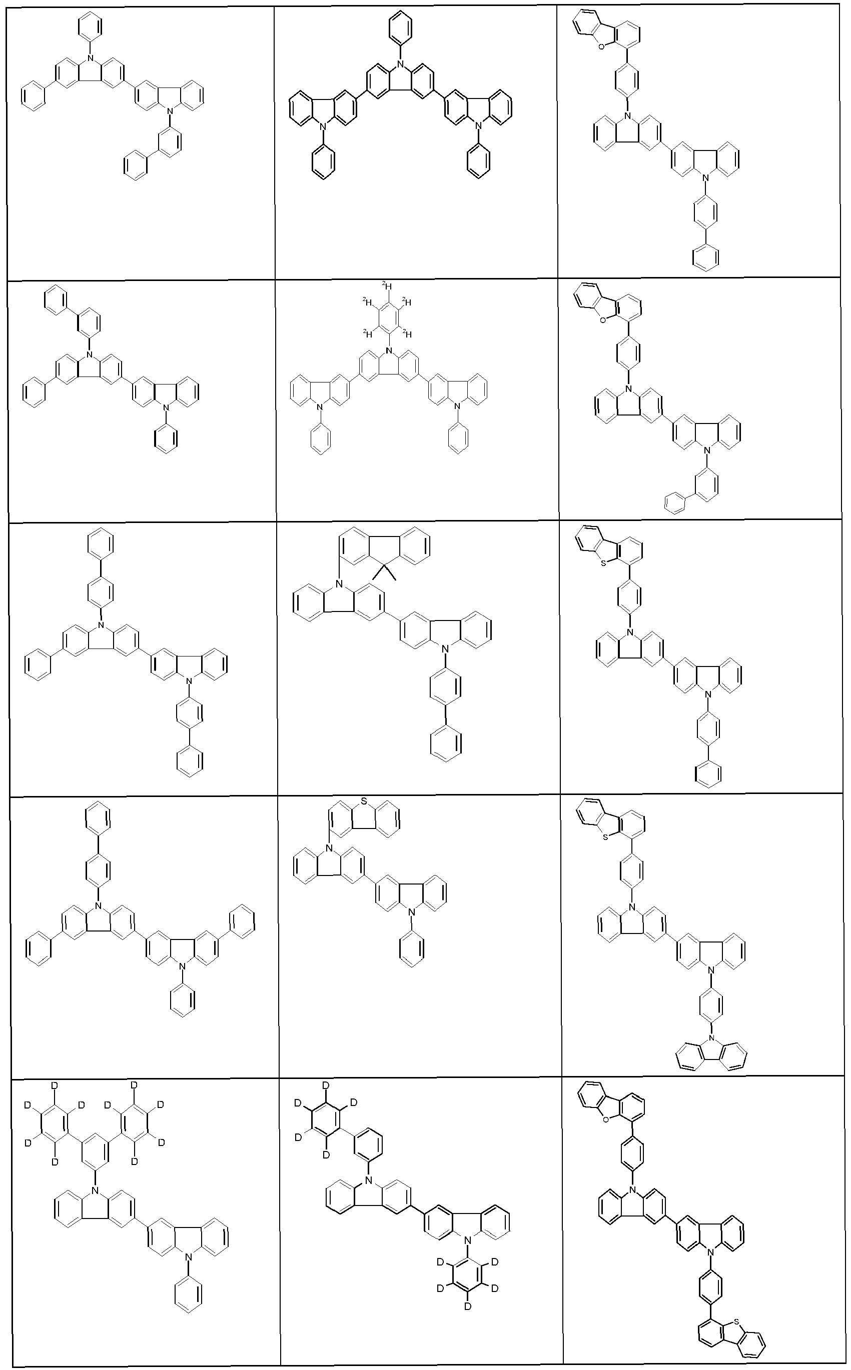

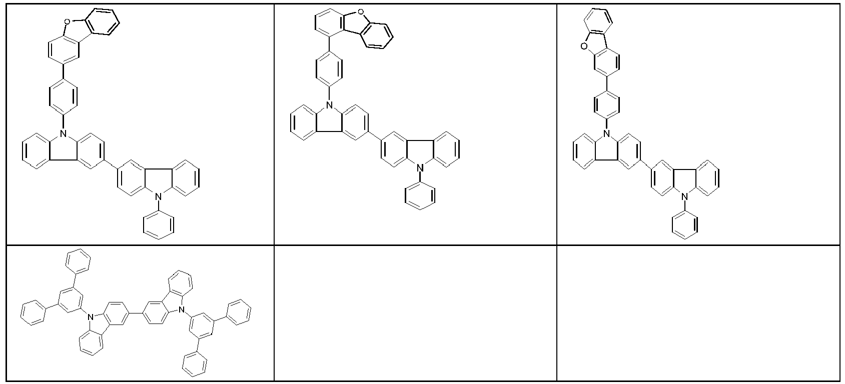

Beispiele für Amine, welche als lochtransportierende Matrixmaterialien eingesetzt werden können sind die folgenden Strukturen:

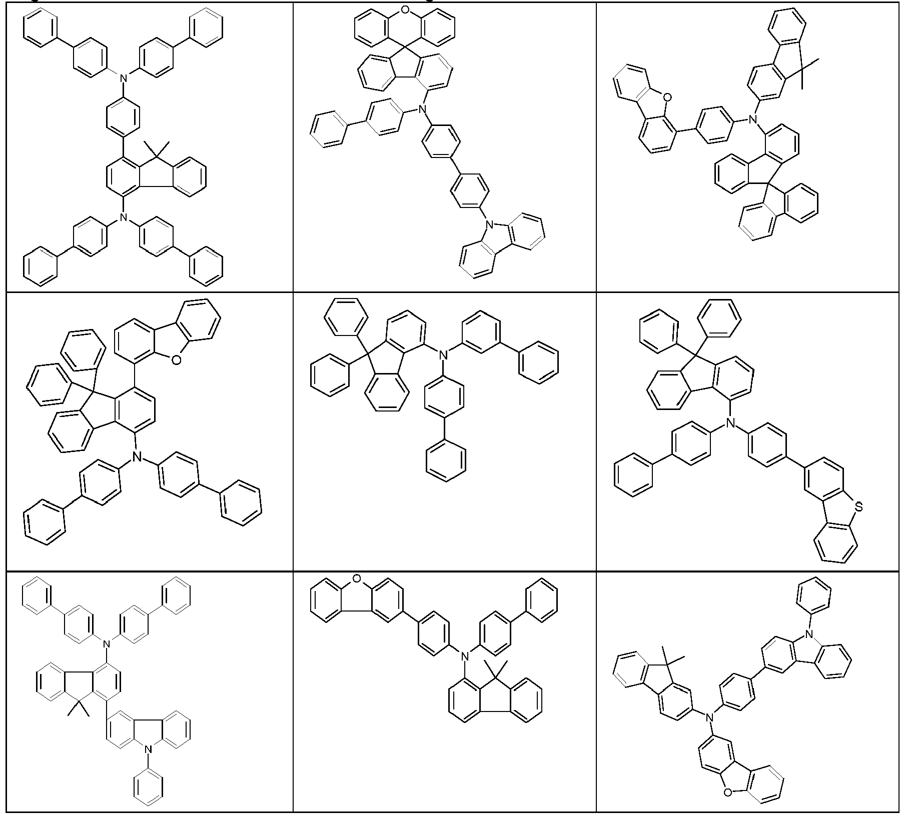

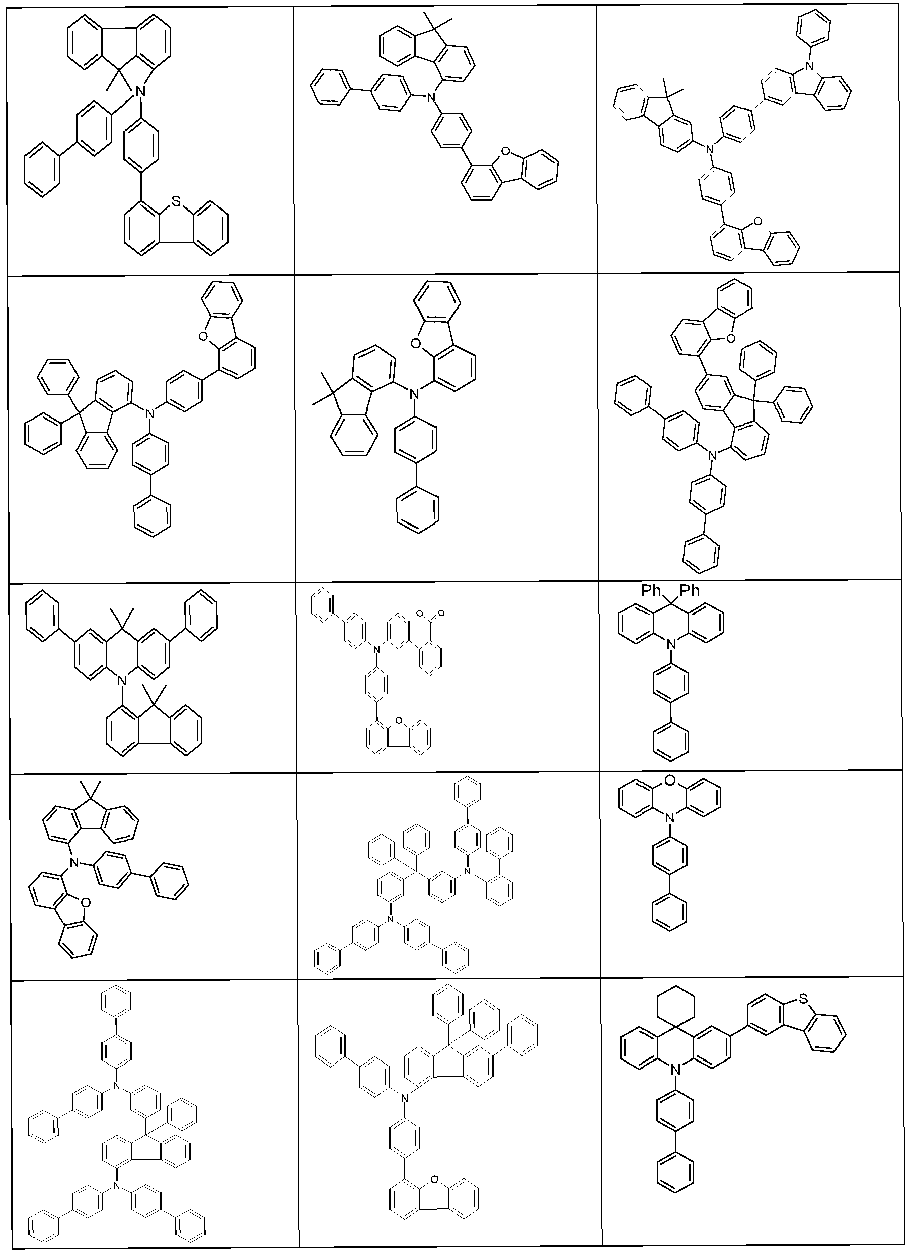

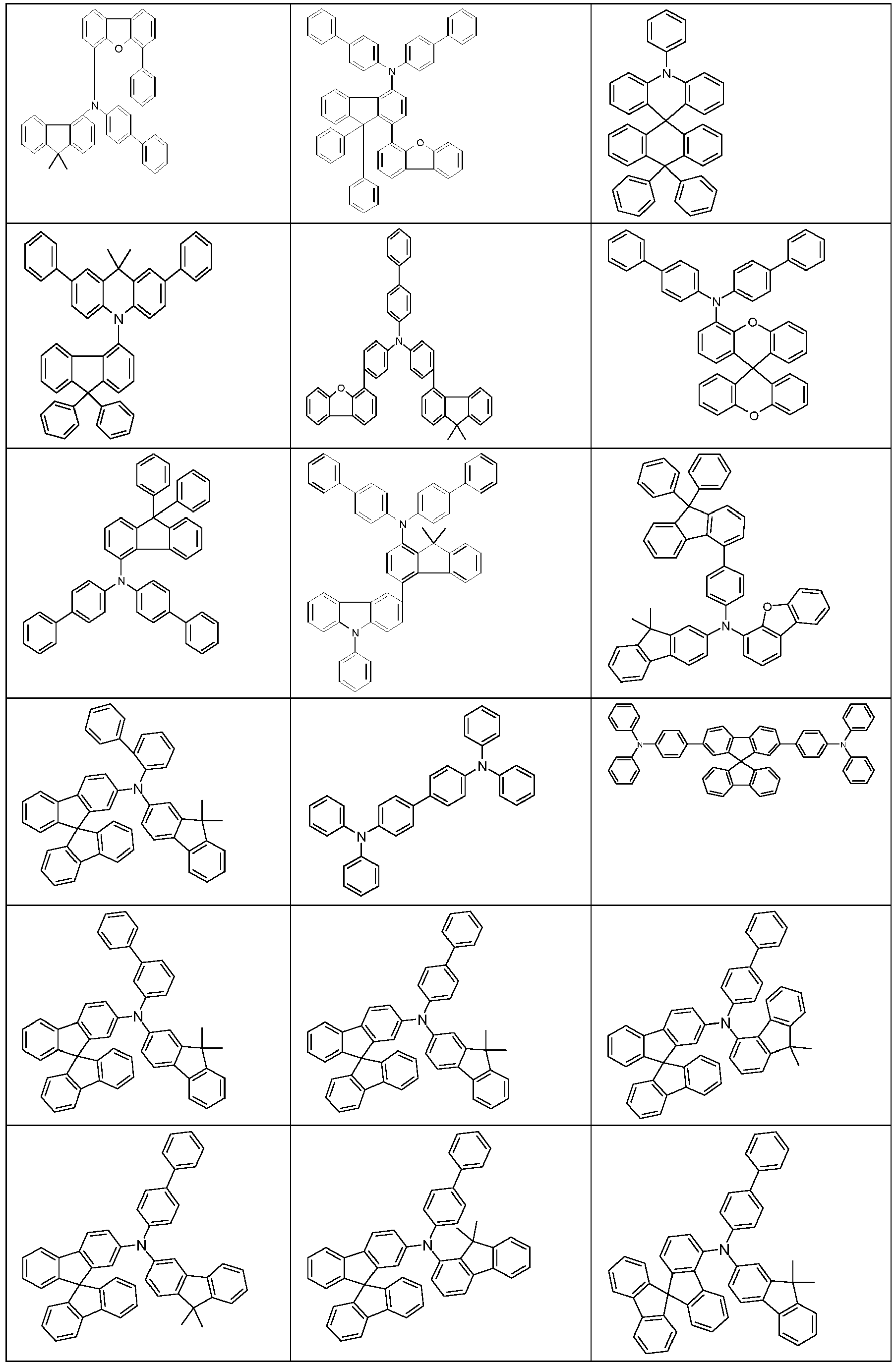

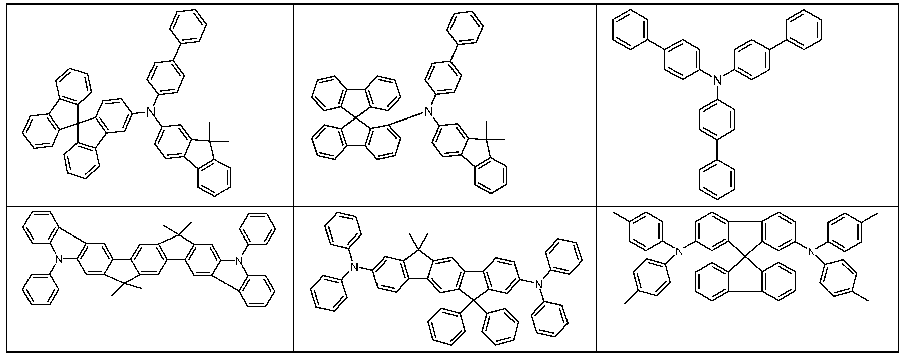

Beispiele für Materialien, welche als Wide Bandgap Matrixmaterialien eingesetzt werden können, sind die folgenden Strukturen:

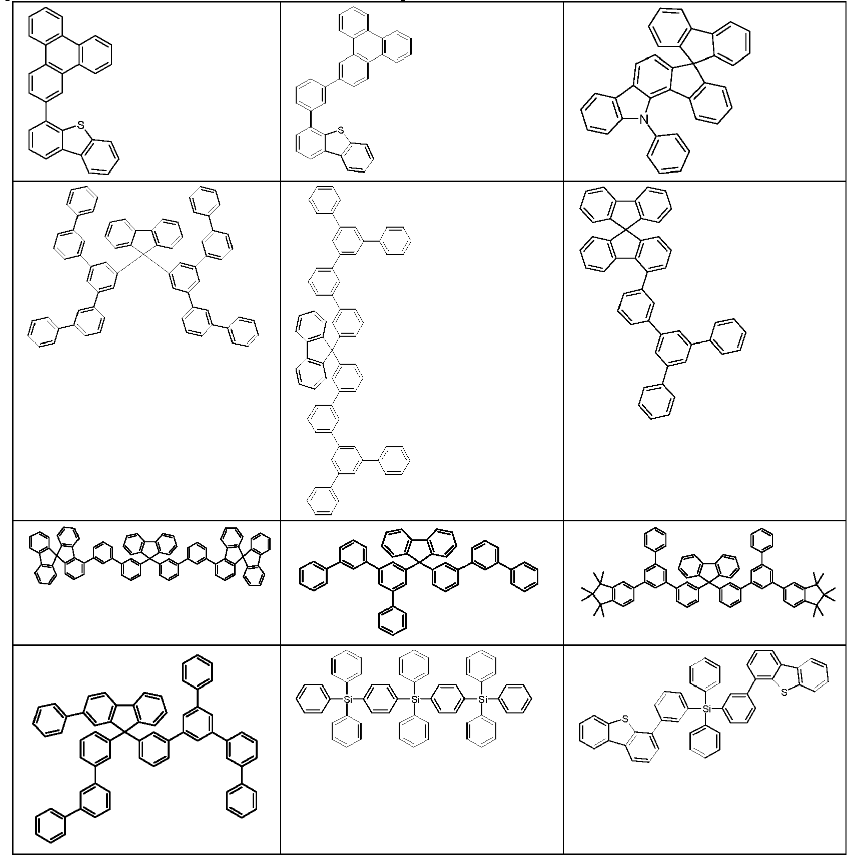

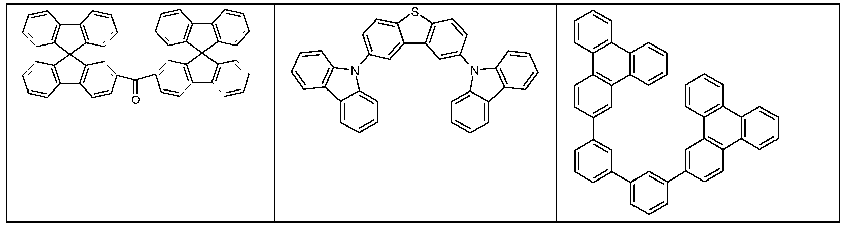

In einer weiteren Ausführungsform der Erfindung wird eine Mischung aus zwei oder mehr Triplettemittern, insbesondere zwei oder drei Triplettemittern, zusammen mit einem oder mehreren Matrixmaterialien eingesetzt. Dabei dient der Triplett-Emitter mit dem kürzerwelligen Emissionsspektrum als Co-Matrix für den Triplett-Emitter mit dem längerwelligen Emissionsspektrum. Dabei weisen diese Triplettemitter bevorzugt die Emissionsfarben Grün und Orange oder Rot oder alternativ Blau und Grün auf. So können beispielsweise die erfindungsgemäßen Metallkomplexe mit einem kürzerwelligen emittierenden Metallkomplex als Co-Matrix kombiniert werden. Es können beispielsweise auch erfindungsgemäße Metallkomplexe als Co-Matrix für längerwellig emittierende Triplettemitter eingesetzt werden. Dabei kann es auch bevorzugt sein, wenn sowohl der kürzerwellig wie auch der längerwellig emittierende Metallkomplex eine erfindungsgemäße Verbindung ist. Eine bevorzugte Ausführungsform bei Verwendung einer Mischung aus drei Triplettemittern ist, wenn zwei als Co-Host und einer als emittierendes Material eingesetzt werden. Dabei weisen diese Triplettemitter bevorzugt die Emissionsfarben Grün, Gelb und Rot oder alternativ Blau, Grün und Orange auf.

Eine weitere bevorzugte Mischung enthält in der emittierenden Schicht ein ladungstransportierendes Hostmaterial, insbesondere ein elektronentransportierendes Hostmaterial, und ein so genanntes "wide bandgap" Hostmaterial, das aufgrund seiner elektronischen Eigenschaften nicht oder nicht in wesentlichem Umfang am Ladungstransport in der Schicht beteiligt ist, und einen Co-Dotanden, welcher ein Triplettemitter ist, welcher bei einer kürzeren Wellenlänge als die erfindungsgemäße Verbindung emittiert, sowie eine erfindungsgemäße Verbindung.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht. Ebenso lassen sich die erfindungsgemäßen Verbindungen als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (0-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden. Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627, WO2014/056565), Fluoren-Amine (z. B. gemäß EP 2875092, EP 2875699 und EP 2875004), Spiro-Dibenzopyran-Amine (z. B. EP 2780325) und Dihydroacridin-Derivate (z. B. gemäß WO 2012/150001).

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Mit den erfindungsgemäßen Metallkomplexen ist rote, orange, gelbe, grüne und blaue Emission mit hoher Effizienz und Lebensdauer zugänglich.
2. Die erfindungsgemäßen Metallkomplexe weisen eine sehr gute Hydrolysestabilität auf. Insbesondere ist die Hydrolysestabilität deutlich besser als bei Komplexen, welche Pyrazolylborat-Derivate als Liganden enthalten, in welchen die Liganden aber nicht polypodal überbrückt sind. Die erfindungsgemäßen Verbindungen eignen sich daher auch sehr gut für die Verarbeitung aus Lösung. Die verbesserte Hydrolysestabilität ist auch ein Vorteil bei der Synthese der Komplexe.
3. Organische Elektrolumineszenzvorrichtungen enthaltend die erfindungsgemäßen Metallkomplexe als emittierende Materialien weisen eine hervorragende Effizienz auf und zeigen orientierte Emission. Dabei ist die Effizienz der Emission besser als in vergleichbaren Komplexen, welche keinen Pyrazolylborat-Teilliganden der Formel (2) aufweisen. Dieser Effekt ist besonders stark ausgeprägt für Metallkomplexe, in denen L³ ein Teilligand der Formel (2) ist, die also zwei Teilliganden der Formel (2) aufweisen. Dieser Effekt ist weiterhin dann besonders ausgeprägt, wenn der Teilligand L² einen Substituenten der Formel (52) oder (53) aufweist, und insbesondere wenn gleichzeitig der Teilligand L³ eine Struktur der Formel (2) aufweist.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbindungen, die mehrere tautomere Formen aufweisen können, wird stellvertretend eine tautomere Form dargestellt.

### A: Synthese der Synthone S:

### Beispiel S1:

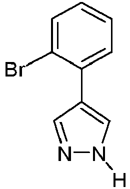

Ein gut gerührtes Gemisch aus 11.2 g (100 mmol) 1H-Pyrazol-4-boron-säure [763120-58-7], 28.3 g (100 mmol) 2-Brom-iod-benzol [583-55-1] und 21.2 g (200 mmol) Natriumcarbonat in 300 ml Dioxan und 50 ml Wasser wird mit 1.63 g (2 mmol) Dichloro[1,1'-bis(diphenylphosphino)ferrocen]-palladium(II) x CH₂Cl₂ versetzt und anschließend 16 h unter Rückfluss erhitzt. Nach Erkalten gibt man 300 ml ges. Kochsalzlösung zu, trennt die org. Phase ab und trocknet diese über Magnesiumsulfat. Man filtriert über ein mit Dioxan vorgeschlämmtes Kieselgelbett vom Trockenmittel ab, engt das Filtrat im Vakuum ein und unterzieht den Rückstand einer FlashChromatographie (Säulenautomat Torrent der Fa. A. Semrau). Ausbeute: 12.0 g (54 mmol), 54 %. Reinheit ca. 95%ig n. ¹H-NMR.

Analog können folgende Verbindungen dargestellt werden.

| Bsp. | Edukte | Produkt | Ausbeute |
|---|---|---|---|
| S2 | 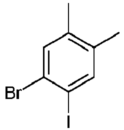 | 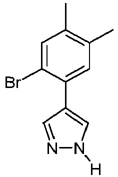 | 57% |
| | 96834-22-0 | | |
| S3 | 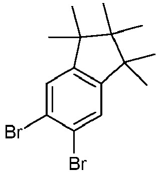 | 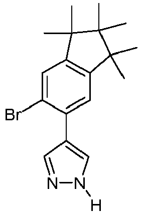 | 51% |
| | 1541101-19-2 | | |
| S4 | 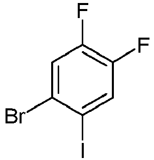 | 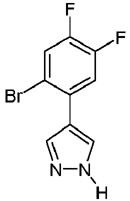 | 45% |
| | 1349718-22-4 | | |
| S5 | 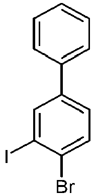 | 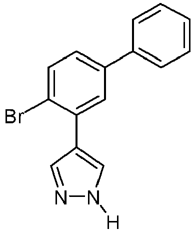 | 50% |
| | 1370712-52-7 | | |
| S6 | 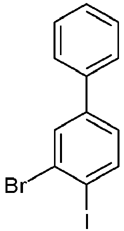 | 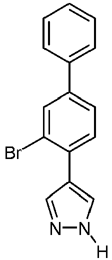 | 48% |
| | 900806-53-3 | | |
| S7 | 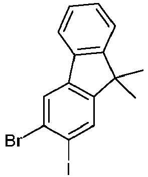 | 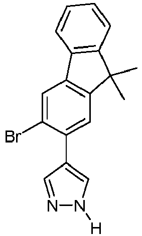 | 52% |
| | 1346635-65-1 | | |
| S8 | 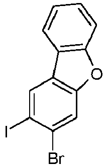 | 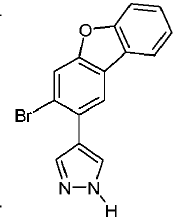 | 53% |
| | 2086712-49-2 | | |
| S9 | 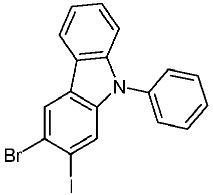 | 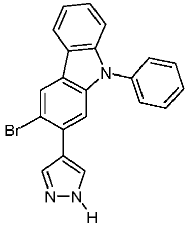 | 45% |
| | 1549979-37-4 | | |

### Beispiel S30:

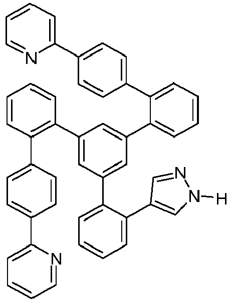

Ein gut gerührtes Gemisch aus 66.3 g (100 mmol) 2,2'-[5"-(4,4,5,5-tetramethyl-1,3,2-dioxaborolan-2-yl)[1,1'-2',1":3",1‴:2‴,1ʺʺ-quinquephenyl]-4, 4""-diyl]bis-pyridin [1989597-72-9], 22.3 g (100 mmol) S1, 21.2 g (200 mmol) Natriumcarbonat, 1.23 g (3 mmol) SPhos, 449 mg (2 mmol) Palladium(II)acetat, 300 ml Toluol, 100 ml Ethanol und 300 ml Wasser wird 16 h unter Rückfluss erhitzt. Nach Erkalten wird mit 300 ml Toluol erweitert, die org. Phase wird abgetrennt, einmal mit 500 ml Wasser und einmal mit 500 ml ges. Kochsalzlösung gewaschen und über Magnesiumsulfat getrocknet. Nach Abfiltrieren vom Trockenmittel über ein mit Toluol vorgeschlämmtes Celite-Bett und Entfernen des Lösungsmittels im Vakuum wird der Rückstand aus Acetonitril/Ethylacetat umkristallisiert. Ausbeute: 49.6 g (73 mmol), 73 %. Reinheit: ca. 97 %ig n. ¹H-NMR.

Analog können folgende Verbindungen dargestellt werden.

| Bsp. | Edukte | Produkt | Ausbeute |
|---|---|---|---|
| S31 | 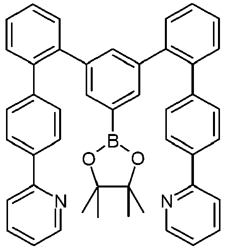 | 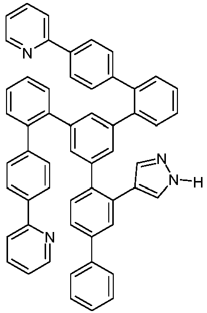 | 70% |
| | [1989597-72-9] S5 | | |
| S32 | 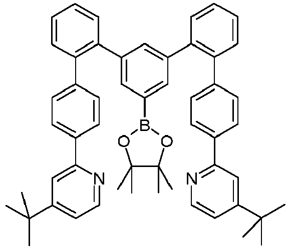 | 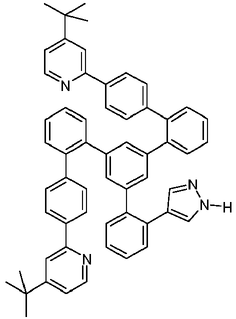 | 75% |
| | [1989597-75-2] S1 | | |
| S33 | 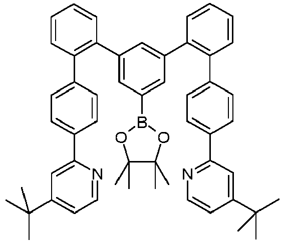 | 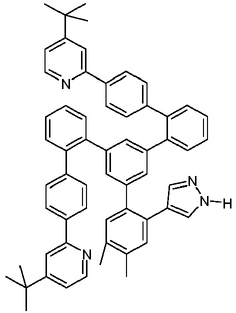 | 72% |
| | [1989597-75-2] S2 | | |
| S34 | 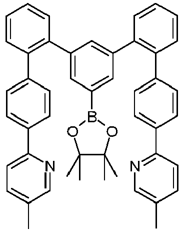 | 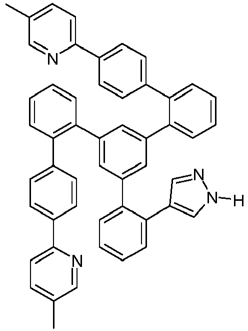 | 70% |
| | Darst. analog zu [1989597-75-2] gemäß WO 2016/124304 durch Einsatz von 2-Brom-5-methylpyridin [3510-66-5] S1 | | |
| S35 | 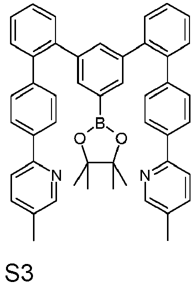 | 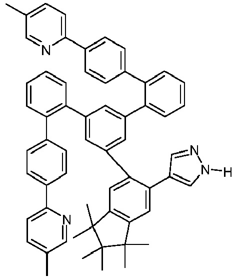 | 67% |
| S36 | 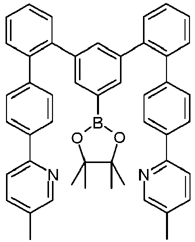 | 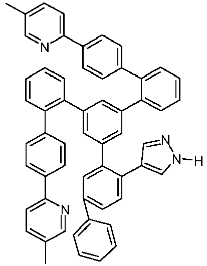 | 76% |
| S37 | 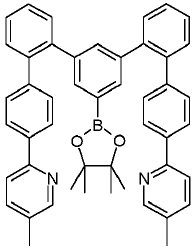 | 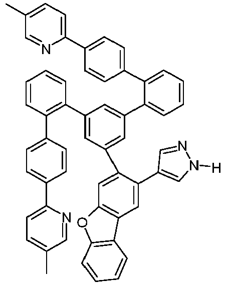 | 78% |
| S38 | 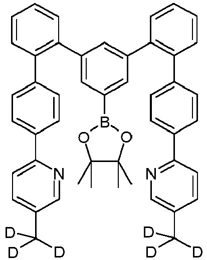 | 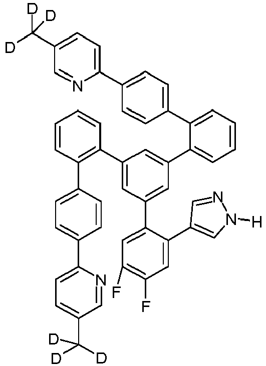 | 64% |
| | Darst. analog zu [1989597-75-2] gemäß WO 2016/124304 durch Einsatz von 2-Brom-5-(methyl-d₃)-pyridin [1185306-03-9] S4 | | |
| S39 | 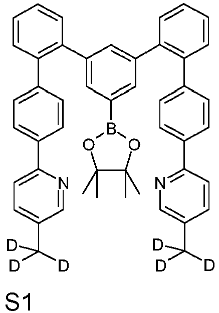 | 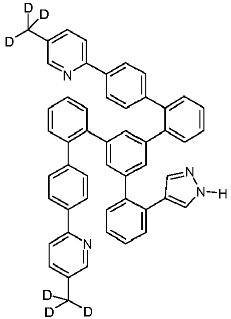 | 77% |
| S40 | 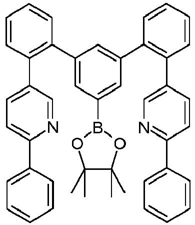 | 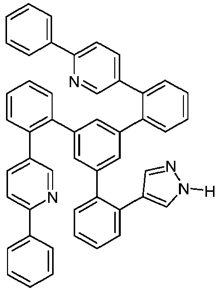 | 73% |
| | [1989597-70-7] S1 | | |
| S41 | 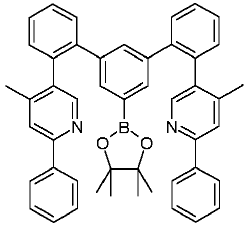 | 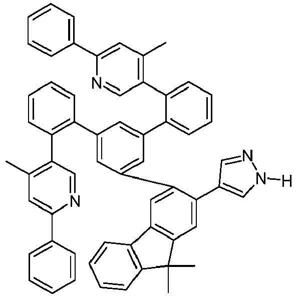 | 69% |
| | [1989597-71-8] S7 | | |
| S42 | 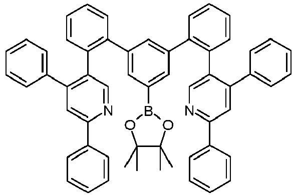 | 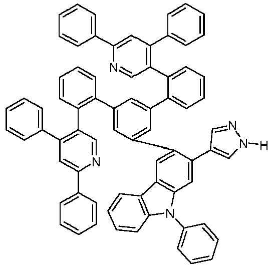 | 76% |
| | [1989597-74-1] S9 | | |

### Beispiel S50:

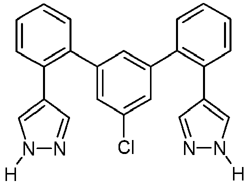

Ein gut gerührtes Gemisch aus 18.2 g (50 mmol) 2,2'-(5-Chlor-1,3-phenylen)bis[4,4,5,5-tetramethyl-1,3,2-dioxaborolan [1417036-49-7], 22.3 g (100 mmol) S1 und 21.2 g (200 mmol) Natriumcarbonat in 300 ml Toluol, 200 ml Ethanol und 300 ml Wasser wird mit 1.6 g (6 mmol) Triphenylphosphin und dann mit 449 mg (2 mmol) Palladium(II)acetat versetzt und anschließend 24 h unter Rückfluss erhitzt. Nach Erkalten trennt man die Toluolphase ab, wäscht diese einmal mit 300 ml Wasser und einmal mit 300 ml ges. Kochsalzlösung und trocknet dann über Magnesiumsulfat. Man filtriert über ein mit Toluol vorgeschlämmtes Celite-Bett ab, entfernt das Toluol im Vakuum und kristallisiert den Rückstand aus Acetonitril/Methanol um. Ausbeute: 12.7 g (32 mmol), 64 %. Reinheit: ca. 95%ig n. ¹H-NMR.

### Beispiel S51:

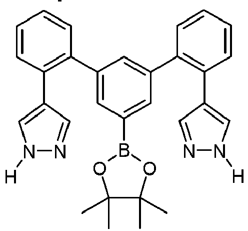

Ein Gemisch aus 19.8 g (50 mmol) S50, 14.0 g (55 mmol) Bis(pinacolato)-diboran [78183-34-3], 8.2 g (100 mmol) Natriumacetat und 50 g Glaskugeln (3 mm Durchmesser) in 300 ml THF wird nacheinander mit 534 mg (1.3 mmol) SPhos und dann mit 224 mg (1 mmol) Palladium(II)acetat versetzt und 16 h unter Rückfluss gerührt. Nach Erkalten wird die Reaktionsmischung über ein mit THF vorgeschlämmtes Celite-Bett filtriert. Das Filtrat wird im Vakuum zur Trockene eingeengt, und der Rückstand wird in 200 ml warmem Methanol ausgerührt. Man saugt das Produkt ab, wäscht zweimal mit je 50 ml Methanol und trocknet im Vakuum. Ausbeute: 23.0 g (47 mmol), 94 %. Reinheit ca. 95%ig n. ¹H-NMR.

### Beispiel S60:

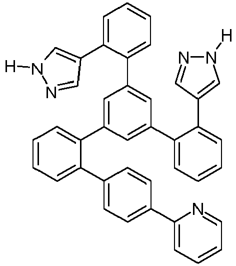

Ein gut gerührtes Gemisch aus 48.8 g (100 mmol) S51, 31.0 g (100 mmol) 2-(2'-Brom[1,1'-biphenyl]-4-yl)pyridin [1374202-35-3], 21.2 g (200 mmol) Natriumcarbonat, 1.23 g (3 mmol) SPhos, 449 mg (2 mmol) Palladium(II)-acetat, 300 ml Toluol, 100 ml Ethanol und 300 ml Wasser wird 16 h unter Rückfluss erhitzt. Nach Erkalten wird mit 300 ml Toluol erweitert, die org. Phase wird abgetrennt, einmal mit 500 ml Wasser und einmal mit 500 ml ges. Kochsalzlösung gewaschen und über Magnesiumsulfat getrocknet. Nach Abfiltrieren vom Trockenmittel über ein mit Toluol vorgeschlämmtes Celite-Bett und Entfernen des Lösungsmittel im Vakuum wird der Rückstand aus Acetonitril/Ethylacetat umkristallisiert. Ausbeute: 37.3 g (63 mmol), 63 %. Reinheit: ca. 97 %ig n. ¹H-NMR.

Analog können folgende Verbindungen dargestellt werden.

| Bsp. | Edukte | Produkt | AusBeute |
|---|---|---|---|
| S61 | 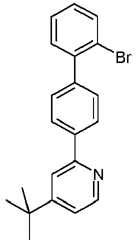 | 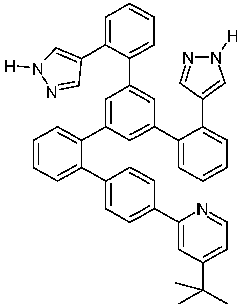 | 66% |
| | [1989597-33-2] S51 | | |
| S62 | 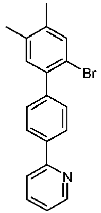 | 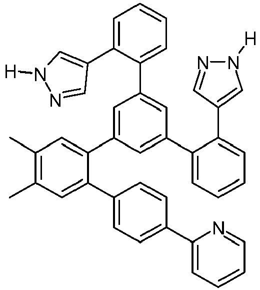 | 60% |
| | [1989597-43-4] S51 | | |
| S63 | 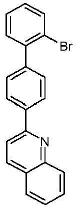 | 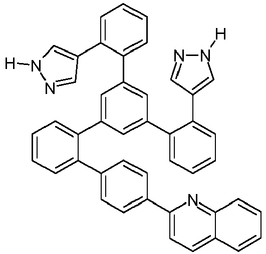 | 61% |
| | [2088182-36-7] | | |
| | S51 | | |
| S64 | 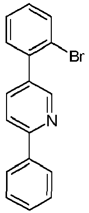 | 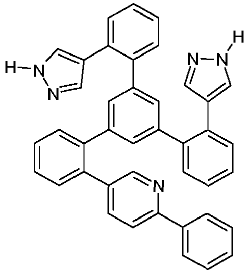 | 60% |
| | [1989597-29-6] S51 | | |
| S65 | 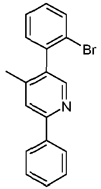 | 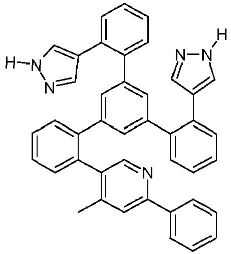 | 64% |
| | [1989597-30-9] S51 | | |
| S66 | 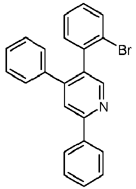 | 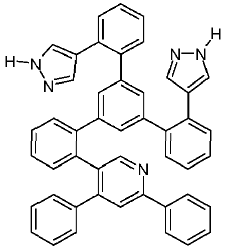 | 68% |
| | [1989597-32-1] S51 | | |
| S67 | 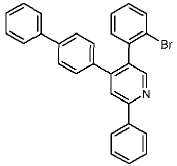 | 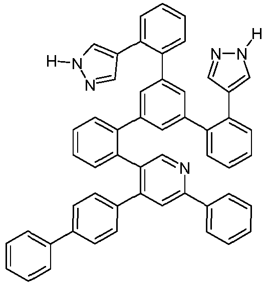 | 68% |
| | Darstellung gemäß WO2016124304 analog zu [1989597-32-1] durch Einsatz von [5122-94-1] S51 | | |
| S68 | 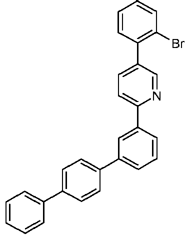 | 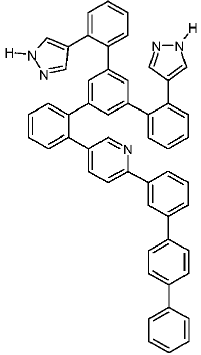 | 70% |
| | Darstellung gemäß WO2016124304 analog zu [1989597-29-6] durch Einsatz von [881911-81-5] S51 | | |
| S69 | 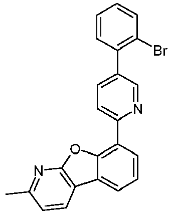 | 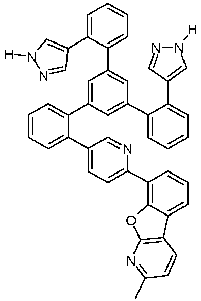 | 66% |
| | [1989597-32-1] S51 | | |

### B: Synthese der Komplexe:

### Beispiel Ir(L30):

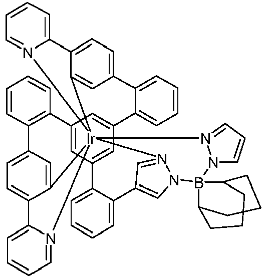

Eine gut gerührte Lösung von 6.79 g (10 mmol) S30 in 200 ml trockenem Benzonitril wird bei 60 °C mit 8.27 g (30 mmol) Silbercarbonat [534-16-7] und 50 g Glaskugeln (3 mm Durchmesser) versetzt und 5 min. gerührt. Dann fügt man 3.22 g (10 mmol) Tris-(acetonitril)trichloroiridium(III) [85835-70-7] zu und erhitzt die Reaktionsmischung 6 h am Wasserabscheider auf 130 °C, wobei das Acetonitril abdestilliert. Man lässt auf 60 °C abkühlen, gibt 2.8 g (12 mmol) 1,5-Cyclooctandiyl(*N,N*-dimethylamin)(1*H*-pyrazolato-*N*¹)-boran [125050-95-5] zu und rührt 16 h bei 60 °C nach. Man entfernt das Benzonitril im Vakuum, löst den Rückstand in 300 ml Dichlormethan (DCM) und destilliert dann das DCM am Rotationsverdampfer ab, wobei man gleichzeitig MeOH zutropft, bis das Rohprodukt kristallisiert. Man saugt ab, wäscht das Rohprodukt dreimal mit je 30 ml MeOH und trocknet im Vakuum. Das so erhaltene Rohprodukt wird in 200 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten und am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des orangefarbenen Produkts durch fünfmalige kontinuierliche Heißextraktion mit Dichlormethan/Acetonitril 1:1 (vv) (Vorlagemenge jeweils ca. 200 ml, Extraktionshülse: standard Soxhletthülsen aus Cellulose der Fa. Whatman) unter sorgfältigem Luft- und Lichtausschluss. Über das Verhältnis Dichlormethan (Niedersieder und Gutlöser):Acetonitril (Hochsieder und Schlechtlöser) kann der Verlust in die Mutterlauge eingestellt werden. Typischerweise sollte er 3-6 Gew.-% der eingesetzten Menge betragen. Es können zur Heißextraktion auch andere Lösungsmittel bzw. Lösemittelgemische wie Toluol, Xylol, Essigester, Butylacetat, i-PrOH, etc. verwendet werden. Abschließend wird das Produkt im Hochvakuum bei 380-440 °C fraktioniert sublimiert. Ausbeute: 3.82 g (3.6 mmol), 36 %. Reinheit: > 99.9 % nach HPLC.

Analog können folgende Verbindungen dargestellt werden.

| Bsp. | Edukte | Produkt | Ausbeute |
|---|---|---|---|
| Ir(L31) | 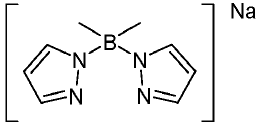 S31 | 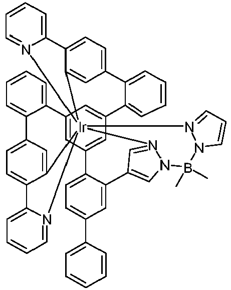 | 24% |
| | [56953-94-7] | | |
| Ir(L32) | S32 [56953-94-7] | 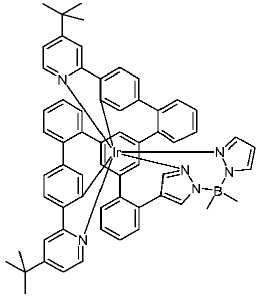 | 35% |
| Ir(L33) | 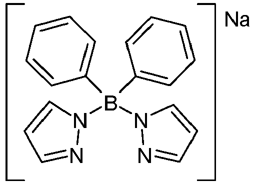 S33 | 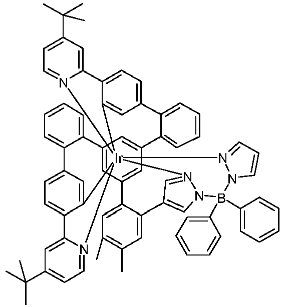 | 32% |
| | [16453-63-7] | | |
| Ir(L34) | S34 [125050-95-5] | 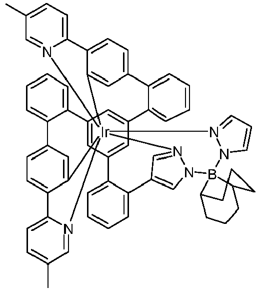 | 74% |
| | 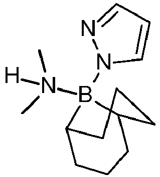 | | |
| Ir(L35) | S35 [125050-95-5] | 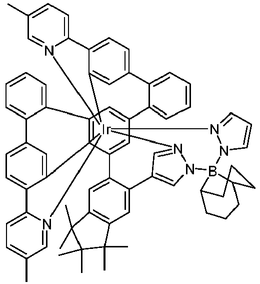 | 34% |
| Ir(L36) | S36 [125050-95-5] | 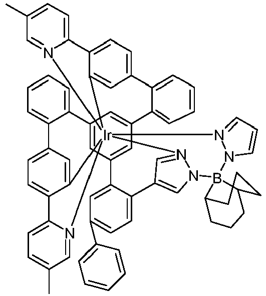 | 33% |
| Ir(L37) | S37 [125050-95-5] | 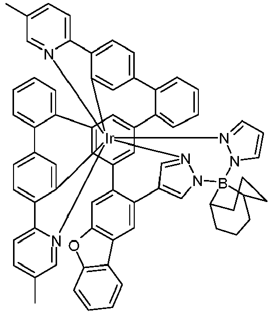 | 29% |
| Ir(L38) | S38 [125050-95-5] | 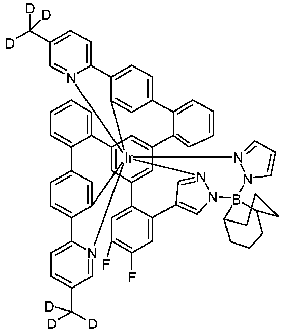 | 34% |
| Ir(L39) | S39 [125050-95-5] | 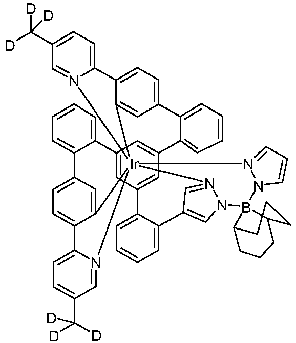 | 37% |
| Ir(L40) | S40 [125050-95-5] | 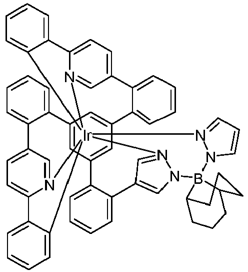 | 43% |
| Ir(L41) | S41 [125050-95-5] | 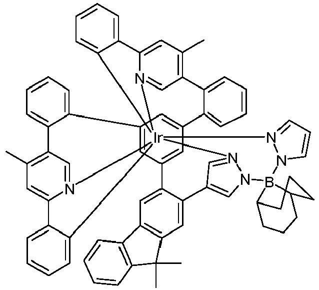 | 45% |
| Ir(L42) | S42 [125050-95-5] | 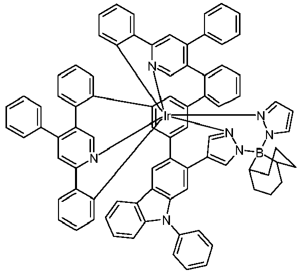 | 40% |

### Beispiel Ir(L60):

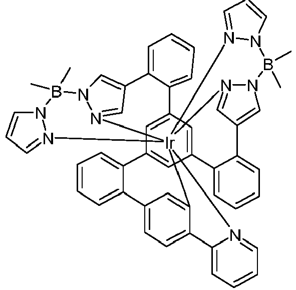

Eine gut gerührte Lösung von 5.92 g (10 mmol) S60 in 200 ml trockenem Benzonitril wird bei 60 °C mit 8.27 g (30 mmol) Silbercarbonat [534-16-7] und 50 g Glaskugeln (3 mm Durchmesser) versetzt und 5 min. gerührt.

Dann fügt man 3.22 g (10 mmol) Tris-(acetonitril)trichloroiridium(III) [85835-70-7] zu und erhitzt die Reaktionsmischung 6 h am Wasserabscheider auf 130 °C, wobei das Acetonitril abdestilliert. Man lässt auf 60 °C abkühlen, gibt 4.98 g (25 mmol) Natrium[dimethylbis(1*H*-pyrazolato-*N*¹)]borat [56953-94-7] zu und rührt 16 h bei 60 °C nach. Man entfernt das Benzonitril im Vakuum, löst den Rückstand in 300 ml Dichlormethan (DCM) und destilliert dann das DCM am Rotationsverdampfer ab, wobei man gleichzeitig MeOH zutropft, bis das Rohprodukt kristallisiert. Man saugt ab, wäscht das Rohprodukt dreimal mit je 30 ml MeOH und trocknet dann im Vakuum. Das so erhaltene Rohprodukt wird, wie unter Beispiel Ir(L30) beschrieben, gereinigt und sublimiert. Ausbeute: 3.01 g (3 mmol), 30 %. Reinheit: > 99.9 % nach HPLC.

Analog können folgende Verbindungen dargestellt werden.

| Bsp. | Edukte | Produkt | Ausbeute |
|---|---|---|---|
| Ir(L61) | S61 [16453-63-7] | 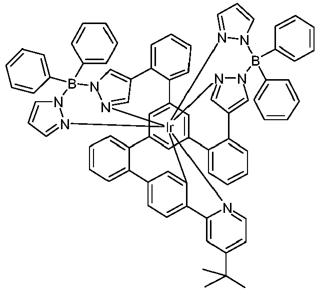 | 29% |
| Ir(L62) | S62 [125050-95-5] | 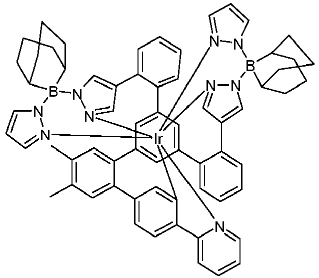 | 34% |
| Ir(L63) | S63 [125050-95-5] | 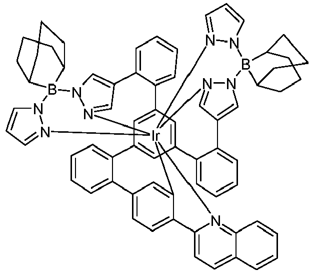 | 30% |
| Ir(L64) | S64 [125050-95-5] | 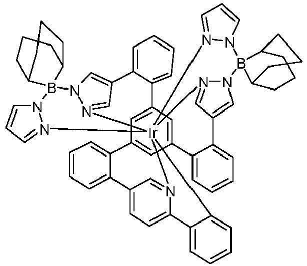 | 29% |
| Ir(L65) | S65 [125050-95-5] | 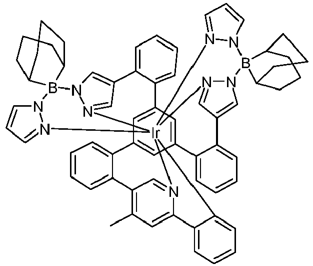 | 37% |
| Ir(L66) | S66 [125050-95-5] | 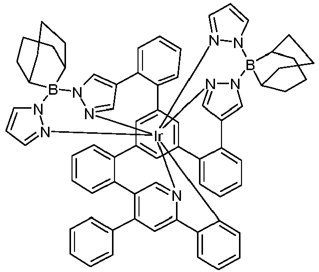 | 35% |
| Ir(L67) | S67 [125050-95-5] | 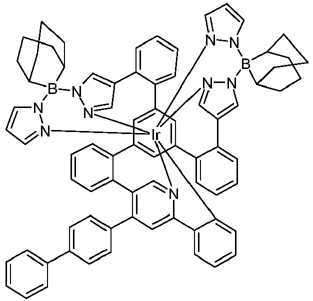 | 27% |
| Ir(L68) | S68 [56953-94-7] | 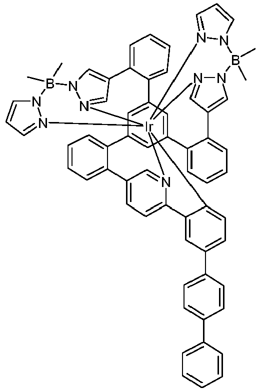 | 31% |
| Ir(L69) | S69 [56953-94-7] | 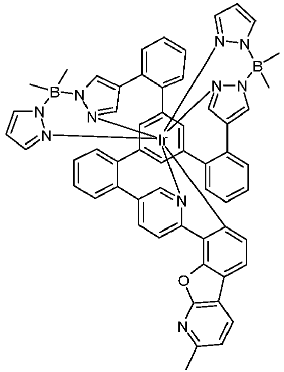 | 33% |

### Hydrolysestabilität der Komplexe:

Zur Verarbeitung aus Lösung (s. Beispiel: Herstellung der OLEDs, Lösungs-prozessierte Devices) müssen die Komplexe eine sehr gute Hydrolysestabilität aufweisen, da sonst durch das im Lösungsmittel vorhandene Restwasser eine hydrolytische Zersetzung erfolgen kann. Schon eine hydrolytische Zersetzung in geringfügigem Umfang kann die Bauteileigenschaften der OLED-Devices bezüglich Effizienz und vor allem Lebensdauer sehr negativ beeinflussen. Zur Überprüfung der Hydrolysebeständigkeit werden 15 mg des Komplexes in 0.75 ml DMSO-d6 gelöst, mit 50 µl H₂O versetzt und 8 h bei 60 °C ausgelagert. Danach wird ein 1H NMR Spektrum (1024 scans) vermessen und mit dem 1H NMR Spektrum des Komplexes in trockenem DMSO-d6, wobei die Lösung ebenfalls 8 h bei 60 °C ausgelagert wurde, verglichen. Hydrolyse macht sich durch das Aufreteten von neuen Signalen bemerkbar. Diese können dem freien Liganden, Hydrolyseprodukten des Liganden und Aquo-Komplexen zugeordnet werden. Die Ergebnisse sind in der nachfolgenden Tabelle 1 zusammengestellt.

**Tabelle 1: Hydrolyseeigenschaften**

| Bsp. | Komplex | Beobachtung von Hydrolyse |
|---|---|---|
| H1 | Ref-Ir1 s. (Tabelle 4) | Ja |
| H2 | Ir(L31) | Nein |
| H3 | Ir(L60) | Nein |

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird. In den folgenden Beispielen werden die Ergebnisse verschiedener OLEDs vorgestellt. Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 25 Minuten mit UV-Ozon vorbehandelt (UV-Ozon Generator PR-100, Firma UVP) und innerhalb 30 min. zur verbesserten Prozessierung mit 20 nm PEDOT:PSS beschichtet (Poly(3,4-ethylendioxythiophen)poly(styrolsulfonat), bezogen als CLEVIOS^{™} P VP Al 4083 von Heraeus Precious Metals GmbH Deutschland, aus wässriger Lösung aufgeschleudert) und anschließend bei 180 °C 10 min. lang ausgeheizt. Diese beschichteten Glasplättchen bilden die Substrate, auf welche die OLEDs aufgebracht werden. Die OLEDs haben prinzipiell folgenden Schichtaufbau: Substrat / Lochinjektionsschicht 1 (HIL1) bestehend aus HTM dotiert mit 5 % NDP-9 (kommerziell erhältlich von der Fa. Novaled), 20 nm / Lochtransportschicht 1 (HTL1) bestehend aus HTM, 160 nm für blaue Devices, 220 nm für grüne/gelbe Devices / Elektronenblockerschicht (EBL) / Emissionsschicht (EML) / Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Für vakuum-prozessierte OLEDs werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M1:M2:Ir(L2) (55%:35%:10%) bedeutet hierbei, dass das Material M1 in einem Volumenanteil von 55%, M2 in einem Volumenanteil von 35% und Ir(L1) in einem Volumenanteil von 10% in der Schicht vorliegt. Analog kann auch die Elektronentransportschicht aus einer Mischung zweier Materialien bestehen. Der genaue Aufbau der OLEDs ist Tabelle 2 zu entnehmen. Die zur Herstellung der OLEDs verwendeten Materialien sind in Tabelle 5 gezeigt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/m² bestimmt und daraus die CIE 1931 x und y Farbkoordinaten berechnet. Als Lebensdauer LD80 wird die Zeit definiert, nach der die Leuchtdichte bei Betrieb mit einem konstantem Strom von 40 mA/cm² auf 80% der Startleuchtdichte absinkt.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Die Ergebnisse der OLEDs sind in Tabelle 3 zusammengefasst.

**Tabelle 2: Aufbau der OLEDs**

| **Bsp.** | **EBL Dicke** | **EML Dicke** | **HBL Dicke** | **ETL Dicke** |
|---|---|---|---|---|
| D1 | EBM1 10 nm | M1: Ir(L30) (83%:17%) 30 nm | ETM1 10nm | ETM1:ETM2 (50%:50%) 30 nm |
| D2 | EBM1 10 nm | M1:M2: Ir(L30) (50%:38%:12%) 30 nm | ETM1 10nm | ETM1:ETM2 (50%:50%) 30 nm |
| D3 | EBM1 5nm | M1:Ir(L31) (78%:22%) 30 nm | ETM1 10nm | ETM1:ETM2 (50%:50%) 30 nm |
| D4 | EBM2 10 nm | M1:M2: Ir(L67) (50%:38%:12%) 30 nm | ETM1 10nm | ETM1:ETM2 (50%:50%) 30 nm |
| D5 | EBM2 10 nm | M1:M2: Ir(L68) (50%:38%:12%) 30 nm | ETM1 10nm | ETM1:ETM2 (50%:50%) 30 nm |

**Tabelle 3: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** | **LD80 (h) 40 mA/cm²** |
|---|---|---|---|---|
| D1 | 23.6 | 3.1 | 0.36/0.61 | 220 |
| D2 | 23.9 | 2.9 | 0.36/0.62 | 250 |
| D3 | 21.4 | 3.3 | 0.18/0.35 | 90 |
| D4 | 23.0 | 3.0 | 0.38/0.60 | 360 |
| D5 | 26.3 | 3.1 | 0.39/0.60 | 330 |

### Lösungs-prozessierte Devices:

### Aus niedermolekularen löslichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport. Im vorliegenden Fall wird ein HL-X von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices vom Typ1 enthalten eine Emissionsschicht aus M3:M4:IrL (20%:60%:20%), die vom Typ2 enthalten eine Emissionsschicht aus M3:M4:IrLa:IrLb (30%:34%:30%:6%), d.h. sie enthalten zwei verschiedene Ir-Komplexe. Die Emissionsschicht wird in einer Inertgasatmosphäre, im vorliegenden Fall Argon, aufgeschleudert und 10 min bei 160 °C ausgeheizt. Darüber werden die Lochblockierschicht (10 nm ETM1) und die Elektronentransportschicht (40 nm ETM1 (50%) / ETM2 (50%)) aufgedampft (Aufdampfanlagen von Lesker o.a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert. Tabelle 4 fasst die erhaltenen Daten zusammen.

**Tabelle 4: Ergebnisse mit aus Lösung prozessierten Materialien**

| **Bsp.** | **Emitter Device** | **EQE (%) 1000 cd/m²** | **Spannung (V) 1000 cd/m²** | **CIE x/y** | **LD50 (h) 1000 cd/m²** |
|---|---|---|---|---|---|
| Sol-D1 | Ir(L33) Typ1 | 21.3 | 4.4 | 0.30/0.63 | 270000 |
| Sol-D2 | Ir(L63) Ir(L213) Typ2 | 19.8 | 4.3 | 0.65/0.34 | 300000 |

**Tabelle 5: Strukturformeln der verwendeten Materialien**

| | |
|---|---|
| 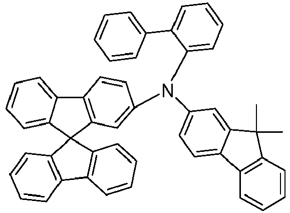 | 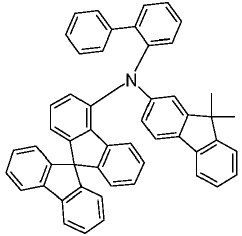 |
| HTM [1364602-88-9] | EBM1 [1450933-44-4] |
| 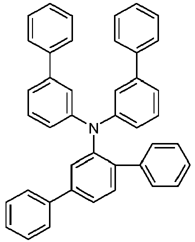 | 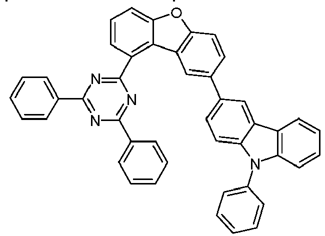 |
| EBM2 [1443540-48-4] | M1 [1822310-78-0] |
| 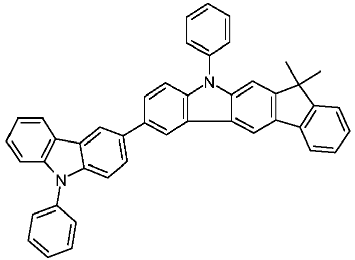 | 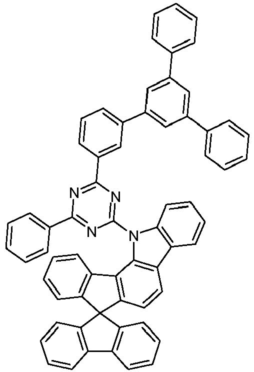 |
| M2 [1357150-54-9] | M3 [1616231-60-7] |
| 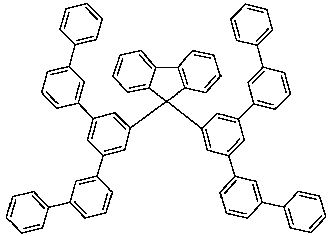 | 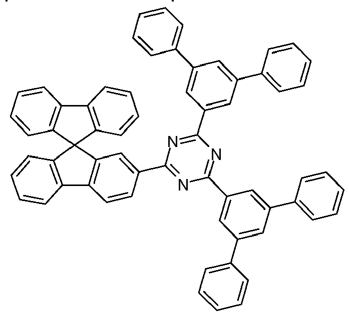 |
| M4 [1246496-85-4] | ETM1 = M10 [1233200-52-6] |
| 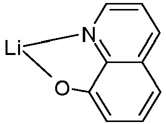 | 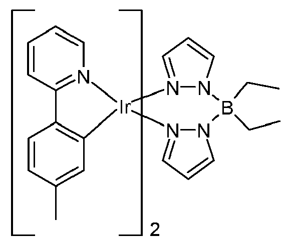 |
| ETM2 [25387-93-3] | Ref-Ir1 [710278-52-7] |

## Patentansprüche

1. Verbindung der Formel (1), 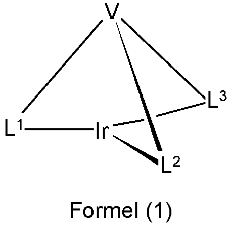 wobei für die verwendeten Symbole gilt:
L¹ ist ein Teilligand der Formel (2), der über die beiden mit * gekennzeichneten N-Atome an das Iridium koordiniert und der über die gestrichelte Bindung an V gebunden ist, 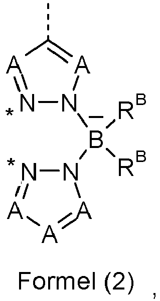 wobei gilt:
A ist bei jedem Auftreten gleich oder verschieden CR oder N, wobei maximal eine Gruppe A pro Ring für N steht;
R^{B} ist bei jedem Auftreten gleich oder verschieden F, OR¹, eine geradkettige Alkylgruppe mit 1 bis 10 C-Atomen oder eine verzweigte oder cyclische Alkylgruppe mit 3 bis 10 C-Atomen, wobei die Alkylgruppe jeweils mit einem oder mehreren Resten R¹ substituiert sein kann, oder ein aromatisches oder heteroaromatisches Ringsystem mit 5 bis 24 aromatischen Ringatomen, das jeweils durch einen oder mehrere Reste R¹ substituiert sein kann; dabei können die beiden Reste R^{B} auch miteinander ein Ringsystem bilden;
L² ist ein bidentater, monoanionischer Teilligand, der über ein Kohlenstoffatom und ein Stickstoffatom oder über zwei Kohlenstoffatome an das Iridium koordiniert;
L³ ist ein bidentater, monoanionischer Teilligand, der über ein Kohlenstoffatom und ein Stickstoffatom oder über zwei Kohlenstoffatome an das Iridium koordiniert, oder ist ein Teilligand der Formel (2), der gleich oder verschieden L¹ sein kann;
V ist eine Gruppe gemäß einer der Formeln (4b), (5b), (6b) oder (7b), wobei die gestrichelten Bindungen jeweils die Bindungen zu den Teilliganden L¹, L² und L³ darstellen, 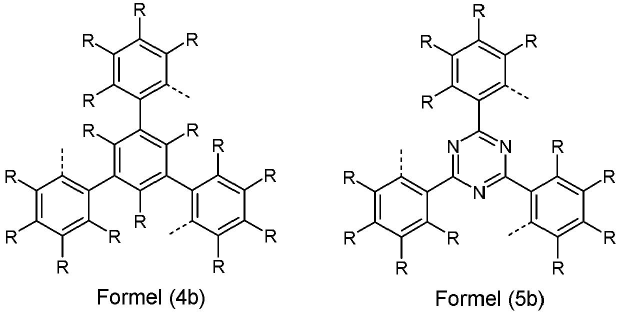 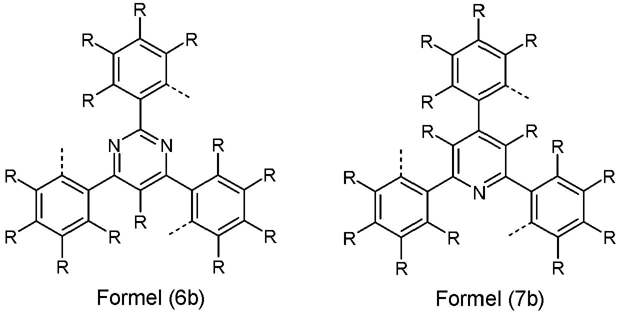
R ist bei jedem Auftreten gleich oder verschieden H, D, F, Cl, Br, I, N(R¹)₂, OR¹, SR¹, CN, NO₂, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann und wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
R¹ ist bei jedem Auftreten gleich oder verschieden H, D, F, Cl, Br, I, N(R²)₂, OR², SR², CN, NO₂, Si(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer und/oder heteroaromatischer organischer Rest, mit 1 bis 20 C-Atomen, in dem auch ein oder mehrere H-Atome durch F ersetzt sein können;
dabei können die drei bidentaten Liganden L¹, L² und L³ außer durch die Gruppe V auch noch durch eine weitere Brücke zu einem Kryptat geschlossen sein.

2. Verbindung nach Anspruch 1, **dadurch gekennzeichnet, dass** die Gruppe V ausgewählt ist aus den Strukturen der Formeln (4c) bzw. (5c), 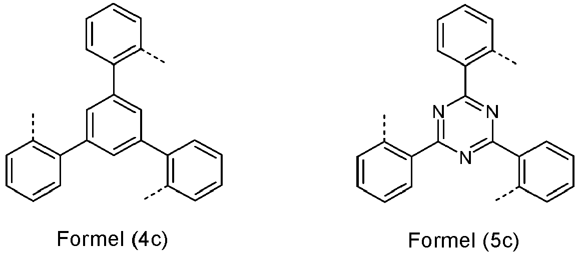 wobei die Symbole die in Anspruch 1 genannten Bedeutungen aufweisen.

3. Verbindung nach Anspruch 1 oder 2, **dadurch gekennzeichnet, dass** der Teilligand L¹ eine Struktur der Formel (2a) aufweist, 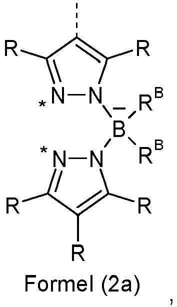 wobei die Symbole die in Anspruch 1 genannten Bedeutungen aufweisen und die Substituenten R, die dem koordinierenden N-Atom benachbart sind, gleich oder verschieden bei jedem Auftreten ausgewählt sind aus der Gruppe bestehend aus H, D, F, Methyl, Ethyl und Phenyl.

4. Verbindung nach einem oder mehreren der Ansprüche 1 bis 3, **dadurch gekennzeichnet, dass** der Teilligand L¹ eine Struktur der Formel (2c) aufweist, 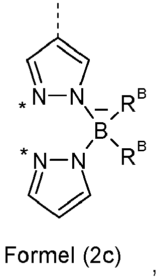 wobei die Symbole die in Anspruch 1 genannten Bedeutungen aufweisen.

5. Verbindung nach einem oder mehreren der Ansprüche 1 bis 4, **dadurch gekennzeichnet, dass** die Substituenten R^{B} bei jedem Auftreten gleich oder verschieden ausgewählt sind aus der Gruppe bestehend aus OR¹, wobei R¹ für eine Alkylgruppe mit 1 bis 5 C-Atomen steht, einer geradketttigen Alkylgruppe mit 1 bis 5 C-Atomen, einer verzweigten oder cyclischen Alkylgruppe mit 3 bis 6 C-Atomen, einer Arylgruppe mit 6 bis 10 C-Atomen, die mit einem oder mehreren bevorzugt nicht-aromatischen Resten R¹ substituiert sein kann, oder einer Heteroarylgruppe mit 5 bis 10 aromatischen Ringatomen, die mit einem oder mehreren bevorzugt nicht-aromatischen Resten R¹ substituiert sein kann, wobei die beiden Reste R^{B} auch miteinander ein Ringsystem bilden können; oder dass die beiden Reste R^{B} zusammen mit dem Boratom, an das sie binden, eine Gruppe gemäß einer der folgenden Formeln (B-1) bis (B-8) darstellen, 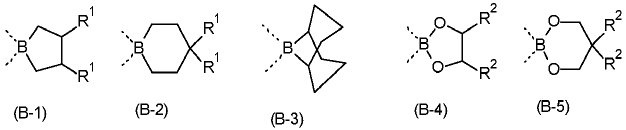 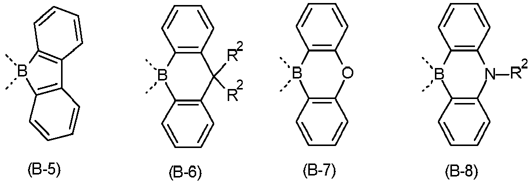 wobei R¹ und R² die in Anspruch 1 genannten Bedeutngen aufweisen, die gestrichelten Bindungen am Boratom jeweils die Bindung an den Pyrazolylring bzw. für A = N an den Triazolylring darstellen und die negative Ladung am Boratom nicht eingezeichnet ist.

6. Verbindung nach einem oder mehreren der Ansprüche 1 bis 5, **dadurch gekennzeichnet, dass** L³ einen Teilliganden der Formel (2) darstellt, wobei die Teilliganden L¹ und L³ gleich oder verschieden sein können.

7. Verbindung nach einem oder mehreren der Ansprüche 1 bis 6, **dadurch gekennzeichnet, dass** L² ein Kohlenstoffatom und ein Stickstoffatom als koordinierende Atome aufweist.

8. Verbindung nach einem oder mehreren der Ansprüche 1 bis 7, **dadurch gekennzeichnet, dass** der Teilligand L² für eine Struktur gemäß einer der Formeln (L-1) oder (L-2) steht und dass der Teilligand L³, wenn dieser über ein Kohlenstoffatom und ein Stickstoffatom oder über zwei Kohlenstoffatome an das Iridium koordiniert, für eine Struktur gemäß einer der Formeln (L-1) oder (L-2) steht, 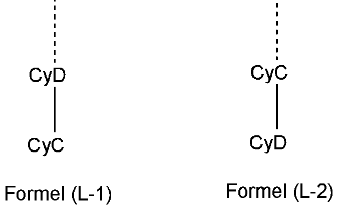 wobei die gestrichelte Bindung die Bindung des Teilliganden an die Gruppe der Formel (3) darstellt und für die weiteren verwendeten Symbole gilt:
CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei können mehrere Substituenten miteinander ein Ringsystem bilden.

9. Verbindung nach Anspruch 8, **dadurch gekennzeichnet, dass** CyC eine Aryl- oder Heteroarylgruppe mit 6 bis 13 aromatischen Ringatomen darstellt, welche über ein Kohlenstoffatom an das Metall koordiniert, welche mit einem oder mehreren Resten R substituiert sein kann und welche über eine kovalente Bindung mit CyD verbunden ist, und dass CyD eine Heteroarylgruppe mit 5 bis 13 aromatischen Ringatomen darstellt, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

10. Verbindung nach einem oder mehreren der Ansprüche 1 bis 9, **dadurch gekennzeichnet, dass** der Teilligand L² mit einem Substituenten der Formel (52) oder (53) substituiert ist, 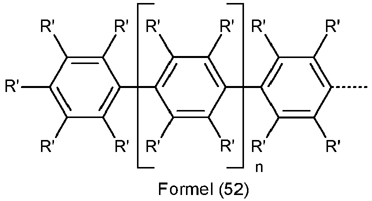 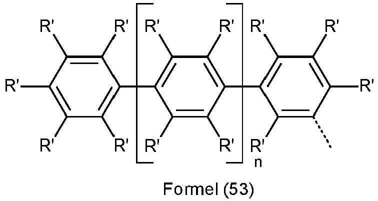 wobei die gestrichelte Bindung die Verknüpfung der Gruppe an den Teilliganden L² andeutet und weiterhin gilt:
R' ist gleich oder verschieden bei jedem Auftreten ausgewählt aus der Gruppe bestehend aus H, D, F, CN, einer geradkettigen Alkylgruppe mit 1 bis 10 C-Atomen, in der auch ein oder mehrere H-Atome durch D oder F ersetzt sein können, oder einer verzweigten oder cyclischen Alkylgruppe mit 3 bis 10 C-Atomen, in der auch ein oder mehrere H-Atome durch D oder F ersetzt sein können, oder einer Alkenylgruppe mit 2 bis 10 C-Atomen, in der auch ein oder mehrere H-Atome durch D oder F ersetzt sein können; dabei können auch zwei benachbarte Reste R' bzw. zwei Reste R' an benachbarten Phenylgruppen miteinander ein Ringsystem bilden; oder zwei R' an benachbarten Phenylgruppen stehen zusammen für eine Gruppe ausgewählt aus O oder S, so dass die beiden Phenylringe zusammen mit der verbrückenden Gruppe für ein Dibenzofuran oder Dibenzothiophen stehen, und die weiteren R' sind wie vorstehend definiert;
n ist 0, 1, 2, 3, 4 oder 5.

11. Verfahren zur Herstellung einer Verbindung nach einem oder mehreren der Ansprüche 1 bis 10, **dadurch gekennzeichnet, dass** ein Iridiumsalz mit einer Ligandenvorstufe in Gegenwart eines Pyrazolylborat-Synthons und in Gegenwart eines Halogenfängers umgesetzt wird.

12. Formulierung, enthaltend mindestens eine Verbindung nach einem oder mehreren der Ansprüche 1 bis 10 und mindestens ein Lösemittel und/oder mindestens eine weitere organische oder anorganische Verbindung.

13. Verwendung einer Verbindung nach einem oder mehreren der Ansprüche 1 bis 10 in einer elektronischen Vorrichtung oder als Sauerstoff-Sensibilisator oder als Photoinitiator oder Photokatalysator.

14. Elektronische Vorrichtung enthaltend mindestens eine Verbindung nach einem oder mehreren der Ansprüche 1 bis 10.

15. Elektronische Vorrichtung nach Anspruch 14, **dadurch gekennzeichnet, dass** es sich um eine organische Elektrolumineszenzvorrichtung handelt und die Verbindung nach einem oder mehreren der Ansprüche 1 bis 10 zusammen mit einem Matrixmaterial in einer oder mehreren emittierenden Schichten vorliegt.

## Claims

1. Compound of the formula (1) 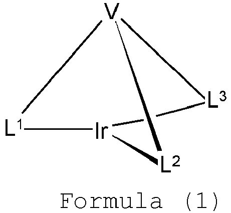 where the symbols used are as follows:
L¹ is a sub-ligand of the formula (2) which coordinates to the iridium via the two nitrogen atoms identified by * and which is bonded to V via the dotted bond, 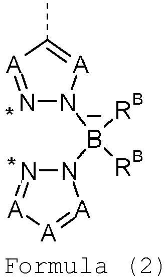 where:
A is the same or different at each instance and is CR or N, where not more than one A group per ring is N;
R^{B} is the same or different at each instance and is F, OR¹, a straight-chain alkyl group having 1 to 10 carbon atoms or a branched or cyclic alkyl group having 3 to 10 carbon atoms, where the alkyl group in each case may be substituted by one or more R¹ radicals, or an aromatic or heteroaromatic ring system which has 5 to 24 aromatic ring atoms and may be substituted in each case by one or more R¹ radicals; at the same time, the two R^{B} radicals together may also form a ring system;
L² is a bidentate, monoanionic sub-ligand which coordinates to the iridium via one carbon atom and one nitrogen atom or via two carbon atoms;
L³ is a bidentate, monoanionic sub-ligand which coordinates to the iridium via one carbon atom and one nitrogen atom or via two carbon atoms, or is a sub-ligand of the formula (2) which may be the same as or different from L¹;
V is a group of one of the formulae (4b), (5b), (6b) or (7b), where the dotted bonds each represent the bonds to the sub-ligands L¹, L² and L3, 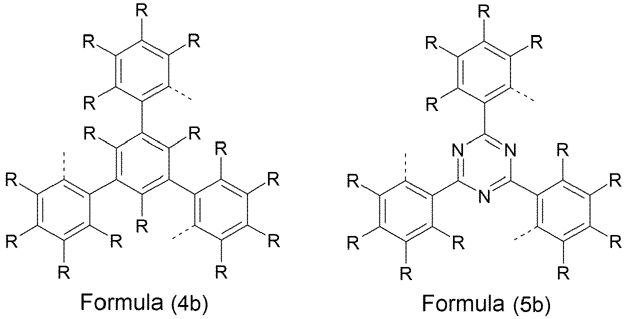 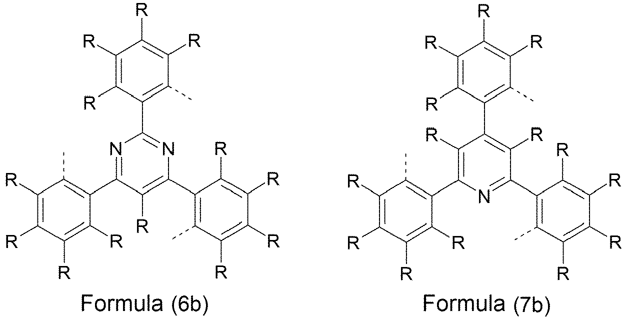
R is the same or different at each instance and is H, D, F, Cl, Br, I, N(R¹)₂, OR¹, SR¹, CN, NO₂, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, a straightchain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R¹ radicals and where one or more nonadjacent CH₂ groups may be replaced by Si(R¹)₂, C=O, NR¹, O, S or CONR¹, or an aromatic or heteroaromatic ring system which has 5 to 40 aromatic ring atoms and may be substituted in each case by one or more R¹ radicals; at the same time, two R radicals together may also form a ring system;
R¹ is the same or different at each instance and is H, D, F, Cl, Br, I, N(R²)₂, OR², SR², CN, NO₂, Si(R²)₃, B(OR²)₂, C(=O)R², P(=O)(R²)₂, S(=O)R², S(=O)₂R², OSO₂R², a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R² radicals and where one or more nonadjacent CH₂ groups may be replaced by Si(R²)₂, C=O, NR², O, S or CONR², or an aromatic or heteroaromatic ring system which has 5 to 40 aromatic ring atoms and may be substituted in each case by one or more R² radicals; at the same time, two or more R¹ radicals together may form a ring system;
R² is the same or different at each instance and is H, D, F or an aliphatic, aromatic and/or heteroaromatic organic radical having 1 to 20 carbon atoms, in which one or more hydrogen atoms may also be replaced by F;
at the same time, the three bidentate ligands L¹, L² and L³, apart from by the V group, may also be closed by a further bridge to form a cryptate.

2. Compound according to Claim 1, **characterized in that** the V group is selected from the structures of the formulae (4c) and (5c) 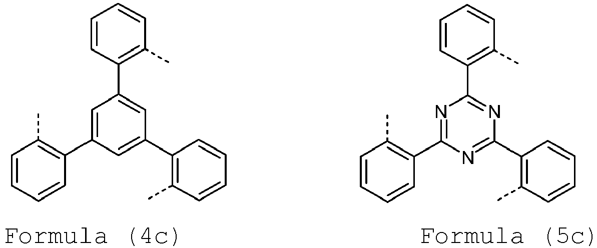 where the symbols have the definitions given in Claim 1.

3. Compound according to Claim 1 or 2, **characterized in that** the sub-ligand L¹ has a structure of the formula (2a) 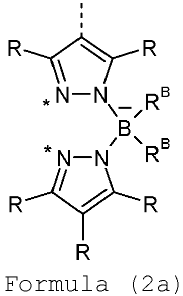 where the symbols have the definitions given in Claim 1 and the substituents R adjacent to the coordinating nitrogen atom are the same or different at each instance and are selected from the group consisting of H, D, F, methyl, ethyl and phenyl.

4. Compound according to one or more of Claims 1 to 3, **characterized in that** the sub-ligand L¹ has a structure of the formula (2c) 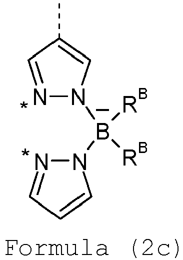 where the symbols have the definitions given in Claim 1.

5. Compound according to one or more of Claims 1 to 4, **characterized in that** the substituents R^{B} are the same or different at each instance and are selected from the group consisting of OR¹ where R¹ is an alkyl group having 1 to 5 carbon atoms, a straight-chain alkyl group having 1 to 5 carbon atoms, a branched or cyclic alkyl group having 3 to 6 carbon atoms, an aryl group which has 6 to 10 carbon atoms and may be substituted by one or more preferably nonaromatic R¹ radicals, or a heteroaryl group which has 5 to 10 aromatic ring atoms and may be substituted by one or more preferably nonaromatic R¹ radicals, where the two R^{B} radicals together may also form a ring system; or **in that** the two R^{B} radicals together with the boron atom to which they are bonded represent a group of one of the following formulae (B-1) to (B-8): 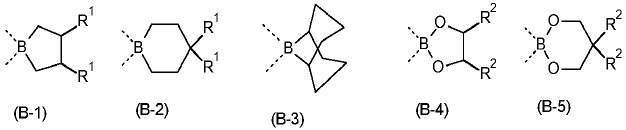 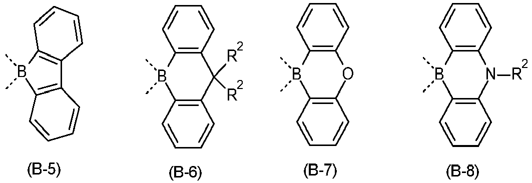 where R¹ and R² have the definitions given in Claim 1, the dotted bonds to the boron atom each represent the bond to the pyrazolyl ring or, when A = N, the triazolyl ring, and the negative charge on the boron atom is not shown.

6. Compound according to one or more of Claims 1 to 5, **characterized in that** L³ represents a sub-ligand of the formula (2), where the sub-ligands L¹ and L³ may be the same or different.

7. Compound according to one or more of Claims 1 to 6, **characterized in that** L² has one carbon atom and one nitrogen atom as coordinating atoms.

8. Compound according to one or more of Claims 1 to 7, **characterized in that** the sub-ligand L² is a structure of one of the formulae (L-1) or (L-2), and **in that** the sub-ligand L³, when it coordinates to the iridium via one carbon atom and one nitrogen atom or two carbon atoms, is a structure of one of the formulae (L-1) and (L-2) 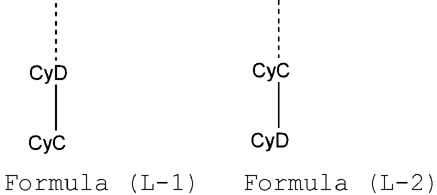 where the dotted bond represents the bond of the sub-ligand to the group of the formula (3) and the other symbols used are as follows:
CyC is the same or different at each instance and is a substituted or unsubstituted aryl or heteroaryl group which has 5 to 14 aromatic ring atoms and coordinates in each case to the metal via a carbon atom and which is bonded to CyD via a covalent bond;
CyD is the same or different at each instance and is a substituted or unsubstituted heteroaryl group which has 5 to 14 aromatic ring atoms and coordinates to the metal via a nitrogen atom or via a carbene carbon atom and which is bonded to CyC via a covalent bond;
at the same time, two or more substituents together may form a ring system.

9. Compound according to Claim 8, **characterized in that** CyC represents an aryl or heteroaryl group which has 6 to 13 aromatic ring atoms and coordinates to the metal via a carbon atom and which may be substituted by one or more R radicals and which is bonded to CyD via a covalent bond, and **in that** CyD represents a heteroaryl group which has 5 to 13 aromatic ring atoms and coordinates to the metal via an uncharged nitrogen atom or via a carbene carbon atom and which may be substituted by one or more R radicals and which is bonded to CyC via a covalent bond.

10. Compound according to one or more of Claims 1 to 9, **characterized in that** the sub-ligand L² is substituted by a substituent of the formula (52) or (53) 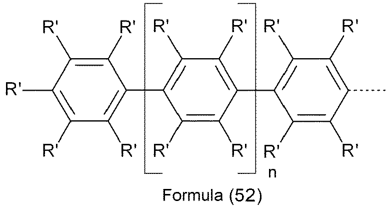 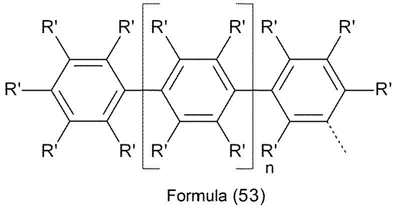 where the dotted bond indicates the linkage of the group to the sub-ligand L² and, in addition:
R' is the same or different at each instance and is selected from the group consisting of H, D, F, CN, a straight-chain alkyl group having 1 to 10 carbon atoms in which one or more hydrogen atoms may also be replaced by D or F, or a branched or cyclic alkyl group having 3 to 10 carbon atoms in which one or more hydrogen atoms may also be replaced by D or F, or an alkenyl group having 2 to 10 carbon atoms in which one or more hydrogen atoms may also be replaced by D or F; at the same time, two adjacent R' radicals or two R' radicals on adjacent phenyl groups together may also form a ring system; or two R' on adjacent phenyl groups together are a group selected from O and S, such that the two phenyl rings together with the bridging group are a dibenzofuran or dibenzothiophene, and the further R' are as defined above;
n is 0, 1, 2, 3, 4 or 5.

11. Process for preparing a compound according to one or more of Claims 1 to 10, **characterized in that** an iridium salt is reacted with a ligand precursor in the presence of a pyrazolylborate synthon and in the presence of a halogen scavenger.

12. Formulation comprising at least one compound according to one or more of Claims 1 to 10 and at least one solvent and/or at least one further organic or inorganic compound.

13. Use of a compound according to one or more of Claims 1 to 10 in an electronic device or as oxygen sensitizer or as photoinitiator or photocatalyst.

14. Electronic device comprising at least one compound according to one or more of Claims 1 to 10.

15. Electronic device according to Claim 14, **characterized in that** it is an organic electroluminescent device and the compound according to one or more of Claims 1 to 10 is present together with a matrix material in one or more emitting layers.

## Revendications

1. Composé de formule (1), 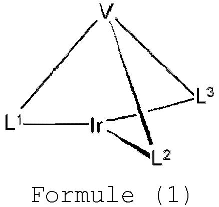 dans laquelle pour les symboles utilisés il s'applique que :
L¹ est un ligand partiel de formule (2) qui est coordonné à l'iridium par l'intermédiaire des deux atomes d'azote marqués par * et qui est lié à V par la liaison en tireté, 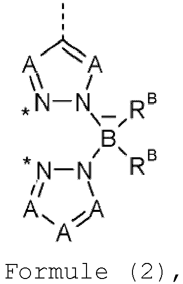 dans laquelle il s'applique que :
A est, le même ou différent à chaque occurrence, CR ou N, au maximum un groupe A par cycle représentant N ;
R^{B} est, le même ou différent à chaque occurrence, F, OR¹, un groupe alkyle à chaîne droite ayant de 1 à 10 atomes de carbone ou un groupe alkyle ramifié ou cyclique ayant de 3 à 10 atomes de carbone, le groupe alkyle pouvant dans chaque cas être substitué par un ou plusieurs radicaux R¹, ou un système cyclique aromatique ou hétéroaromatique ayant de 5 à 24 atomes formant le cycle aromatique, qui peut dans chaque cas être substitué par un ou plusieurs radicaux R¹ ; en outre les deux radicaux R^{B} peuvent également former l'un avec l'autre un système cyclique ;
L² est un ligand partiel bidenté, monoanionique, qui est coordonné à l'iridium par l'intermédiaire d'un atome de carbone et d'un atome d'azote ou par l'intermédiaire de deux atomes de carbone ;
L³ est un ligand partiel bidenté, monoanionique, qui est coordonné à l'iridium par l'intermédiaire d'un atome de carbone et d'un atome d'azote ou par l'intermédiaire de deux atomes de carbone, ou est un ligand partiel de formule (2) qui peut être identique à ou différent de L¹ ;
V est un groupe conforme à l'une des formules (4b), (5b), (6b) ou (7b), où les liaisons en tireté représentant respectivement les liaisons aux ligands L¹, L² et L³, 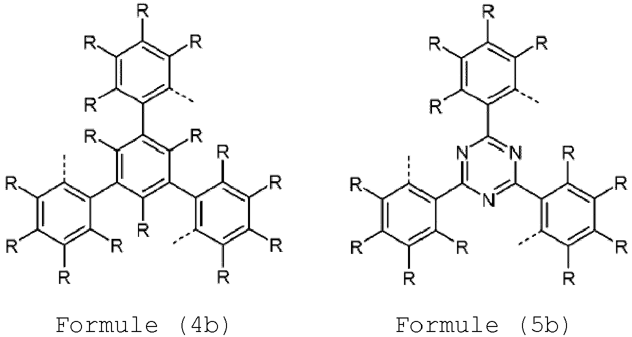 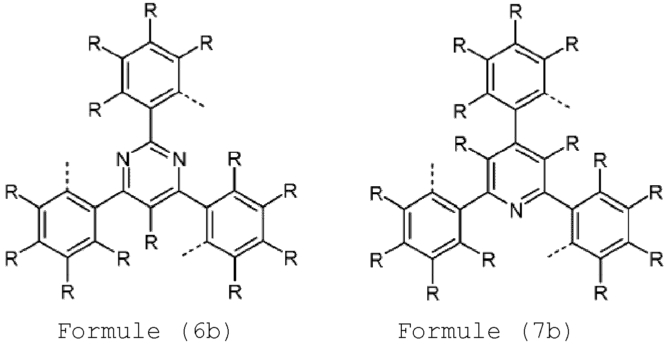
R est, le même ou différent à chaque occurrence, H, D, F, Cl, Br, I, N(R¹)₂, OR¹, SR¹, CN, NO₂, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, un groupe alkyle à chaîne droite ayant de 1 à 20 atomes de carbone ou un groupe alcényle ou alcynyle ayant de 2 à 20 atomes de carbone ou un groupe alkyle ramifié ou cyclique ayant de 3 à 20 atomes de carbone, le groupe alkyle, alcényle ou alcynyle pouvant dans chaque cas être substitué par un ou plusieurs radicaux R¹ et un ou plusieurs groupes CH₂ non contigus pouvant être remplacés par Si(R¹)₂, C=O, NR¹, O, S ou CONR¹, ou un système cyclique aromatique ou hétéroaromatique ayant de 5 à 40 atomes formant le cycle aromatique, qui peut dans chaque cas être substitué par un ou plusieurs radicaux R¹ ; deux radicaux R pouvant en outre également former l'un avec l'autre un système cyclique ;
R¹ est, le même ou différent à chaque occurrence, H, D, F, Cl, Br, I, N(R²)₂, OR², SR¹, CN, NO₂, Si(R²)₃, B(OR²)₂, C(=O)R², P(=O)(R²)₂, S(=O)R², S(=O)₂R², OSO₂R², un groupe alkyle à chaîne droite ayant de 1 à 20 atomes de carbone ou un groupe alcényle ou alcynyle ayant de 2 à 20 atomes de carbone ou un groupe alkyle ramifié ou cyclique ayant de 3 à 20 atomes de carbone, le groupe alkyle, alcényle ou alcynyle pouvant dans chaque cas être substitué par un ou plusieurs radicaux R² et un ou plusieurs groupes CH₂ non contigus pouvant être remplacés par Si(R²)₂, C=O, NR², O, S ou CONR², ou un système cyclique aromatique ou hétéroaromatique ayant de 5 à 40 atomes formant le cycle aromatique, qui peut dans chaque cas être substitué par un ou plusieurs radicaux R² ; deux ou plus de deux radicaux R¹ pouvant en outre former l'un avec l'autre/les uns avec les autres un système cyclique ;
R² est, le même ou différent à chaque occurrence, H, D, F ou un radical organique aliphatique, aromatique et/ou hétéroaromatique, ayant de 1 à 20 atomes de carbone, dans lequel un ou plusieurs atomes d'hydrogène peuvent également être remplacés par F ;
en outre les trois ligands bidentés L¹, L² et L³ peuvent être fermés en un cryptate, outre par le groupe V, également encore par un autre pont.

2. Composé selon la revendication 1, **caractérisé en ce que** le groupe V est choisi parmi les structures de formules (4c) et (5c), 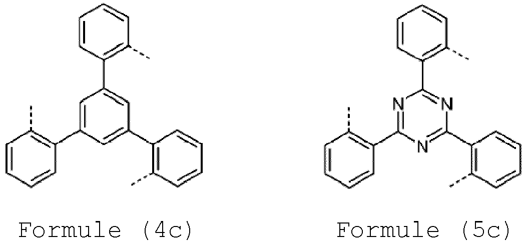 dans lesquelles les symboles ont les significations indiquées dans la revendication 1.

3. Composé selon la revendication 1 ou 2, **caractérisé en ce que** le ligand partiel L¹ présente une structure de formule (2a) 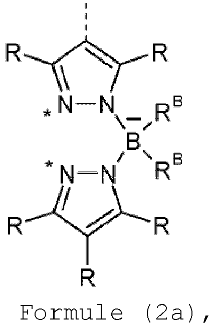 dans laquelle les symboles ont les significations indiquées dans la revendication 1 et les substituants R, qui sont contigus à l'atome d'azote coordonnant, sont choisis, identiques ou différents à chaque occurrence, dans le groupe constitué par H, D, F, méthyle, éthyle et phényle.

4. Composé selon une ou plusieurs des revendications 1 à 3, **caractérisé en ce que** le ligand partiel L¹ présente une structure de formule (2c) 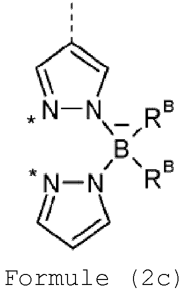 dans laquelle les symboles ont les significations indiquées dans la revendication 1.

5. Composé selon une ou plusieurs des revendications 1 à 4, **caractérisé en ce que** les substituants R^{B} sont choisis, identiques ou différents à chaque occurrence, dans le groupe constitué par OR¹, R¹ représentant un groupe alkyle ayant de 1 à 5 atomes de carbone, un groupe alkyle à chaîne droite ayant de 1 à 5 atomes de carbone, un groupe alkyle ramifié ou cyclique ayant de 3 à 6 atomes de carbone, un groupe aryle ayant de 6 à 10 atomes de carbone, qui peut être substitué par un ou plusieurs radicaux R¹ de préférence non aromatiques, ou un groupe hétéroaryle ayant de 5 à 10 atomes formant le cycle aromatique, qui peut être substitué par un ou plusieurs radicaux R¹ de préférence non aromatiques, les deux radicaux R^{B} pouvant également former l'un avec l'autre un système cyclique ; ou **en ce que** les deux radicaux R^{B} représentent ensemble aves l'atome de bore, auquel ils sont liés, un groupe conforme à l'une des formules (B-1) à (B-8) suivantes, 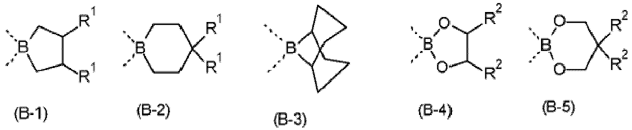 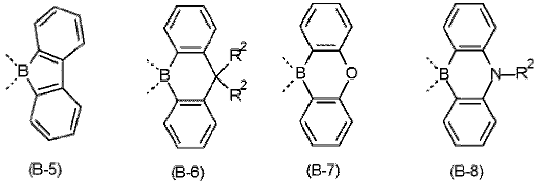 dans lesquelles R¹ et R² ont les significations indiquées dans la revendication 1, les liaisons en tireté sur l'atome de brome représentent chacune la liaison au cycle pyrazolyle ou, pour A = N, au cycle triazolyle, et la charge négative sur l'atome de bore n'est pas figurée.

6. Composé selon une ou plusieurs des revendications 1 à 5, **caractérisé en ce que** L³ représente un ligand partiel de formule (2), les ligands partiels L¹ et L³ pouvant être identiques ou différents.

7. Composé selon une ou plusieurs des revendications 1 à 6, **caractérisé en ce que** L² comporte un atome de carbone et un atome d'azote en tant qu'atomes coordonnants.

8. Composé selon une ou plusieurs des revendications 1 à 7, **caractérisé en ce que** le ligand partiel L² représente une structure conforme à l'une des formules (L-1) et (L-2) et **en ce que** le ligand partiel L³, lorsqu'il est coordonne à l'iridium par l'intermédiaire d'un atome de carbone ou d'un atome d'azote ou par l'intermédiaire de deux atomes de carbone, représente une structure conforme à l'une des formules (L-1) et (L-2), 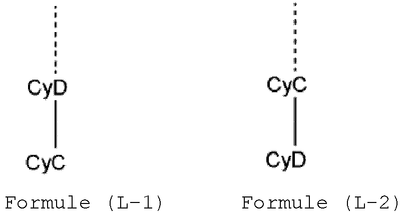 dans lesquelles la liaison en tireté représente la liaison du ligand partiel au groupe de formule (3) et pour les autres symboles utilisés il s'applique que :
CyC est, le même ou différent à chaque occurrence, un groupe aryle ou hétéroaryle substitué ou non substitué ayant de 5 à 14 atomes formant le cycle aromatique, qui est coordonné au métal dans chaque cas par l'intermédiaire d'un atome de carbone et qui est lié à CyD par une liaison covalente ;
CyD est, le même ou différent à chaque occurrence, un groupe hétéroaryle substitué ou non substitué ayant de 5 à 14 atomes formant le cycle aromatique, qui est coordonné au métal par l'intermédiaire d'un atome d'azote ou par l'intermédiaire d'un atome de carbone en fonction carbène et qui est lié à CyC par une liaison covalente ;
en outre plusieurs substituants peuvent former les uns avec les autres un système cyclique.

9. Composé selon la revendication 8, **caractérisé en ce que** CyC représente un groupe aryle ou hétéroaryle ayant de 6 à 13 atomes formant le cycle aromatique, qui est coordonné au métal par l'intermédiaire d'un atome de carbone, qui peut être substitué par un ou plusieurs radicaux R et qui est lié à CyD par une liaison covalente, et **en ce que** CyD représente un groupe hétéroaryle ayant de 5 à 13 atomes formant le cycle aromatique, qui est coordonné au métal par l'intermédiaire d'un atome d'azote neutre ou par l'intermédiaire d'un atome de carbone en fonction carbène et qui peut être substitué par un ou plusieurs radicaux R et qui est lié à CyC par une liaison covalente.

10. Composé selon une ou plusieurs des revendications 1 à 9, **caractérisé en ce que** le ligand partiel L² est substitué par un substituant de formule (52) ou (53), 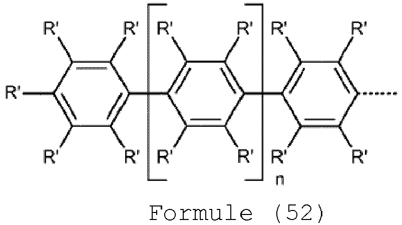 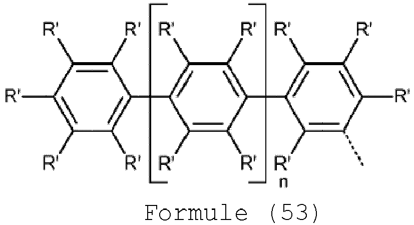 formules dans lesquelles la liaison en tireté indique l'attachement du groupe au ligand partiel L² et en outre il s'applique que
R' est choisi, le même ou différent à chaque occurrence, dans le groupe constitué par H, D, F, CN, un groupe alkyle à chaîne droite ayant de 1 à 10 atomes de carbone, dans lequel également un ou plusieurs atomes d'hydrogène peuvent être remplacés par D ou F, ou un groupe alkyle ramifié ou cyclique ayant de 3 à 10 atomes de carbone, dans lequel également un ou plusieurs atomes d'hydrogène peuvent être remplacés par D ou F, ou un groupe alcényle ayant de 2 à 10 atomes de carbone, dans lequel également un ou plusieurs atomes d'hydrogène peuvent être remplacés par D ou F ; en outre deux radicaux R' contigus ou deux radicaux R' sur des groupes phényle contigus peuvent également former l'un avec l'autre un système cyclique ; ou deux radicaux R' sur des groupes phényle contigus représentent ensemble un groupe choisi parmi O et S, de sorte que les deux cycles phényle forment ensemble avec le groupe pontant un dibenzofurane ou dibenzothiophène, et les autres radicaux R' sont tels que définis précédemment ;
n est 0, 1, 2, 3, 4 ou 5.

11. Procédé destiné à la préparation d'un composé selon une ou plusieurs des revendications 1 à 10, **caractérisé en ce qu'**on fait réagir un sel d'iridium avec un précurseur de ligand en présence d'un synthon borate de triazolyle et en présence d'un capteur d'halogène.

12. Formulation contenant au moins un composé selon une ou plusieurs des revendications 1 à 10 et au moins un solvant et/ou au moins un autre composé organique ou inorganique.

13. Utilisation d'un composé selon une ou plusieurs des revendications 1 à 10 dans un dispositif électronique ou en tant que sensibilisateur à l'oxygène ou en tant que photoamorceur ou photocatalyseur.

14. Dispositif électronique contenant au moins un composé selon une ou plusieurs des revendications 1 à 10.

15. Dispositif électronique selon la revendication 14, **caractérisé en ce qu'**il s'agit d'un dispositif d'électroluminescence organique et le composé selon une ou plusieurs des revendications 1 à 10 est présent conjointement avec un matériau de matrice dans une ou plusieurs couches émettrices.
